(19) **Europäisches Patentamt / European Patent Office / Office européen des brevets**

(11) **EP 4 425 960 B1**

(12) **EUROPEAN PATENT SPECIFICATION**

(45) Date of publication and mention
of the grant of the patent:
**01.04.2026  Bulletin 2026/14**

(21) Application number: **22887125.7**

(22) Date of filing: **27.10.2022**

(51) International Patent Classification (IPC):
**G10L 19/008** (2013.01)    **H04R 3/00** (2006.01)
**H04S 7/00** (2006.01)

(52) Cooperative Patent Classification (CPC):
**H04S 7/30; G10L 19/008; H04R 3/005;**
H04R 2430/20; H04S 2400/15; H04S 2420/01;
H04S 2420/03

(86) International application number:
**PCT/JP2022/040170**

(87) International publication number:
**WO 2023/074800 (04.05.2023 Gazette 2023/18)**

(54) **INFORMATION PROCESSING DEVICE**

INFORMATIONSVERARBEITUNGSVORRICHTUNG

DISPOSITIF DE TRAITEMENT D'INFORMATIONS

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**

(30) Priority: **29.10.2021  JP 2021177285**
**07.01.2022  PCT/JP2022/000355**
**15.06.2022  PCT/JP2022/024014**

(43) Date of publication of application:
**04.09.2024  Bulletin 2024/36**

(73) Proprietor: **Sony Group Corporation
Tokyo
108-0075 (JP)**

(72) Inventors:
• **NAMBA Ryuichi**
**Tokyo 108-0075 (JP)**
• **CHINEN Toru**
**Tokyo 108-0075 (JP)**
• **TSUJI Minoru**
**Tokyo 108-0075 (JP)**
• **HATANAKA Mitsuyuki**
**Tokyo 108-0075 (JP)**
• **HONMA Hiroyuki**
**Tokyo 108-0075 (JP)**

• **TOGURI Yasuhiro**
**Tokyo 108-0075 (JP)**

(74) Representative: **2SPL Patentanwälte PartG mbB
Landaubogen 3
81373 München (DE)**

(56) References cited:
WO-A1-2010/109918     WO-A1-2020/255810
JP-A- 2007 006 359     JP-A- 2008 107 629
US-A1- 2011 249 822

• **RYUICHI NAMBA ET AL: "Technical description
of Sony proposal for MPEG-I Immersive Audio",
no. m58791, 11 January 2022 (2022-01-11),
XP030299416, Retrieved from the Internet
<URL:https://dms.mpeg.expert/doc_end_user/
documents/137_OnLine/wg11/
m58791-v1-m58791.zip m58791.docx> [retrieved
on 20220111]**
• **RYUICHI NAMBA ET AL: "Update on Directivity
Coding Core Experiment of Sony Proposal", no.
m60456, 13 July 2022 (2022-07-13),
XP030303837, Retrieved from the Internet
<URL:https://dms.mpeg.expert/doc_end_user/
documents/139_OnLine/wg11/
m60456-v2-m60456_v2.zip m60456_v2.docx>
[retrieved on 20220713]**

**Description**

TECHNICAL FIELD

The present technology relates to an information processing device as set out in the appended set of claims .

BACKGROUND ART

In the related art, it is known that audio reproduction with a higher realistic feeling can be realized by considering directivity of a sound source.

For example, when directivity data representing directivity of sound from an object is prepared together with audio data of the object, audio reproduction based on directional characteristics of the object can be performed using the audio data and the directivity data.

Furthermore, as a technology regarding directivity, for example, a technology has been proposed in which a user can perform recording by arbitrarily selecting a directivity direction at the time of recording, and the user selects and reproduces a desired directivity direction separately from the directivity direction at the time of recording (see, for example, Patent Document 1).

Patent Literature US 2011/249822 A1 discloses a method for coding a multi-channel audio signal representing a sound scene comprising a plurality of sound sources. The method comprises decomposing the multi-channel signal into frequency bands and the following performed per frequency band: obtaining data representative of the direction of the sound sources of the sound scene, selecting a set of sound sources constituting principal sources, adapting the data representative of the direction of the selected principal sources, as a function of restitution characteristics of the multi-channel signal, determining a matrix for mixing the principal sources as a function of the adapted data, matrixing the principal sources by the matrix determined so as to obtain a sum signal with a reduced number of channels and coding the data representative of the direction of the sound sources and forming a binary stream comprising the coded data, the binary stream being transmittable in parallel with the sum signal.

CITATION LIST

PATENT DOCUMENT

Patent Document 1: Japanese Patent Application Laid-Open No. 2021-100209

SUMMARY OF THE INVENTION

PROBLEMS TO BE SOLVED BY THE INVENTION

Meanwhile, since directional characteristics (directivity) are different for each sound source, in a case where audio data of an object and directivity data of the object are provided as content, it is necessary to prepare directivity data for each type of sound source, that is, for each type of object. In addition, when it is attempted to provide information regarding directivity for more directions and frequencies, the data amount of the directivity data increases.

Then, the amount of transmission of the directivity data to the distribution destination of the content increases, and there is a possibility that a transmission delay occurs or a transmission rate increases.

The present technology has been made in view of such a situation, and an object thereof is to reduce an amount of transmission of directivity data.

SOLUTIONS TO PROBLEMS

The invention provides an information processing device, as defined by the appended independent claim 1. Preferred embodiments of the invention are defined by the appended dependent claims.

BRIEF DESCRIPTION OF DRAWINGS

Fig. 1 is a diagram for describing a mixed Gaussian distribution.
Fig. 2 is a diagram for describing a vMF distribution and a Kent distribution.
Fig. 3 is a diagram illustrating an example of directivity.

Fig. 4 is a diagram for describing data points.
Fig. 5 is a diagram illustrating an example of model data.
Fig. 6 is a diagram for describing a relationship between a band and a bin.
Fig. 7 is a diagram illustrating a reduction example of the data amount of the directivity data.
Fig. 8 is a diagram for describing a residual of directivity data.
Fig. 9 is a diagram depicting an example of a configuration of a server.
Fig. 10 is a flowchart for describing the encoding process.
Fig. 11 is a diagram illustrating a configuration example of an information processing device.
Fig. 12 is a flowchart illustrating a directivity data generation process.
Fig. 13 is a flowchart for describing an output audio data generation process.
Fig. 14 is a diagram illustrating appearance probability of difference information.
Fig. 15 is a diagram illustrating an example of model data.
Fig. 16 is a diagram illustrating an example of model data.
Fig. 17 is a diagram for describing transmission of a Huffman encoding table.
Fig. 18 is a diagram illustrating an example of a Huffman encoding table.
Fig. 19 is a diagram illustrating a configuration example of a server.
Fig. 20 is a flowchart illustrating a directivity data generation process.
Fig. 21 is a diagram illustrating a configuration example of a directivity data encoding unit.
Fig. 22 is a diagram illustrating a configuration example of a difference encoding unit.
Fig. 23 is a flowchart illustrating a model data generation process.
Fig. 24 is a diagram illustrating a configuration example of a distribution model decoding unit.
Fig. 25 is a diagram illustrating an example of model data.
Fig. 26 is a diagram illustrating an arrangement example of data points.
Fig. 27 is a diagram illustrating a description example of a data point.
Fig. 28 is a diagram illustrating an example of a scale factor of each bin.
Fig. 29 is a diagram illustrating an example of a minimum value of each bin.
Fig. 30 is a diagram illustrating an example of model data.
Fig. 31 is a diagram illustrating an example of Syntax of SymmetricDir().
Fig. 32 is a diagram for describing a rotation operation.
Fig. 33 is a diagram for describing a symmetry operation.
Fig. 34 is a diagram illustrating an example of Syntax of NonSymmetricDir().
Fig. 35 is a diagram illustrating an example of model data.
Fig. 36 is a diagram illustrating an example of a weight used to calculate output values of a mixture model of each bin.
Fig. 37 is a diagram illustrating an example of model data.
Fig. 38 is a diagram illustrating an example of Syntax of NonSymmetricDir().
Fig. 39 is a diagram illustrating an example of Syntax of LeftRightLineSymmetricDir().
Fig. 40 is a diagram for describing a distribution according to weights.
Fig. 41 is a diagram illustrating a configuration example of a computer.

MODE FOR CARRYING OUT THE INVENTION

Hereinafter, an embodiment to which the present technology is applied will be described with reference to the drawings.

<First embodiment>

<About present technology>

The present technology is to reduce an amount of transmission of directivity data by modeling the directivity data.

In the present technology, for example, audio data and directivity data of a 3D sound source are provided as content.

Specifically, for example, sounds of one or more audio objects (hereinafter, simply referred to as an object) are collected (recorded) as a 3D sound source, and audio data of each object is generated. Furthermore, for each type of object, that is, each sound source type, directivity data representing a directional characteristic, that is, directivity, of the object (sound source) is prepared.

Furthermore, the audio data of each object and the directivity data for each sound source type are provided as content data. That is, the directivity data is transmitted to the device on the reproduction side together with the audio data of the object. Then, on the reproduction side, audio reproduction considering the directivity data is performed on the basis of the audio data and the directivity data constituting the content.

The directivity data can be obtained, for example, by recording sound of an object with a plurality of microphones. Note that the recording of the directivity data may be performed simultaneously with the recording of the audio data of the object, or may be performed at a timing different from the recording of the audio data of the object.

The directivity data is prepared for each sound source type such as a voice, a musical instrument, or a speaker. Further, the directivity data is, for example, data having information about the amplitude and the phase of the sound from the sound source for each target frequency in the entire frequency band from the frequency to be DC to the Nyquist frequency for a position in each direction viewed from the sound source.

For example, the direction viewed from the sound source is represented by an angle in the horizontal direction viewed from the sound source position, that is, an azimuth angle, and an angle in the vertical direction viewed from the sound source position, that is, an elevation angle. At this time, for example, the range of the azimuth angle is set to a range of 0 degrees to 360 degrees, and the range of the elevation angle is set to a range of -90 degrees to +90 degrees.

In the present technology, in discretizing and compressing such directivity data, parametric compression by modeling is performed instead of directly compressing the data.

Note that, in the present technology, the directivity data to be modeled is obtained by appropriately discretizing and normalizing the directivity data obtained by recording or the like.

In the following description, it is assumed that the directivity data to be modeled includes a gain (hereinafter, referred to as a directivity gain) indicating a directional characteristic of each of a plurality of discrete frequencies of a sound source at a plurality of data points.

For example, the position to be the data point can be expressed by coordinates (polar coordinates) of a polar coordinate system with the sound source position as the origin, that is, an azimuth angle indicating a position in the horizontal direction viewed from the sound source position and an elevation angle indicating a position in the vertical direction viewed from the sound source position. Note that the distance (radius) from the sound source position may be used to represent the position of the data point. Furthermore, the directivity gain can be obtained by normalizing the amplitude (sound pressure) of the sound from the sound source at the data point.

(Method of recording directivity data of sound source)

A method of recording the directivity data for each sound source type will be described.

In the present technology, a vMF (von Mises Fisher) distribution on a spherical face, a Kent distribution, or a mixture model including at least any one of the vMF distribution or the Kent distribution, corresponding to a multivariate/univariate Gaussian distribution defined on a plane, is used for modeling the directivity data.

Note that the vMF distribution, the Kent distribution, and the mixture model are described in detail in, for example, "John T. Kent (1982). The Fisher-Bingham Distribution on the Sphere".

First, a general mixed Gaussian distribution will be described.

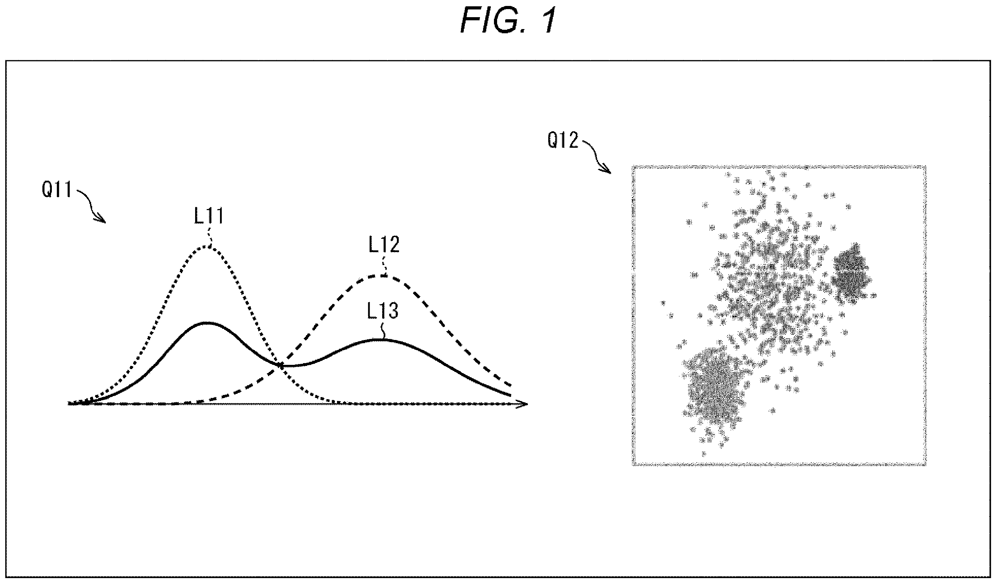

For example, a two-dimensional Gaussian distribution is illustrated in a portion indicated by the arrow Q11 in Fig. 1. In this example, there are two Gaussian distributions on a straight line. That is, the curve L11 indicates one Gaussian distribution, and the curve L12 indicates another Gaussian distribution.

In addition, the curve L13 indicates a mixed Gaussian distribution obtained by mixing the Gaussian distribution indicated by the curve L11 and the Gaussian distribution indicated by the curve L12.

On the other hand, three distributions on a plane are illustrated in a portion indicated by the arrow Q12 in Fig. 1. It is also possible to mix a plurality of distributions on such a plane.

Usually, the mixed Gaussian distribution is used to express a probability density function (pdf) on a plane. By expressing a desired pdf with a small number of model parameters and as few number of mixtures as possible, it is possible to reduce the amount of information.

In the present technology, the directivity data on the spherical surface, that is, the shape (distribution) of the directivity gain is modeled using the mixture model of the vMF distribution and the Kent distribution corresponding to the Gaussian distribution defined on the spherical surface.

The mixture model may include one or more vMF distributions, one or more Kent distributions, or one or more vMF distributions and one or more Kent distributions. That is, the mixture model includes one or more distributions including at least any one of the vMF distribution or the Kent distribution.

When the position vector indicating the position of the spherical surface, that is, the coordinates of the orthogonal coordinate system (Cartesian coordinate system) is x, the value $f(x)$ of the Kent distribution corresponding to the position vector x, that is, the value $f(x)$ of the Kent distribution at the position indicated by the position vector x can be expressed by the following Expression (1).

[Math 1]

$$f(x) = \frac{1}{c(\kappa, \beta)} \exp\left\{\kappa \gamma_1^T \cdot x + \beta\left[(\gamma_2^T \cdot x)^2 - (\gamma_3^T \cdot x)^2\right]\right\} \qquad \cdots (1)$$

Note that, in Expression (1), $\kappa$ represents a degree of parameter concentration, and $\beta$ represents an ellipticity. Further, $\gamma_1$ represents a vector defining the center of the mean direction distribution, $\gamma_2$ represents a major axis vector, and $\gamma_3$ represents a minor axis vector.

Further, $c(\kappa, \beta)$ is a normalization constant expressed by the following Expression (2). Note that, in Expression (2), $\Gamma$ represents a gamma function, and I represents a modified Bessel function of the first kind.

[Math 2]

$$c(\kappa, \beta) = 2\pi \sum_{j=0}^{\infty} \frac{\Gamma\left(j + \frac{1}{2}\right)}{\Gamma(j+1)} \beta^{2j} \left(\frac{1}{2}\kappa\right)^{-2j-\frac{1}{2}} I_{2j+\frac{1}{2}}(\kappa) \qquad \cdots (2)$$

In addition, the value of the vMF distribution at the position indicated by the position vector x can also be expressed by the expression similar to Expression (1). In such a case, the value of the ellipticity $\beta$ in Expression (1) is set to 0.

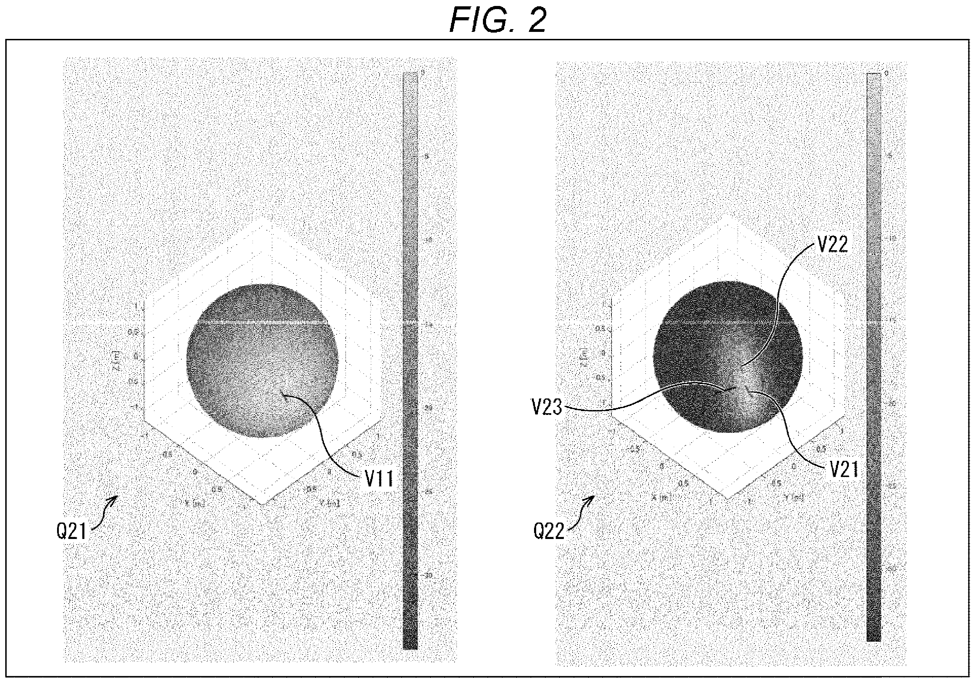

Fig. 2 illustrates an example of the vMF distribution and the Kent distribution.

In Fig. 2, an example of the vMF distribution is illustrated in a portion indicated by the arrow Q21. Specifically, the vector V11 represents the vector $\gamma_1$ shown in Expression (1).

The vMF distribution does not have the ellipticity $\beta$, the major axis vector $\gamma_2$, and the minor axis vector $\gamma_3$ as parameters, and is a circular distribution that spreads isotropically around the position indicated by the vector V11 (vector $\gamma_1$) on the spherical surface. That is, a circular distribution can be reproduced by using the vMF distribution (vMF distribution model).

On the other hand, an example of the Kent distribution is illustrated in a portion indicated by the arrow Q22. Specifically, vectors V21 to V23 represent the vector $\gamma_1$, the major axis vector $\gamma_2$, and the minor axis vector $\gamma_3$ shown in Expression (1).

The Kent distribution is an elliptical distribution centered on the position indicated by the vector V21 (vector $\gamma_1$) on the spherical surface and having the major axis vector $\gamma_2$ and the minor axis vector $\gamma_3$ on the spherical surface as the major axis and the minor axis, respectively. That is, by using the Kent distribution (Kent distribution model), it is possible to reproduce the distribution of the elliptical shape defined by the ellipticity $\beta$, the major axis vector $\gamma_2$, and the minor axis vector $\gamma_3$.

The Kent distribution has a high degree of freedom because the shape of the ellipse can be changed by parameters such as the ellipticity $\beta$, but the number of parameters is larger than that of the vMF distribution.

In the present technology, the directivity data is represented (modeled) by using a mixture model obtained by mixing the vMF distribution and the Kent distribution.

For example, at the position indicated by the position vector x as in Expression (1), the output value $F(x; \Theta)$ of a mixture model using N Kent distributions $f(x; \theta_i)$ can be expressed by the following Expression (3). That is, the mixture model $F(x; \Theta)$ can be expressed by weighted addition of the N Kent distributions $f(x; \theta_i)$.

[Math 3]

$$F(x; \Theta) = \sum_{i=1}^{N} \phi_i f(x; \theta_i) \qquad \cdots (3)$$

Note that, in Expression (3), the Kent distribution $f(x; \theta_i)$ is similar to that shown in the above Expression (1), and indicates the i-th Kent distribution among the N Kent distributions to be mixed.

Further, $\theta_i$ is a parameter constituting the Kent distribution $f(x; \theta_1$, more specifically, a set of parameters, and the parameter $\theta_i$ includes a degree of parameter concentration $\kappa$, an ellipticity $\beta$, a vector $\gamma_1$, a major axis vector $\gamma_2$, and a minor axis vector $\gamma_3$ in Expression (1). The parameter $\Theta$ of the Mixture model $F(x; \Theta)$ is a set of parameters $\theta_i$ of the N Kent distributions $f(x; \theta_i)$.

Furthermore, in Expression (3), $\varphi_i$ represents a weight (weight coefficient) of the i-th Kent distribution $f(x; \theta_i)$ when mixing N Kent distributions, and as shown in Expression (4), the sum of the weights $\varphi_i$ of N Kent distributions $f(x; \theta_i)$ is 1.

[Math 4]

$$\sum_{i=1}^{N} \phi_i = 1 \qquad \cdots (4)$$

The directivity data used in the present technology can be obtained by performing recording (sound collection) with a microphone array including a plurality of microphones disposed around an object.

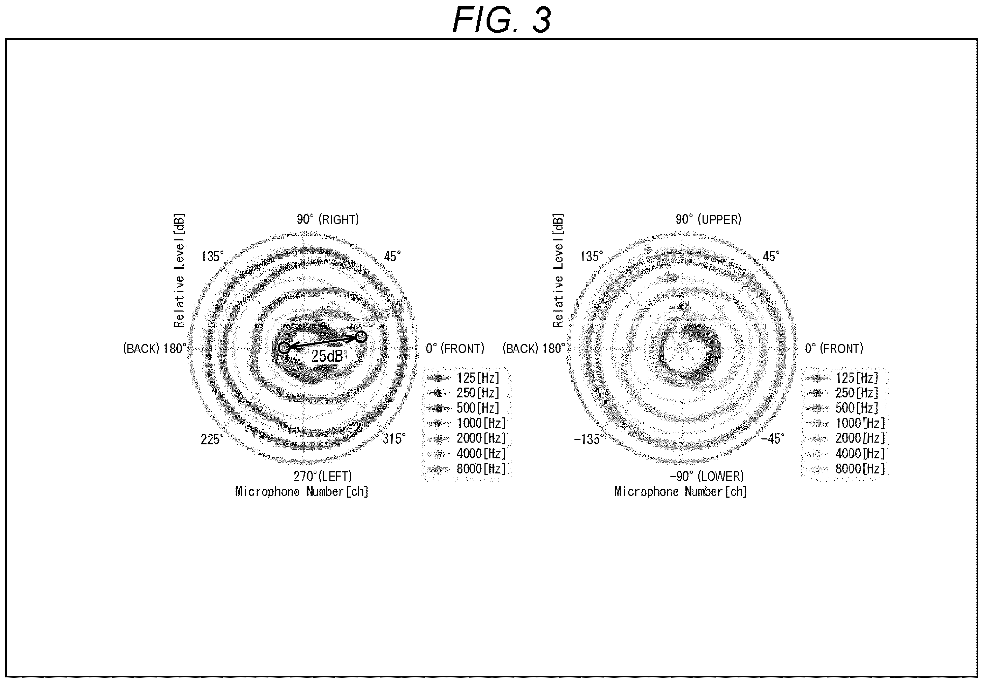

As an example, when the performance sound of the trumpet is recorded, the directivity illustrated in Fig. 3 is observed. Specifically, the directivity of each frequency in a horizontal plane, that is, a plane having an elevation angle of 0 degrees is illustrated on the left side in the figure, and the directivity of each frequency in a median plane is illustrated on the right side in the figure.

In this example, it can be seen that the outline of the directivity changes depending on the frequency (pitch) in both the horizontal plane and the median plane, and the directivity is small at the frequency on the low frequency side, but the directivity is larger (sharper) as the frequency increases. For example, on a horizontal plane, a sound pressure difference of about 25 dB at maximum occurs at 8000 Hz depending on the direction.

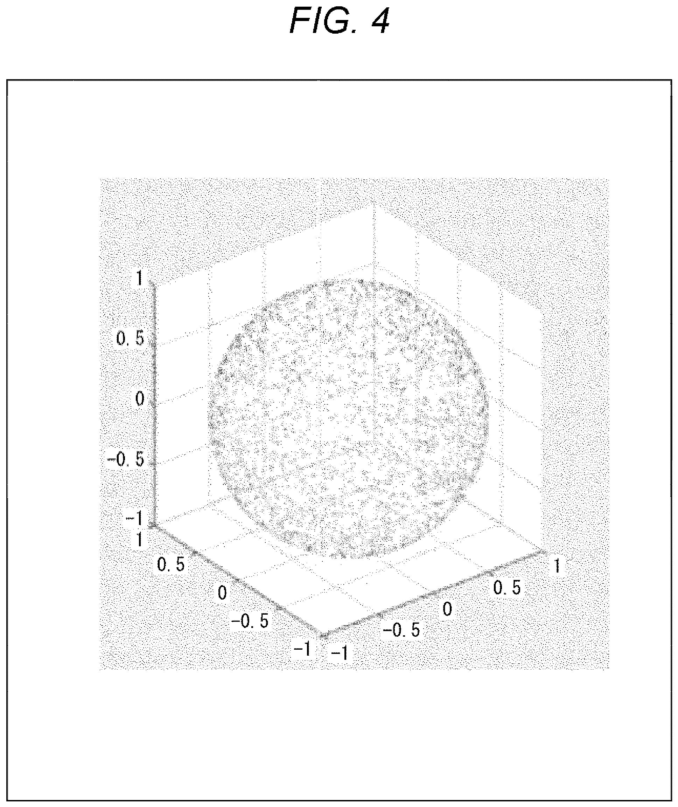

Meanwhile, in the directivity data to be modeled, for example, as illustrated in Fig. 4, a plurality of data points is provided on the spherical surface centered on the sound source position. In the example of Fig. 4, one point represents one data point, and it can be seen that there are a large number of data points on the entire spherical surface.

Here, for example, when data points are provided at intervals of 2 degrees (in increments of 2 degrees) in the azimuth angle direction and at intervals of 2 degrees in the elevation angle direction, 16022 data points are provided on the entire spherical surface. Furthermore, in such a case, when an attempt is made to transmit a directivity gain (sound pressure) in 512 bins (frequency bins) for 19 Hz to 20 kHz for each data point, the directivity data of one sound source is about 31 MB.

As described above, since the data size of the directivity data for each sound source type is large, the amount of transmission increases.

In addition, since there is a vowel sound, a consonant sound, and the like in the sound, and the directivity of the musical instrument varies depending on the playing method, and the variety of sound source types is very large, a large number of pieces of directivity data are required when it is attempted to prepare the directivity data for each sound source type.

For these reasons, the amount of transmission of directivity data increases, and an increase in the amount of directivity data transmission causes a transmission delay and an increase in the transmission rate. Therefore, in some cases, it may not be possible to reproduce the directivity according to the sound source type, the frequency, the direction of the object and the listener, and the like.

Therefore, in the present technology, by modeling the directivity data using the mixture model as described above, the amount of transmission of the directivity data can be reduced.

<Example of model data>

Here, a specific example of the model data obtained by modeling the directivity data will be described.

In the present technology, at the time of transmitting the directivity data, the directivity data based on the mixture model including the vMF distribution and the Kent distribution is modeled, and model data including model parameter and the like constituting the mixture model obtained as a result thereof is generated. Then, the model data is transmitted to the device on the reproduction side of the content. As a result, transmission of the original directivity data having a large data size is unnecessary. In other words, the amount of data (amount of transmission) at the time of transmission of the directivity data can be reduced.

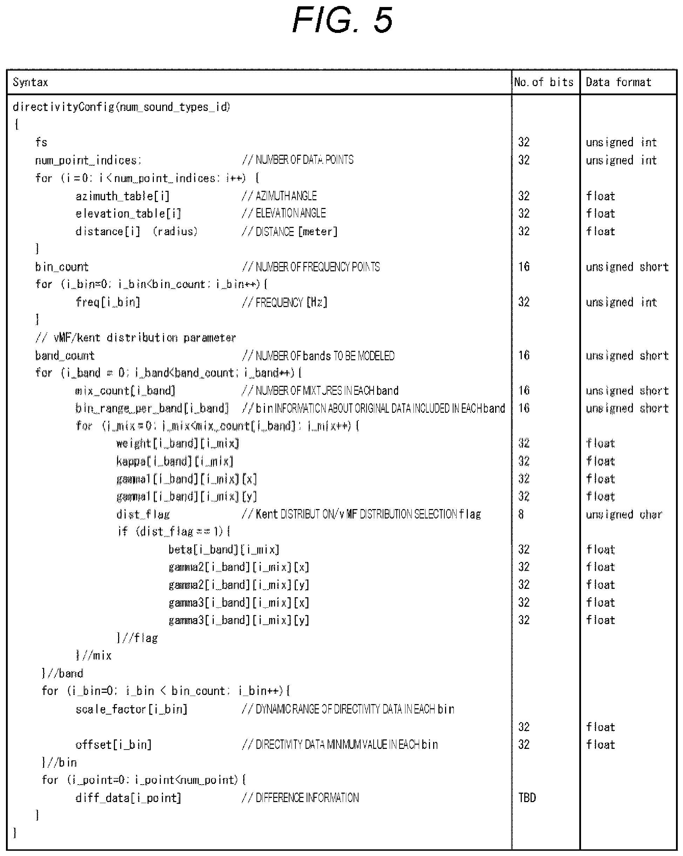

Here, an example of model data of one sound source type designated by num_sound_types_id is illustrated in Fig. 5. In this example, model data of one sound source type is described as directivityConfig.

The model data includes the azimuth angle "azimuth_table[i]", the elevation angle "elevation _table[i]", and the radius "distance[i]" indicating the position of the data point in the original directivity data before modeling by the number indicated by the number of data points "num _point_indices".

The position of the data point is represented by coordinates of a polar coordinate system having the sound source position as an origin, the polar coordinate system including an azimuth angle "azimuth _table[i]" that is an angle of the data point in the horizontal direction viewed from the sound source position, an elevation angle "elevation _table[i]" that is an angle of the data point in the vertical direction viewed from the sound source position, and a radius "distance[i]" that is a distance from the sound source position to the data point.

In addition, the model data includes the number of frequency points "bin_count" and the frequency "freq[i_bin]". In the original directivity data before modeling, the entire frequency band of interest is divided into frequency bins, that is, bins, which are frequency bands (frequencies) of the number indicated by the number of frequency points "bin_count", and the center frequency (Hz) of the i-th bin among these bins is the frequency "freq[i_bin]".

Thus, the original directivity data before modeling includes a directivity gain for each of one or more bins (frequency bin) at each of the plurality of data points.

Further, the model data includes, as parameters related to the Kent distribution and the vMF distribution, the number of bands to be modeled "band _count", the number of mixtures "mix _count[i_band]" in each band, and bin information "bin_range_per_band[i_band]" of the original directivity data before modeling included in each band.

For example, in modeling, the entire target frequency band of interest is divided into bands that are frequency bands whose number is indicated by the number of bands "band _count", and the distribution of the directivity gain is represented by the mixture model for each of the bands. In other words, the model parameter constituting the mixture model representing the distribution of the directivity gain in each band is estimated. Note that the frequency indicated by one or more bins, that is, the center frequency "freq[i_bin]" of the bin is always included in (belongs to) the frequency band indicated by each band.

The number of mixtures "mix _count[i_band]" indicates the number of distributions constituting the mixture model representing the distribution of the directivity gain of the i-th band, that is, the number of Kent distributions and vMF distributions, and the number of mixtures corresponds to N in Expression (3).

The bin information "bin_range_per_band[i_band]" of the directivity data is information indicating a bin of the original directivity data before modeling, the bin included in the i-th band. For example, the bin information is index information indicating a bin of the highest frequency belonging to the i-th band. By referring to the bin information "bin_range_per_band[i_band]", it is possible to identify in which band after modeling the bin (frequency bin) for the original directivity data before modeling is included.

In addition, the model data includes, as parameters related to the Kent distribution and the vMF distribution, the weight $\varphi_i$, the degree of parameter concentration $\kappa$, and the vector $\gamma_1$ described above for each distribution (Kent distribution or vMF distribution) constituting the mixture model for each band.

In this example, "weight[i_band] [i_mix]" and "kappa [i_band] [i_mix]" indicate the weight $\varphi_i$ and the degree of parameter concentration $\kappa$ of the distribution indicated by "i_mix" for the i-th band indicated by "i_band".

Further, "gamma1[i_band] [i_mix] [x]" and "gamma1[i_band][i_mix][y]" indicate an X component (X coordinate) and a Y component (Y coordinate) constituting a vector $\gamma_1$ of the distribution indicated by "i_mix" for the i-th band "i_band".

The model data includes a selection flag "dist_flag" indicating which distribution of the Kent distribution or the vMF distribution the distribution indicated by "i_mix" for the i-th band "i_band" constituting the mixture model is.

A value "1" of the selection flag "dist_flag" indicates that the distribution is the Kent distribution, and a value "0" of the selection flag "dist_flag" indicates that the distribution is the vMF distribution.

In a case where the value of the selection flag "dist_flag" is "1", the model data includes the ellipticity $\beta$, the major axis vector $\gamma_2$, and the minor axis vector $\gamma_3$ described above.

"beta[i_band][i_mix]" indicates the ellipticity $\beta$ of the distribution (Kent distribution) indicated by "i_mix" for the i-th band indicated by "i_band".In addition, "gamma2[i_band] [i_mix] [x]" and "gamma2[i_band][i_mix][y]" indicate an X component (X coordinate) and a Y component (Y coordinate) constituting the major axis vector $\gamma_2$ of the distribution (Kent distribution) indicated by "i_mix" for the i-th band "i_band".

Similarly, "gamma3[i_band] [i_mix] [x]" and "gamma3[i_band] [i_mix] [y]" indicate an X component (X coordinate) and a Y component (Y coordinate) constituting a minor axis vector $\gamma_3$ of the distribution (Kent distribution) indicated by "i_mix" for the i-th band "i_band".

The model data also includes the directivity data in each bin, more specifically, the scale factor "scale _factor [i_bin]" indicating the dynamic range of the directivity gain, and the offset value of the directivity data (directivity gain) in each bin, that is, the minimum value "offset[i _bin]".

Hereinafter, a parameter set including the ellipticity $\beta$, the degree of parameter concentration $\kappa$, the weight $\varphi_i$, the vector $\gamma_1$, the major axis vector $\gamma_2$, the minor axis vector $\gamma_3$, the scale factor, and the minimum value (offset value) included in the model data is also referred to as a model parameter.

The model data also includes difference information "diff_data[i_point]" indicating a difference between the value (directivity gain) of the original directivity data before modeling and the value (directivity gain) of the directivity data indicated by the mixture model obtained by the modeling at the data point. In other words, the difference information is information indicating a difference between the unmodeled directivity data and the modeled directivity data at the data point.

Note that it may be possible to select whether or not the difference information is stored. "diff_data[i_point]" stored in the model data may be Huffman encoded difference information.

In the device on the reproduction side (decoding side), for example, the output value $F(x; \Theta)$ of the mixture model at each data point, that is, the directivity gain is calculated on the basis of the model data of the configuration (format) illustrated in Fig. 5.

Each bin of the original directivity data before modeling belongs to any band of the number of bands described by the number of bands "band _count" at the time of the modeling determined in consideration of the similarity in shape of the directivity data.

Furthermore, a relevant relationship between each bin and a band is described by bin information "bin_range_per_band[i_band]", and a maximum index that is index information indicating a bin of the highest frequency belonging to the band is written as the bin information.

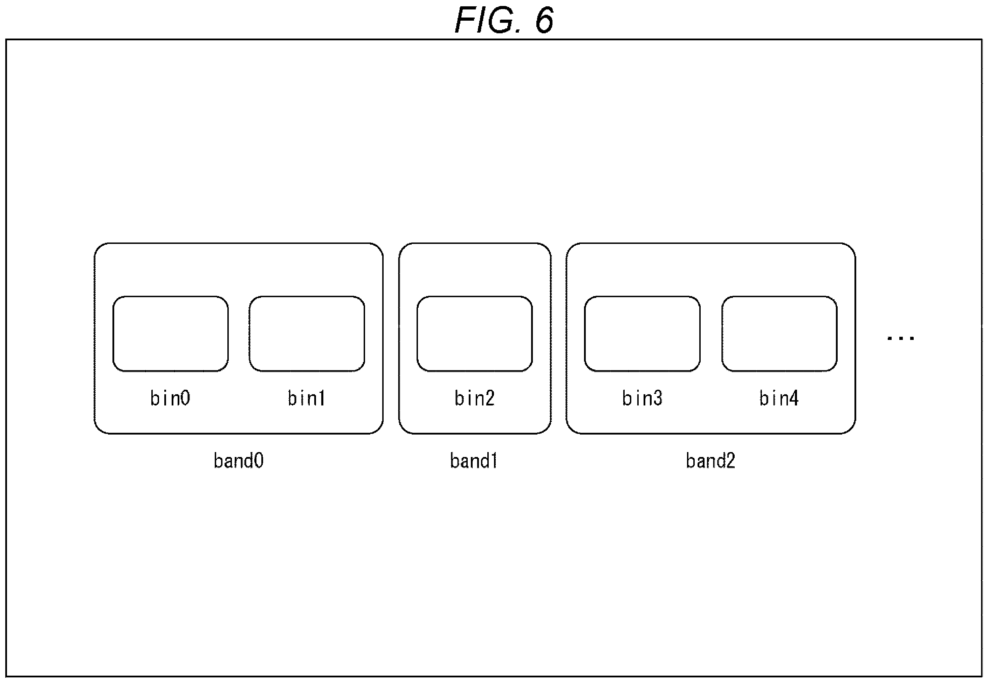

In this case, for example, as illustrated in Fig. 6, the number of bins belonging to each band may be different for each band.

In this example, two bin 0 (bin 0) and bin 1 belong to the first band 0 (band 0) with the lowest frequency, one bin 2 belongs to the next band 1, and two bin 3 and bin 4 belong to the next band 2.

Therefore, the value of the bin information "bin_range_per_band[i_band]" of the band 0 is a value "1" indicating the bin 1, that is, "bin_range_per_band[0] = 1". Similarly, the value of the bin information about the band 1 is "2", that is, "bin_range_per_band[1] = 2", and the value of the bin information about the band 2 is "4", that is, "bin_range_per_band[2] = 4".

Since the model data includes a model parameter, a mixture model F' (x; Θ) for each band can be obtained from the model parameters. Here, the mixture model F' (x; Θ) corresponds to the mixture model F(x; Θ) for each bin indicated by Expression (3).

The directivity data before modeling has a directivity gain value for each bin of each data point. Therefore, the mixture model F' (x; Θ) for each band obtained from the model parameter, more specifically the output value F' (x; Θ) of the mixture model, need to be converted to the original mixture model F(x; Θ) for each bin.

Therefore, in the device on the reproduction side (decoding side), the output value F(x; Θ) of the mixture model for each bin at a data point is calculated on the basis of the mixture model F' (x; Θ) for each band, the scale factor "scale factor [i_bin" for each bin, and the minimum value "offset[i _bin" for each bin.

That is, $F(x; Θ)=F' (x; Θ)×scale\_factor[i\_bin]+offset[i\_bin]$ is calculated. In this calculation, the output value F' (x; Θ) of the mixture model for each band is corrected according to the dynamic range of each bin.

Further, in a case where the differential compression is used together, that is, in a case where the model data includes the difference information "diff_data[i_point]" for each data point, the output value F(x; Θ), the difference information is added to the output value F(x; Θ) obtained by the calculation to make the final output value F(x; Θ).

By the above calculation, the original directivity data before modeling is restored from the model data. Note that, on the reproduction side, the position to be each data point and the frequency of each bin can be identified from the azimuth angle "azimuth_table[i]", the elevation angle "elevation_table[i]", the radius "distance[i]", and the frequency "freq[i_bin]" stored in the model data.

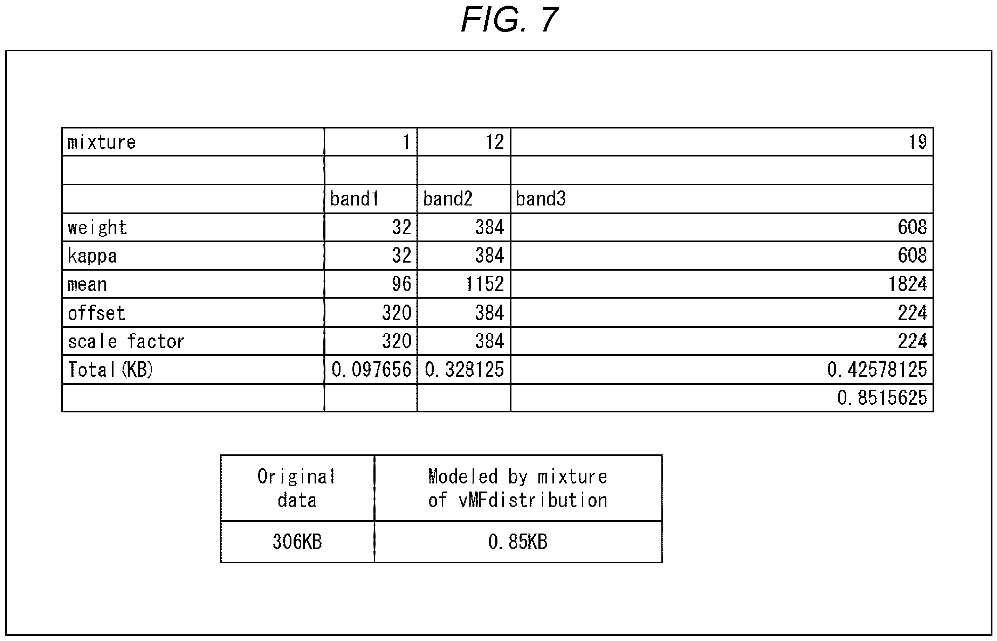

In practice, Fig. 7 illustrates the data amount of the model data when the directivity data is modeled so that the model data has the configuration illustrated in Fig. 5.

In this example, the number of data points in the original directivity data before modeling is 2522, and the number of bins is 29. Furthermore, at the time of modeling, the number of bands "band _count" is set to "3", and modeling with a mixture model including the vMF distribution (without ellipticity β, major axis vector $\gamma_2$, minor axis vector $\gamma_3$) is performed.

In the modeling of Fig. 7, it can be seen that the original directivity data having the data amount of 306 KB before modeling is converted into the model parameter having the data amount of 0.85 KB, and the data amount is compressed to about 1/360.

In addition, in the example of Fig. 5, the model data includes difference information as necessary, and the directivity data is restored using the difference information as appropriate.

That is, for example, in a case where the difference can be perceived from the viewpoint of auditory psychology, difference encoding is used together with modeling of the present technology, and the directivity data is restored to an unperceptible extent.

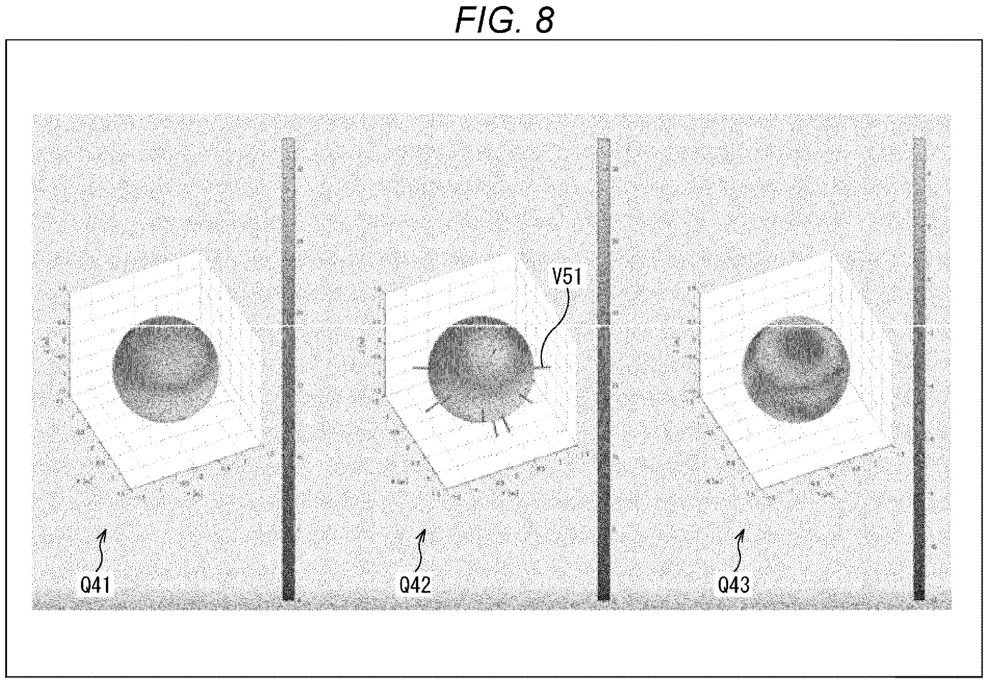

For example, it is assumed that modeling is performed for the directivity data indicated by the arrow Q41 in Fig. 8. Note that, in Fig. 8, the shade of color on each spherical surface indicates the magnitude of the directivity gain.

In this example, it is assumed that as a result of modeling the directivity data indicated by the arrow Q41, the mixture model indicated by the arrow Q42, more specifically, the directivity data represented by the mixture model is obtained.

In the portion indicated by the arrow Q42, each of a plurality of straight lines drawn on the spherical surface represents the above-described vector $\gamma_1$. For example, the vector V51 represents one vector $\gamma_1$.

In a case where the directivity data indicated by the arrow Q41 and the mixture model indicated by the arrow Q42 are obtained, the residual data indicated by the arrow Q43 is obtained as the difference information when the difference between the directivity data and the mixture model is obtained.

In the example illustrated in Fig. 5, the value (residual) at each data point of the residual data indicated by the arrow Q43 is stored in the model data as the difference information "diff _data[i_point]".

Note that there is a system called Higher Order Ambisonics (HOA) in a directivity expression system. The HOA has an advantage that not only amplitude information but also phase information can be recorded. However, as the shape of the directivity is more complicated, a higher-order term is required, and the amount of data increases. In addition, since the coefficient diverges in the HOA, there are prohibited frequencies that cannot be used.

As for the directivity, in general, the shape is more complicated and the degree of protrusion is higher in the high frequency range. In addition, in the high frequency range, the use value of the phase information relatively decreases. Therefore, in the case of reducing the data amount of the directivity data, it is more advantageous to adopt the method of modeling by the mixture distribution model as in the present technology than to use the HOA. Note that, in the low frequency range, the shape of the directivity is relatively gentle, and physical phenomena such as diffraction and interference can be reproduced by recording the phase. Therefore, HOA may be used in the low frequency range, and a method of modeling by a mixture distribution model may be used in the high frequency range.

In a case where the model data is transmitted to the reproduction side (decoding side), in the directivity data (amplitude data) generated (restored) on the basis of the model data, a directivity gain exists only at a specific discrete frequency point, that is, a specific bin. In other words, since there is a frequency at which the directivity gain does not exist, the rendering process may not be performed if the directivity data generated from the model data is used as it is.

In addition, since the data points are also discretely disposed, when the viewpoint position (sound reception position) of the user or the object moves and the positional relationship between the user and the object changes, the data points of the directivity data used for the rendering process also change. In such a case, glitch (waveform discontinuity) occurs when the interval between the data points adjacent to each other is wide.

Therefore, by performing the interpolation process in the frequency direction and the temporal direction on the directivity data, the directivity gain may be obtained for more frequencies (bins) and directions (data points).

For example, as the interpolation process in the frequency direction, it is conceivable to perform the primary interpolation process, the secondary interpolation process, or the like using the directivity gain of the bin indicating a plurality of frequencies in the vicinity of a specific frequency to be obtained.

Furthermore, for example, as the interpolation process in the temporal direction, it is conceivable to perform the bilinear interpolation process in the azimuth angle direction or the elevation angle direction using a directivity gain for each bin at a plurality of data points in the vicinity of the direction (position) to be obtained.

Note that the influence on the calculation amount and the sound quality at the time of modeling the directivity data varies (trade-off) depending on various parameters such as the frame length (number of samples/frame) of the audio data, the number of mixtures and the model (distribution) to be selected in the mixture model, and the number of data points.

That is, for example, in a case where the position and direction of the user (listener) or the object change for each frame of the audio data, the occurrence of the waveform discontinuity can be suppressed by performing the interpolation process in the temporal direction, and the audio reproduction with higher quality can be realized.

Furthermore, for example, on the reproduction side, it is possible to adjust the balance between the calculation amount and the sound quality by appropriately determining whether to increase the number of mixtures of the mixture models in order to obtain more accurate directivity data or to use the Kent distribution having a larger number of parameters than the vMF distribution but a higher expression capability.

Furthermore, the content creator or the like can also determine, for example, whether to increase the number of data points of the directivity data or deal with the small number of data points by the interpolation process at the time of reproduction according to the shape of the directivity of the sound source (object).

In addition, difference information indicating an error (difference) between the original directivity data to be modeled (encoded) and the mixture model, that is, the modeled directivity data may be encoded by any encoding method such as Huffman encoding and transmitted.

Furthermore, for example, a method of using the directivity data (rendering method) such as the interpolation process in the frequency direction and the interpolation process in the temporal direction, and whether or not to use various types of information such as difference information may be switched by a flag or the like.

For example, the flag may enable switching between a parameter for low accuracy for low resource reproduction device or the like and a parameter for high accuracy for high resource reproduction device or the like, that is, switching of parameter accuracy. In such a case, for example, the parameter is switched according to the resource of the reproduction device, the network environment at the time of content distribution, and the like.

Note that, although the example in which the present technology is applied to the directivity data is described above, the present technology can also be applied to color, transparency information, and the like for texture data in a video, for example, volumetric point cloud data.

Furthermore, in the present technology, for example, in a case where reproduction of a microstructure is important, a content creator or the like may manually (manually) add the number of mixtures models or adjust various parameters such as model parameter.

<Configuration example of server>

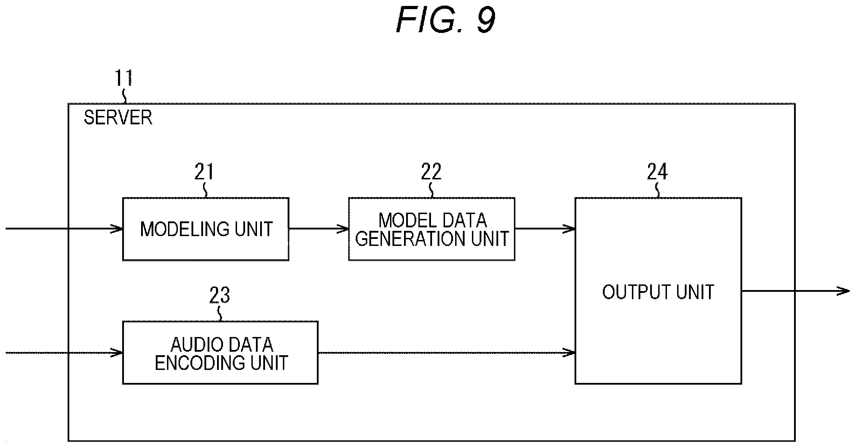

Fig. 9 is a diagram illustrating a configuration example of a server to which the present technology is applied.

A server 11 illustrated in Fig. 9 is an information processing device including, for example, a computer and the like, and distributes content.

For example, the content includes audio data (object audio data) of each of one or more objects and directivity data that is prepared for each sound source type and represents directivity of a sound source (object), that is, a directional characteristic.

Such content can be obtained, for example, by recording directivity data together with a sound of a 3D sound source with a microphone array or the like. Further, the content may include video data corresponding to the audio data.

The server 11 includes a modeling unit 21, a model data generation unit 22, an audio data encoding unit 23, and an output unit 24.

The modeling unit 21 models the input directivity data of each sound source type, and supplies model parameter and difference information obtained as a result to the model data generation unit 22.

The model data generation unit 22 generates model data on the basis of the model parameter and the difference information supplied from the modeling unit 21, and supplies the model data to the output unit 24.

The audio data encoding unit 23 encodes the input audio data of each object, and supplies encoded audio data obtained as a result to the output unit 24.

The output unit 24 generates and outputs an encoded bit stream by multiplexing the model data supplied from the model data generation unit 22 and the encoded audio data supplied from the audio data encoding unit 23.

Note that, in order to simplify the description, an example in which the model data and the encoded audio data are simultaneously output will be described, but the model data and the encoded audio data may be individually generated to output at different timings. In addition, the model data and the encoded audio data may be generated by different devices.

<Description of encoding process>

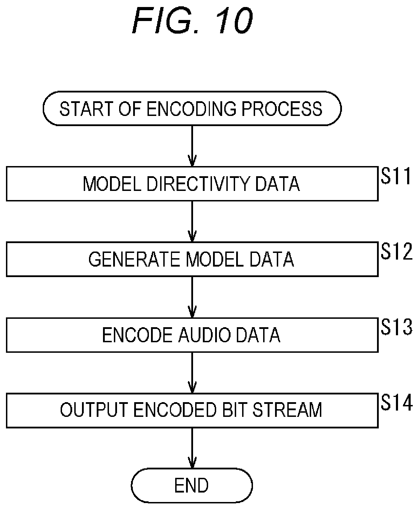

Next, an operation of the server 11 will be described. That is, hereinafter, the encoding process by the server 11 will be described with reference to the flowchart in Fig. 10.

In step S11, the modeling unit 21 models the input directivity data of each sound source type, and supplies the model parameter and the difference information obtained as a result to the model data generation unit 22.

For example, the modeling unit 21 models the directivity data by representing (expressing) the directivity data with the mixture model including a plurality of distributions shown in the above-described Expression (3).

As a result, the degree of parameter concentration $\kappa$, the ellipticity $\beta$, the weight $\varphi_i$, the vector $\gamma_1$, the major axis vector $\gamma_2$, the minor axis vector $\gamma_3$, the scale factor, and the minimum value constituting the mixture model shown in Expression (3) are obtained as model parameter.

In addition, the modeling unit 21 generates information indicating the number of data points, the position of the data points, the number of frequency points, the center frequency of the bin, and the like as the information regarding the original directivity data before modeling.

Furthermore, for example, the modeling unit 21 generates, as difference information, a residual (difference) between the modeled directivity data, that is, the directivity data represented by the mixture model, and the original directivity data before modeling.

Note that the difference information may be generated, for example, in a case where a specific condition is satisfied, such as a case where a residual between the directivity data represented by the mixture model and the original directivity data is equal to or more than a predetermined value, or in a case where a creator or the like of the content instructs generation of the difference information.

The modeling unit 21 supplies the model parameter obtained in this manner, information regarding the original directivity data before modeling, and difference information to the model data generation unit 22.

In step S12, the model data generation unit 22 generates model data by packing the model parameter supplied from the modeling unit 21, the information regarding the original directivity data before modeling, and the difference information, and supplies the model data to the output unit 24.

At this time, the model data generation unit 22 generates model data in the format illustrated in Fig. 5 by Huffman encoding the difference information and packing the encoded difference information (hereinafter, referred to as difference code data), the model parameter, and the like obtained as a result. Note that the model parameter and the model data may be encoded.

In step S13, the audio data encoding unit 23 encodes the input audio data of each object, and supplies the resultant encoded audio data to the output unit 24.

Note that, when there is metadata for the audio data of each object, the audio data encoding unit 23 also encodes the metadata of each object (audio data), and supplies encoded metadata obtained as a result to the output unit 24.

For example, the metadata includes object position information indicating an absolute position of the object in a three-dimensional space, object direction information indicating an orientation of the object in the three-dimensional space, sound source type information indicating a type of the object (sound source), and the like.

In step S14, the output unit 24 multiplexes the model data supplied from the model data generation unit 22 and the encoded audio data supplied from the audio data encoding unit 23 to generate and output an encoded bit stream. When the object includes the metadata, the output unit 24 generates an encoded bit stream including the model data, the encoded audio data, and the encoded metadata.

For example, the output unit 24 transmits an encoded bit stream to an information processing device functioning as a client (not illustrated). When the encoded bit stream is transmitted, the encoding process ends.

As described above, the server 11 models the directivity data to output the encoded bit stream including the model parameter and the difference information obtained as a result. In this way, it is possible to reduce the data amount of directivity data to be transmitted to the client, that is, the amount of transmission of directivity data. As a result, occurrence of a transmission delay and an increase in the transmission rate can be suppressed.

<Configuration example of information processing device>

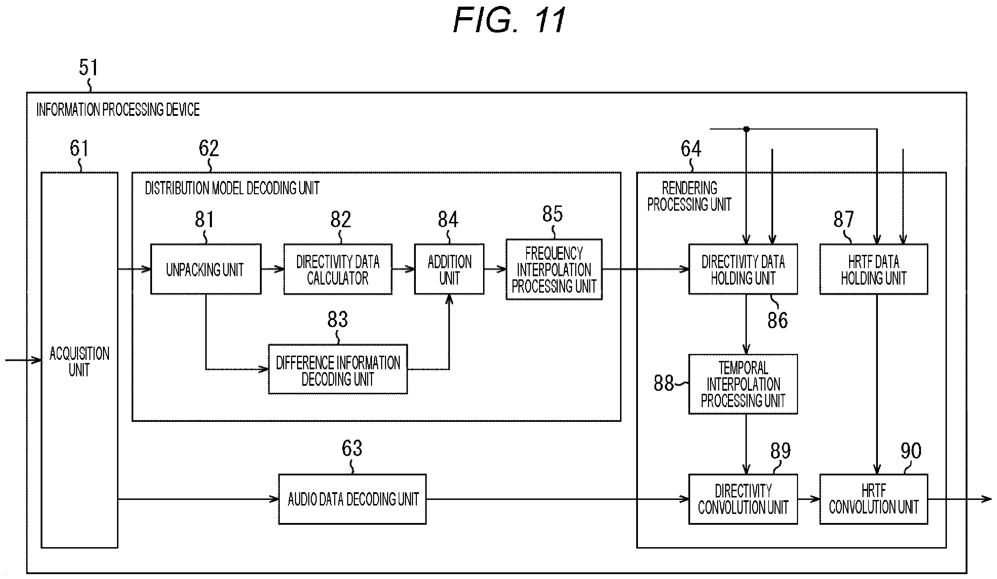

The information processing device configured to acquire the encoded bit stream output from the server 11 and generate the output audio data for reproducing the sound of the content is configured as illustrated in Fig. 11, for example. An information processing device 51 illustrated in Fig. 11 includes, for example, a personal computer, a smartphone, a tablet, a game device, or the like.

The information processing device 51 includes an acquisition unit 61, a distribution model decoding unit 62, an audio data decoding unit 63, and a rendering processing unit 64.

The acquisition unit 61 acquires the encoded bit stream output from the server 11, and extracts the model data and the encoded audio data from the encoded bit stream. The acquisition unit 61 supplies the model data to the distribution model decoding unit 62 and supplies the encoded audio data to the audio data decoding unit 63.

The distribution model decoding unit 62 calculates the directivity data from the model data. The distribution model decoding unit 62 includes an unpacking unit 81, a directivity data calculator 82, a difference information decoding unit 83, an addition unit 84, and a frequency interpolation processing unit 85.

The unpacking unit 81 performs unpacking on the model data supplied from the acquisition unit 61 to extract the model parameter, the information regarding the original directivity data before modeling, and the difference code data from the model data. In addition, the unpacking unit 81 supplies information regarding the model parameter and the original directivity data before modeling to the directivity data calculator 82, and supplies difference code data to the difference information decoding unit 83.

The directivity data calculator 82 calculates (restores) the directivity data on the basis of the information regarding the model parameter supplied from the unpacking unit 81 and the original directivity data before modeling, and supplies the directivity data to the addition unit 84. Note that, hereinafter, the directivity data calculated (restored) on the basis of the model parameter by the directivity data calculator 82 is also referred to as rough directivity data.

The difference information decoding unit 83 decodes the difference code data supplied from the unpacking unit 81 by a method compatible with Huffman encoding, and supplies difference information obtained as a result to the addition unit 84 as a directivity data residual.

The addition unit 84 adds the rough directivity data supplied from the directivity data calculator 82 and the directivity data residual (difference information) supplied from the difference information decoding unit 83 to generate directivity data close to the original directivity data, and supplies the generated directivity data to the frequency interpolation processing unit 85.

The frequency interpolation processing unit 85 performs the interpolation process in the frequency direction on the directivity data supplied from the addition unit 84, and supplies directivity data obtained as a result to the rendering processing unit 64.

The audio data decoding unit 63 decodes the encoded audio data supplied from the acquisition unit 61, and supplies the resultant audio data of each object to the rendering processing unit 64.

Furthermore, in a case where the encoded metadata is included in the encoded bit stream, the audio data decoding unit 63 decodes the encoded metadata supplied from the acquisition unit 61, and supplies the metadata obtained as a result to the rendering processing unit 64.

The rendering processing unit 64 generates output audio data on the basis of the directivity data supplied from the frequency interpolation processing unit 85 and the audio data supplied from the audio data decoding unit 63.

The rendering processing unit 64 includes a directivity data holding unit 86, a head related transfer function (HRTF) data holding unit 87, a temporal interpolation processing unit 88, a directivity convolution unit 89, and an HRTF convolution unit 90.

The viewpoint position information, the listener direction information, the object position information, and the object direction information are supplied to the directivity data holding unit 86 and the HRTF data holding unit 87 according to designation by the user or the like, measurement by a sensor or the like, or the like.

For example, the viewpoint position information is information indicating a viewpoint position (listening position) in a three-dimensional space of a user (listener) viewing the content, and the listener direction information is information indicating a direction of a face of the user viewing the content in the three-dimensional space.

Furthermore, in a case where the encoded metadata is included in the encoded bit stream, the object position information and the object direction information are extracted from the metadata obtained by decoding the encoded metadata and supplied to the directivity data holding unit 86 and the HRTF data holding unit 87.

In addition, the sound source type information obtained by being extracted from the metadata or the like is also supplied to the directivity data holding unit 86, and the user ID indicating the user who views the content is appropriately supplied to the HRTF data holding unit 87.

The directivity data holding unit 86 holds the directivity data supplied from the frequency interpolation processing unit 85. Further, the directivity data holding unit 86 reads directivity data corresponding to the viewpoint position information, the listener direction information, the object position information, the object direction information, and the sound source type information supplied from the held directivity data, and supplies the directivity data to the temporal interpolation processing unit 88.

The HRTF data holding unit 87 holds the HRTF for each of a plurality of directions viewed from the user (listener) for each user indicated by the user ID.

The HRTF data holding unit 87 reads the HRTF corresponding to the viewpoint position information, the listener direction information, the object position information, the object direction information, and the user ID supplied from the held HRTF, and supplies the HRTF to the HRTF convolution unit 90.

The temporal interpolation processing unit 88 performs the interpolation process in the temporal direction on the directivity data supplied from the directivity data holding unit 86, and supplies directivity data obtained as a result to the directivity convolution unit 89.

The directivity convolution unit 89 convolves the audio data supplied from the audio data decoding unit 63 and the directivity data supplied from the temporal interpolation processing unit 88, and supplies the resultant audio data to the HRTF convolution unit 90. By the convolution of the directivity data, the directional characteristic of the object (sound source) is added to the audio data.

The HRTF convolution unit 90 convolves the audio data supplied from the directivity convolution unit 89, that is, the audio data in which the directivity data is convolved, and the HRTF supplied from the HRTF data holding unit 87 to output the audio data obtained as a result as output audio data. By convolution of the HRTF, it is possible to obtain the output audio data in which the sound of the object is localized at the position of the object viewed from the user (listener).

<Description of directivity data generation process>

Next, the operation of the information processing device 51 will be described.

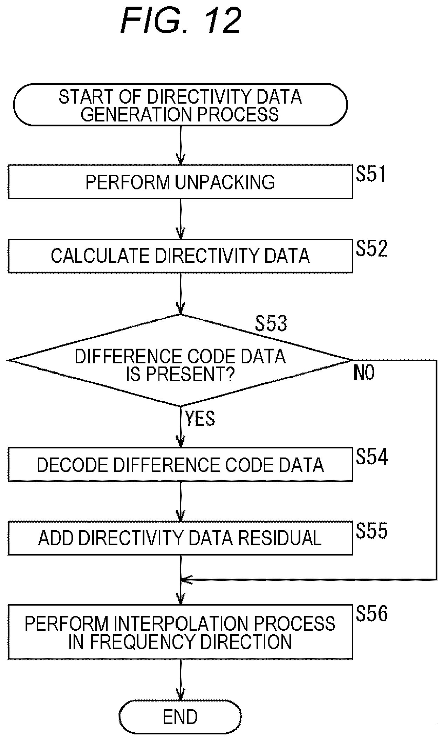

First, the directivity data generation process performed when the information processing device 51 generates directivity data of each sound source type will be described. That is, the directivity data generation process by the information processing device 51 will be described below with reference to the flowchart of Fig. 12.

The directivity data generation process is started when the acquisition unit 61 receives the encoded bit stream transmitted from the server 11 and the acquisition unit 61 supplies the model data extracted from the encoded bit stream to the unpacking unit 81.

In step S51, the unpacking unit 81 unpacks the model data supplied from the acquisition unit 61, and supplies information regarding the model parameter extracted from the model data and the original directivity data before modeling to the directivity data calculator 82.

In step S52, the directivity data calculator 82 calculates (generates) rough directivity data on the basis of the information regarding the model parameter supplied from the unpacking unit 81 and the original directivity data before modeling, and supplies the rough directivity data to the addition unit 84.

For example, the directivity data calculator 82 calculates the output value $F(x; \Theta)$ of the mixture model for each bin at the data point on the basis of the mixture model $F'(x; \Theta)$ of each band obtained by the model parameter, the scale factor "scale_factor[i_bin]" for each bin, and the minimum value "offset[i _bin]" for each bin. As a result, rough directivity data including a directivity gain (amplitude data) for each bin at each data point is obtained.

In step S53, the unpacking unit 81 determines whether or not the difference code data is included in the model data supplied from the acquisition unit 61, that is, whether or not the difference code data is present.

In a case where it is determined in step S53 that the difference code data is included, the unpacking unit 81 extracts the difference code data from the model data and supplies the difference code data to the difference information decoding unit 83, and thereafter, the process proceeds to step S54.

In step S54, the difference information decoding unit 83 decodes the difference code data supplied from the unpacking unit 81, and supplies a directivity data residual (difference information) obtained as a result to the addition unit 84.

In step S55, the addition unit 84 adds the directivity data residual supplied from the difference information decoding unit 83 to the rough directivity data supplied from the directivity data calculator 82.

The addition unit 84 supplies the directivity data obtained by the addition to the frequency interpolation processing unit 85, and thereafter, the process proceeds to step S56.

On the other hand, in a case where it is determined in step S53 that the difference code data is not included, the process in steps S54 and S55 is skipped, and then the process proceeds to step S56. In this case, the addition unit 84 supplies the rough directivity data supplied from the directivity data calculator 82 to the frequency interpolation processing unit 85 as restored directivity data as it is.

When it is determined in step S53 that the difference code data is not included or the process in step S55 is performed, the process in step S56 is performed.

In step S56, the frequency interpolation processing unit 85 performs the interpolation process in the frequency direction on the directivity data supplied from the addition unit 84, and supplies the directivity data obtained by the interpolation process to the directivity data holding unit 86 to hold.

For example, it is assumed that the audio data of the object is data in a frequency domain, and the audio data has a frequency component value for each of a plurality of frequency bins. In such a case, in the interpolation process in the frequency direction, for example, the interpolation process of calculating a directivity gain of a necessary bin is performed such that the directivity data has a directivity gain for all frequency bins in which the audio data has a frequency component value.

Specifically, for example, the frequency interpolation processing unit 85 performs the interpolation process based on the directivity gains of a plurality of bins (frequencies) at a predetermined data point in the directivity data, thereby calculating a directivity gain of a new frequency (bin) at the same data point that does not exist in the original directivity data. By such an interpolation process in the frequency direction, it is possible to obtain directivity data including directivity gains at more frequencies.

When the interpolation process in the frequency direction is performed and the directivity data after the interpolation process is held in the directivity data holding unit 86, the directivity data generation process ends.

As described above, the information processing device 51 calculates the directivity data on the basis of the model data. In this way, the data amount of directivity data to be transmitted, that is, the amount of transmission of directivity data can be reduced. As a result, occurrence of a transmission delay and an increase in the transmission rate can be suppressed.

<Description of output audio data generation process>

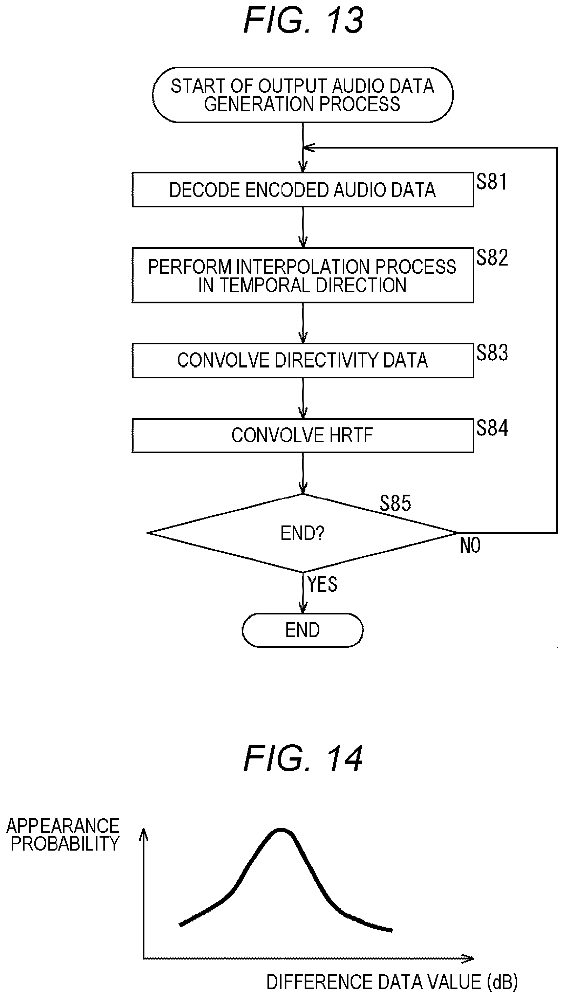

Next, the output audio data generation process performed by the information processing device 51 will be described with reference to the flowchart in Fig. 13. This output audio data generation process is performed at any timing after the directivity data generation process described with reference to Fig. 12 is performed.

In step S81, the audio data decoding unit 63 decodes the encoded audio data supplied from the acquisition unit 61, and supplies the resultant audio data to the directivity convolution unit 89. For example, audio data in a frequency domain is obtained by decoding.

Note that, in a case where the encoded metadata is supplied from the acquisition unit 61, the audio data decoding unit 63 decodes the encoded metadata, and supplies the object position information, the object direction information, and the sound source type information included in the metadata obtained as a result to the directivity data holding unit 86 and the HRTF data holding unit 87 as appropriate.

Further, the directivity data holding unit 86 supplies the directivity data corresponding to the viewpoint position information, the listener direction information, the object position information, the object direction information, and the sound source type information supplied to the temporal interpolation processing unit 88.

For example, the directivity data holding unit 86 identifies the relationship between the object and the viewpoint position (listening position) of the user in the three-dimensional space from the viewpoint position information, the listener direction information, the object position information, and the object direction information, and identifies the data point corresponding to the identifying result.

As an example, for example, when a direction from the object to the viewpoint position is a viewpoint position direction, a position on the spherical surface of the mixture model in the viewpoint position direction when viewed from the center of the mixture model is identified as the target data point position. Note that there may be no actual data point at the target data point position.

The directivity data holding unit 86 extracts a directivity gain of each bin at a plurality of data points near the identified target data point position from the directivity data of the sound source type indicated by the sound source type information.

Then, the directivity data holding unit 86 supplies data including the directivity gains of the respective bins at the plurality of extracted data points to the temporal interpolation processing unit 88 as directivity data according to the relationship between the positions and directions of the object and the user (listener).

Further, the HRTF data holding unit 87 supplies the HRTF corresponding to the viewpoint position information, the listener direction information, the object position information, the object direction information, and the user ID supplied to the HRTF convolution unit 90.

Specifically, for example, the HRTF data holding unit 87 identifies the relative direction of the object viewed from the listener (user) as the object direction on the basis of the viewpoint position information, the listener direction information, the object position information, and the object direction information. Then, the HRTF data holding unit 87 supplies an HRTF in the direction corresponding to the object direction among the HRTFs in the respective directions corresponding to the user ID to the HRTF convolution unit 90.

In step S82, the temporal interpolation processing unit 88 performs the interpolation process in the temporal direction on the directivity data supplied from the directivity data holding unit 86, and supplies directivity data obtained as a result to the directivity convolution unit 89.

For example, the temporal interpolation processing unit 88 calculates the directivity gain of each bin at the target data point position by the interpolation process on the basis of the directivity gain of each bin at the plurality of data points included in the directivity data. That is, the directivity gain at a new data point (target data point position) different from the original data point is calculated by the interpolation process.

The temporal interpolation processing unit 88 supplies data including the directivity gain of each bin at the target data point position to the directivity convolution unit 89 as directivity data obtained by the interpolation process in the temporal direction.

In step S83, the directivity convolution unit 89 convolves the audio data supplied from the audio data decoding unit 63 and the directivity data supplied from the temporal interpolation processing unit 88, and supplies the resultant audio data to the HRTF convolution unit 90.

In step S84, the HRTF convolution unit 90 convolves the audio data supplied from the directivity convolution unit 89 and the HRTF supplied from the HRTF data holding unit 87 to output the output audio data obtained as a result.

In step S85, the information processing device 51 determines whether or not to end the processing.

For example, in a case where encoded audio data of a new frame is supplied from the acquisition unit 61 to the audio data decoding unit 63, it is determined in step S85 that the process is not ended. On the other hand, for example, in a case where the encoded audio data of the new frame is not supplied from the acquisition unit 61 to the audio data decoding unit 63 and the output audio data of all the frames of the content is generated, it is determined in step S85 that the process is ended.

In a case where it is determined in step S85 that the process is not yet ended, thereafter, the process returns to step S81, and the above-described process is repeatedly performed.

On the other hand, in a case where it is determined in step S85 that the process is ended, the information processing device 51 ends the operation of each unit and the output audio data generation process ends.

As described above, the information processing device 51 selects appropriate directivity data and HRTF, and convolves the directivity data and the HRTF in the audio data to obtain output audio data. By doing so, it is possible to realize high-quality audio reproduction with a more realistic feeling in consideration of the directional characteristic of the object (sound source) and the relationship between the positions and orientations of the object and the listener.

<Second embodiment>

<Encoding of difference information>

Meanwhile, the directivity data has different directivity shapes for each sound source type and each frequency band.

In addition, in the server 11, difference information indicating a difference between the unmodeled directivity data and the modeled directivity data is appropriately generated. In the above example, it is described that the difference information is encoded by an encoding method such as Huffman encoding, and the difference code data is obtained.

The method of encoding the difference information may be selected by the server 11, that is, the encoder, so that the appropriate encoding may be performed according to the sound source type and the frequency band for not only the modeling based on the Kent distribution and the vMF distribution but also the encoding of the difference information.

Here, a case where the difference information is Huffman encoded will be described as an example.

In Huffman encoding, for example, as illustrated in Fig. 14, a distribution of appearance probability (probability density function) is generated on the basis of difference information for each of a plurality of bins obtained from one piece of directivity data to be encoded.

Note that, in Fig. 14, the horizontal axis represents the value (dB value) of the difference information, and the vertical axis represents the appearance probability of each value of the difference information.

For example, all bins (frequencies) at all data points of the directivity data are targeted, and a histogram is generated from the difference information about each bin, so that the appearance probability of each value of the difference information is obtained. Note that the distribution of the appearance probability (probability density function) may be obtained for each bin, may be obtained for a bin included in a specific frequency band, may be obtained for all bins, or any of them may be selectable.

In the server 11, one appropriate Huffman encoding table is selected from a plurality of Huffman encoding tables prepared in advance or one new Huffman encoding table is generated on the basis of the appearance probability of the difference information.

All bins (frequencies) at all data points of the directivity data are targeted, and one Huffman encoding table may be selected or generated for all those bins, or one Huffman encoding table may be selected or generated for one or more bins.

The Huffman encoding of the difference information is performed using the Huffman encoding table selected or generated in this manner.

The Huffman encoding table is a table for converting data before encoding into a Huffman code, the table indicating a correspondence between data before encoding, that is, difference information and a Huffman encode (code data) obtained by encoding.

In addition, when the difference code data obtained by Huffman encoding the difference information is decoded, the reverse table corresponding to the Huffman encoding table is used.

The reverse table is a table for converting a Huffman code into decoded data, the table indicating a correspondence between the Huffman code (code data) and the decoded data. This reverse table can be generated from a Huffman encoding table.

In a case of Huffman encoding the difference information, both the server 11 (encoder) and the information processing device 51 (decoding unit) may hold the Huffman encoding table in advance. In such a case, the server 11 notifies the information processing device 51 of the ID information indicating the Huffman encoding table used for Huffman encoding the difference information.

Furthermore, the server 11 may store the Huffman encoding table or the reverse table in the encoded bit stream to it to the information processing device 51.

Specifically, since the size (data amount) of the reverse table is large, the Huffman encoding table may be transmitted from the server 11 to the information processing device 51, and the information processing device 51 may generate the reverse table on the basis of the Huffman encoding table at the time of decoding or the like.

In addition, in the distribution of the appearance probability (probability density function), there are a value of difference information with a low appearance probability (appearance frequency) and a value of difference information with a high appearance probability. Therefore, for example, a range corresponding to data of a narrow dynamic range including a value of difference information having a high appearance probability, such as a range of $\pm 3$ dB as a range of possible values of difference information, may be set as a target range, and a Huffman encoding table for only the target range may be used.

In such a case, for difference information about a value outside the target range, that is, difference information about an irregular value having a low appearance probability, the difference information may be stored as it is in the model data. In other words, the difference information is treated as the difference code data as it is.

As described above, the efficient Huffman encoding table is selected or generated according to the probability density function of the difference information, and the information regarding which Huffman encoding table is used is described in the encoded bit stream, so that the difference information can efficiently be encoded and transmitted.

Furthermore, in encoding the difference information, by using one or more methods in combination, the dynamic range can be further reduced, and the encoding efficiency can be improved. Specifically, multi-stage difference encoding can be implemented by combining a plurality of methods.

For example, in the multi-stage difference encoding, it is conceivable to perform encoding by combining at least two or more of the spatial adjacency difference method, the inter-frequency difference method, or the complex difference method.

In addition, for example, a mode indicating the presence or absence and the method of the multi-stage difference encoding is recorded as enc_mode or the like in the model data. At this time, for example, in a case where the multi-stage difference encoding method is recorded in the lower 4 bits and which of a real number or a complex number the target is is recorded in the upper 4 bits, the following information is stored in the model data.

(Target data is real number)

    0x00: no multi-stage difference encoding
    0x01: spatial adjacency difference method
    0x02: inter-frequency difference method
    0x03: spatial adjacency difference method + inter-frequency difference method

(Target data is complex number)

0x1*: lower bits are the same as those in the case where the target data is real number

**[0228]** In the spatial adjacency difference method, when difference information at a data point to be processed is encoded, a difference between difference information at the data point to be processed and difference information at another data point in the vicinity of the data point to be processed is obtained as spatial difference information. For example, a difference in difference information between data points adjacent to each other is obtained as the spatial difference information. Then, the obtained spatial difference information is Huffman encoded to be difference code data.

In the spatial adjacency difference method, a property that data at a spatially close position (data point) in the directivity data, that is, a directivity gain and difference information, easily take close values is used.

In the inter-frequency difference method, when difference information about a bin (frequency) to be processed is encoded, a difference between difference information in a bin to be processed and difference information in another bin such as a bin adjacent to the bin to be processed, the another bin indicating a close frequency, is obtained as inter-frequency difference information. Then, the obtained inter-frequency difference information is Huffman encoded to be difference code data.

In the inter-frequency difference method, a property that data of a close frequency (bin), that is, a directivity gain or difference information can easily take close values is used.

For example, in a case where the spatial adjacency difference method and the inter-frequency difference method are used in combination, the difference in the spatial difference information between the adjacent bins is obtained as the inter-frequency difference information, and the inter-frequency difference information is Huffman encoded, or the difference in the inter-frequency difference information between the adjacent data points is obtained as the spatial difference information, and the spatial difference information is Huffman encoded.

The complex difference method is used in a case where the directivity data has not only the information regarding the amplitude described above but also the information regarding the phase.

For example, in a case where the directivity data has information regarding the amplitude and the phase, the information regarding the amplitude and the phase, that is, the directivity gain is expressed by a complex number. That is, the directivity data has complex number data (hereinafter, also referred to as complex directivity gain) indicating the amplitude and the phase for each bin for each data point, and the difference information is also complex number data.

In the complex difference method, a real part and an imaginary part of difference information represented by a complex number are independently (individually) Huffman encoded, or Huffman encoding is performed on two-dimensional data (complex directivity gain) including the real part and the imaginary part. Note that, in the complex difference method, it may be possible to select whether to individually perform Huffman encoding on each of the real part and the imaginary part or to perform Huffman encoding on two-dimensional data.

Hereinafter, each method of performing encoding by combining at least one or more methods of the spatial adjacency difference method, the inter-frequency difference method, or the complex difference method, and a method of Huffman encoding the difference information as it is are also referred to as one difference encoding method or difference encoding mode. Specifically, it can be said that the difference encoding method in which the difference information is directly Huffman encoded is a method in which encoding using a difference, that is, difference encoding is not performed.

For example, the server 11 selects the most efficient method from the plurality of difference encoding methods (difference encoding mode) on the basis of the difference information and the like, and Huffman encodes the difference information by the selected difference encoding method.

Specifically, for example, the code amount (data amount) of the difference code data in each difference encoding method may be obtained by an operation based on the difference information, and the method having the smallest code amount among the difference encoding methods may be selected as the most efficient method.

In addition, an appropriate difference encoding method may be selected on the basis of, for example, a sound source type of directivity data, an environment at the time of recording directivity data such as an anechoic chamber, or the like.

<Representation method of directivity data>

The example in which the directivity data is modeled by the mixture model (mixture distribution model) including the Kent distribution and the vMF distribution has been mainly described above.

In addition, for example, it is described that the directivity data may be modeled by the HOA and the information regarding the phase may also be recorded in the low frequency range, that is, the low frequency bin, and the directivity data may be modeled by the mixture model including the Kent distribution and the vMF distribution in the high frequency range in which the degree of importance of the phase is relatively low, that is, the high frequency bin. In this case, for example, it is conceivable to switch between modeling by the mixture model and modeling by the HOA at a predetermined frequency in the vicinity of 1.5 kHz to 2 kHz. For example, intensity stereo that does not use phase information in an audio codec or the like is used in the above band or higher. The method of combining the HOA and the mixture model as described above is considered to be effective in a case of having sharp front directivity, for example, a whistle or a trumpet.

Note that the present invention is not limited thereto, and the model data may be generated by combining at least one or more methods of the HOA method, the mixing method, the complex mixing method, or the difference method for each frequency band, that is, for each bin or band, or in common for all frequency bands. In such a case, for example, the directivity data is modeled by one or more methods different from each other such as the HOA method and the mixing method, and model data including model parameter and the like obtained as a result thereof is generated.

The HOA method is a method of modeling directivity data including a complex directivity gain for each bin at each data point using HOA. That is, the HOA method is a method of modeling the directivity data by spherical harmonic function expansion.

Specifically, in the HOA method, spherical harmonic function expansion is performed on the directivity data, and as a result, a spherical harmonic coefficient that is a coefficient for the spherical harmonic function of each dimension is obtained as a model parameter. From the spherical harmonic coefficient of each dimension, it is possible to obtain the directivity data including the complex directivity gain after modeling by the HOA.

As described above, in the modeling by the HOA method, the expression including the phase is possible, but in order to perform the fine expression, it is necessary to increase the order of the spherical harmonic function expansion, that is, to obtain the spherical harmonic coefficient up to the high-order term, and in such a case, the data amount of the model data increases. Specifically, in the modeling by the HOA method, it is not possible to finely express the distribution of the amplitude and the phase only in a specific azimuth (direction).

Conversely, in a case where the spherical harmonic coefficient is obtained only for the low-order term, only a relatively gentle change in amplitude or phase can be described.

The mixing method is a method of performing modeling by a mixture model including the Kent distribution and the vMF distribution described above. In the mixing method, it is possible to describe the shape of the directivity gain that changes drastically in a specific azimuth (direction) seen from the sound source, that is, the position of the data point.

The complex mixing method is a method of modeling directivity data including a complex directivity gain, that is, amplitude and phase data, using a mixture distribution (mixture model) corresponding to a complex number.

As an example of the complex mixing method, for example, modeling by the following two methods is considered.

First, as a first method, it is conceivable to perform modeling by describing each of a real part and an imaginary part of a complex directivity gain or each of an amplitude and a phase angle obtained from the complex directivity gain independently with a mixture model of a probability density function for a real number.

As a second method, a method of performing modeling by describing directivity data (distribution of complex directivity gains) using a complex Bingham distribution mixture model corresponding to a complex number, a complex watson distribution mixture model, or the like is considered.

In this case, for example, the directivity data is modeled by a mixture model including one or more complex Bingham distributions or a mixture model including one or more complex watson distributions, and as a result, the model parameter similar to that in the case of the mixing method is obtained. Directivity data including the complex directivity gain after modeling by the complex mixing method can be obtained from the model parameter obtained in this manner.

As an example, in a case where the distribution of the target complex number data is described as the complex Bingham distribution as it is, the description is made in a format illustrated in the following Expression (5). That is, the value f(z) of the complex Bingham distribution is expressed by the following Expression (5).

[Math 5]

$$f(z) = C(A)^{-1} \exp(z^* A z) \qquad \cdots (5)$$

The complex number vector z in Expression (5) corresponds to the position vector x of the spherical surface in the Kent distribution or the vMF distribution, and z* is its complex conjugate. The complex matrix A is a $k \times k$ dimensional matrix indicating a position, steepness, a direction, and a shape, and the normalization coefficient C(A) is expressed by the following Expression (6).

[Math 6]

$$C(A) = 2\pi^k \sum_{j=1}^{k} a_j \exp(\lambda_j) \qquad \cdots (6)$$

where, the definition of $a_j$ is as in the following Expression (7). $\lambda_j$ is an eigenvalue of the complex matrix A, and $\lambda_1 < \lambda_2 < \lambda_3 < \ldots \lambda_k$.

[Math 7]

$$a_j = \frac{1}{\prod_{i \neq j}(\lambda_j - \lambda_i)} \qquad \cdots (7)$$

The number of mixtures and weights in the mixture model including one or more complex Bingham distributions, that is, the complex Bingham mixture model, are common to the formulation of the mixture model including the Kent distribution and the vMF distribution described above. The value F(x; Θ) of the mixture model including N complex Bingham distributions f(z; $\theta_i$) can be described by weighting according to the following Expression (8). Note that, as illustrated in Expression (9), the sum of the weights is 1, Θ represents a set of all parameters, $\theta_i$ represents a set of parameters of each complex Bingham distribution (parameters constituting the complex Bingham distribution), and $\varphi_i$ represents a weight for each complex Bingham distribution.

[Math. 8]

$$F(x;\Theta) = \sum_{i=1}^{N} \phi_i f(z;\theta_i) \qquad \cdots (8)$$

[Math. 9]

$$\sum_{i=1}^{N} \phi_i = 1 \qquad \cdots (9)$$

The difference method is a method of generating model data using the difference.

For example, in a case where the model data is generated by combining one or more other methods such as the HOA method and the mixing method and the difference method, in the difference method, difference information indicating a difference between the directivity data before modeling and the directivity data after modeling by the one or more of other methods is encoded by the any difference encoding method, and the difference code data obtained as a result is stored in the model data. Note that the difference of the directivity data obtained by the difference method may be modeled by the HOA method or the like.

In the difference method, for example, at least any one of a difference between spatial positions (between data points) or a difference between frequencies (between bins or bands) is obtained for difference information, and the difference obtained as a result is Huffman encoded to be difference code data. At this time, in a case where the difference of the difference information to be Huffman encoded is a complex number, each of the real part and the imaginary part of the difference may be individually Huffman encoded, the complex number may be Huffman encoded as it is, or each of the amplitude component and the phase component obtained from the difference may be individually Huffman encoded.

On the other hand, in a case where only the difference method is used, that is, in a case where the model data is generated by the difference method alone, the encoding (Huffman encoding) on the directivity data is performed as in the any difference encoding method described above.

At this time, at least one or more of the spatial adjacency difference method, the inter-frequency difference method, or the complex difference method including at least one method of the spatial adjacency difference method and the inter-frequency difference method are used. That is, the difference in the directivity gain between the positions (between the data points) and between the frequencies (between the bins or between the bands) in the space is obtained, and the difference is Huffman encoded. When the difference is expressed by a complex number, the real part and the imaginary part of the difference may be individually Huffman encoded, or the difference (complex number) may be Huffman encoded. Further, each of the amplitude component and the phase component obtained from the difference may be individually Huffman encoded.

Furthermore, model data including data (hereinafter, also referred to as encoded directivity data) including a Huffman code obtained by Huffman encoding for the difference obtained by the difference method is generated. In this case, since there is no residual in the directivity data, the model data does not include the difference code data.

Note that, in the difference method, lossless compression is possible, but the compression rate varies depending on data. In addition, in a case where processing of obtaining a multi-stage difference by combining a plurality of methods such as the spatial adjacency difference method and the inter-frequency difference method, that is, obtaining the differences is performed a plurality of times, unlike the case of one-dimensional data, it is necessary to define the data order when the difference code data and the encoded directivity data are stored in the model data, and the compression rate varies depending on the data order.

In generating the model data from the directivity data, it is also conceivable to model the average value of the directivity gains for each bin or each band of the directivity data, that is, the average directional characteristic. In such a case, the difference information is calculated after applying the offset and the scale factor to the average directional characteristic and matching the dynamic range.

In a case where model data is generated by combining the HOA method, the mixing method, the complex mixing method, and the difference method as described above, classification into the following five methods is mainly considered as a method of generating model data.

The five methods mentioned herein are a band hybrid method, an addition hybrid method, a multiplication hybrid method, a spherical harmonic coefficient modeling method, and a combination hybrid method. Each method will be described below.

(Band hybrid method)

The band hybrid method is a method of switching whether to generate the model data using which of the HOA method, the mixing method, the complex mixing method, and the difference method for each frequency band, that is, for each bin or each band. In this case, for example, recording with a complex directivity gain may be performed in the low frequency range, and recording with a real number directivity gain may be performed in the high frequency range.

As a specific example, for example, it is possible to model the directivity data by a method different for each band (frequency band), such as performing modeling by the HOA method in the low frequency band and performing modeling by the mixing method in the high frequency band.

Furthermore, for example, modeling by a complex mixing method using a complex Bingham distribution or the like may be performed in a low frequency band, and modeling by a mixing method may be performed in a high frequency band.

(Addition hybrid method)

In the addition hybrid method, difference information indicating a difference from the modeled directivity data is further modeled or encoded by the difference method.

Specific examples of the addition hybrid method include the following methods (AH1) to (AH4). Specifically, in the following example, the process is executed in order from the method described on the left side.

Method (AH1): Mixing method + difference method
Method (AH2): HOA method (low order) + mixing method
Manner (AH3): HOA Manner (low order) + difference method
Method (AH4): HOA method (low order) + mixing method + difference method

In method (AH1), the directivity data is first modeled in a mixing method. Next, difference information indicating a difference between the directivity data before modeling and the directivity data after modeling by the mixing method is encoded by the difference method, and difference code data is generated.

Then, model data including the model parameter obtained by modeling by the mixing method and the difference code data is generated.

In method (AH2), first, the directivity data is modeled in the HOA method. Specifically, in the modeling by the HOA method, spherical harmonic function expansion up to a low-order term is performed. Next, difference information indicating a difference between the directivity data before modeling and the directivity data after modeling by the HOA method is further modeled by the mixing method.

Then, model data including the model parameter obtained by modeling by the HOA method and the model parameter obtained by modeling the difference information by the mixing method is generated.

In the method (AH3), as in the method (AH2), modeling up to a lower-order term is performed by the HOA method, and then difference information obtained by modeling by the HOA method is encoded by the difference method, and difference code data is generated.

Then, model data including the model parameter obtained by modeling by the HOA method and the difference code data is generated.

In the method (AH4), as in the method (AH2), modeling up to the lower-order term is performed by the HOA method, and then modeling of the difference information is further performed by the mixing method.

Next, difference information indicating a difference between difference information obtained by modeling by the HOA method and difference information after modeling by the mixing method is encoded by the difference method, and difference code data is generated. In other words, difference information indicating a difference between the directivity data after modeling modeled by the combination of the HOA method and the mixing method and the directivity data before modeling is encoded by the difference method, and difference code data is generated.

Then, model data including a model parameter obtained by modeling by the HOA method, a model parameter obtained by modeling the difference information by the mixing method, and difference code data is generated.

Hereinafter, the difference information to be modeled is also particularly referred to as intermediate difference information in order to further distinguish the difference information to be modeled from the difference information to be encoded in the difference method after modeling the directivity data in the predetermined method.

For example, in the method (AH4), difference information obtained by modeling by the HOA method is intermediate difference information, and the intermediate difference information is modeled by the mixing method. Then, difference information indicating a difference between the original intermediate difference information and the intermediate difference information after modeling by the mixing method is encoded by the difference method.

Among the above methods (AH1) to (AH4), data that completely matches the original directivity data cannot be obtained on the decoding side in the method (AH2), but data that completely matches the original directivity data is obtained in the method (AH1), the method (AH3), and the method (AH4).

In addition, the directivity data may be modeled or encoded by a single method instead of the addition hybrid method. That is, for example, the directivity data may be modeled or encoded by only any one of the HOA method, the mixing method, and the difference method, and the model data including the model parameter or the encoded directivity data obtained as a result thereof may be generated.

(Multiplication hybrid method)

In the multiplication hybrid method, the directivity data is modeled by a predetermined method, and the ratio (quotient) of the modeled directivity data and the unmodeled directivity data is further modeled by another method different from the predetermined method.

Specific examples of the multiplication hybrid method include the following methods (MH1) and (MH2).

Method (MH1): HOA method (low order) × amplitude modulation (mixing method)
Method (MH2): HOA method (low order) × amplitude phase modulation (mixing method)

In the method (MH1), first, the directivity data is modeled by the HOA method. Specifically, in the modeling by the HOA method, spherical harmonic function expansion up to a low-order term is performed.

Next, a value (hereinafter, also referred to as amplitude modulation information) obtained by dividing the directivity data before modeling by the directivity data after modeling by the HOA method is further modeled by the mixing method. At this time, for example, the absolute value (amplitude component) of the complex number (complex directivity gain) constituting the amplitude modulation information may be a value for modeling by the mixing method, or the ratio of the amplitude components of the directivity data before and after modeling may be the amplitude modulation information. Then, model data including the model parameter obtained by modeling by the HOA method and the model parameter obtained by modeling the amplitude modulation information by the mixing method is generated.

At the time of decoding, the directivity data calculated from the model parameter for the HOA method is multiplied by the amplitude modulation information calculated from the model parameter for the mixing method, and the final directivity data is calculated.

In such a method (MH1), amplitude modulation information indicating a small amplitude swing according to a high frequency azimuth (direction from a sound source), the information not being able to be expressed by modeling up to a low-order term in the HOA method, is modeled by the mixing method and recorded (stored) in model data. At the time of decoding, the directivity data calculated from the model parameter for the HOA method is modulated by the amplitude modulation information, and the directivity data with less error is obtained.

In the method (MH2), as in the method (MH1), modeling up to the lower-order term in the HOA method is performed on the directivity data.

Next, a value (hereinafter, also referred to as amplitude phase modulation information) obtained by dividing the directivity data before modeling by the directivity data after modeling by the HOA method is further modeled by the mixing method. At this time, for example, the real part and the imaginary part of the complex number (complex directivity gain) constituting the amplitude phase modulation information, or the amplitude component and the phase component are to be modeled by the mixing method. Note that the amplitude phase modulation information may be modeled by a complex mixing method. Then, model data including the model parameter obtained by modeling by the HOA method and the model parameter obtained by modeling the amplitude phase modulation information by the mixing method is generated.

At the time of decoding, the directivity data calculated from the model parameter for the HOA method is multiplied by the amplitude phase modulation information calculated from the model parameter for the mixing method, and the final directivity data is calculated.

In such a method (MH2), the amplitude phase modulation information indicating the rotational change in the high frequency phase according to the azimuth (direction from the sound source), the information not being able to be expressed by the modeling up to the low-order term in the HOA method, is modeled by the mixing method and recorded (stored) in the model data. At the time of decoding, the directivity data calculated from the model parameter for the HOA method is modulated by the amplitude phase modulation information, and the directivity data with less error is obtained.

In the multiplication hybrid method or another method, in a case where a directivity gain (complex directivity gain) or intermediate difference information expressed by a complex number is modeled, modeling may be performed independently (individually) by different or the same method between a real part and an imaginary part of the complex number. For example, the real part may be modeled by the mixing method, and the imaginary part may also be modeled by the mixing method.

Similarly, the amplitude component and the phase component may be independently (individually) modeled by any method, or data of a complex number may be modeled by a complex mixing method.

(Spherical harmonic coefficient modeling method)

In the spherical harmonic coefficient modeling method, the directivity data is modeled by the HOA method, model parameter obtained as a result thereof, that is, the spherical harmonic coefficient, is further modeled by the mixing method, and the model parameter obtained as a result thereof is stored in the model data.

Therefore, in the spherical harmonic coefficient modeling method, it can be said that the directivity data is modeled in two stages of the HOA method and the mixing method. At the time of decoding, first, the spherical harmonic coefficient is calculated on the basis of the model parameter for the mixing method, and further, the directivity data (rough directivity data) is calculated on the basis of the spherical harmonic coefficient.

In addition, for example, each of the real part and the imaginary part of the spherical harmonic coefficient as the model parameter, or each of the amplitude component and the phase component obtained from the model parameter may be individually (independently) modeled by any method such as a mixing method. In addition, the spherical harmonic coefficient may be modeled by a complex mixing method, that is, one or more complex Bingham distributions or the like.

(Combination hybrid method)

In the combination hybrid method, model data is generated using a combination of at least two or more of the band hybrid method, the addition hybrid method, the multiplication hybrid method, or the spherical harmonic coefficient modeling method described above.

In addition, for example, information indicating a combination of one or more methods used for generating the model data, such as the HOA method and the mixing method, may be stored in the model data. In such a case, a combination of one or more methods used for generating model data can be appropriately selected and switched on the server 11 side.

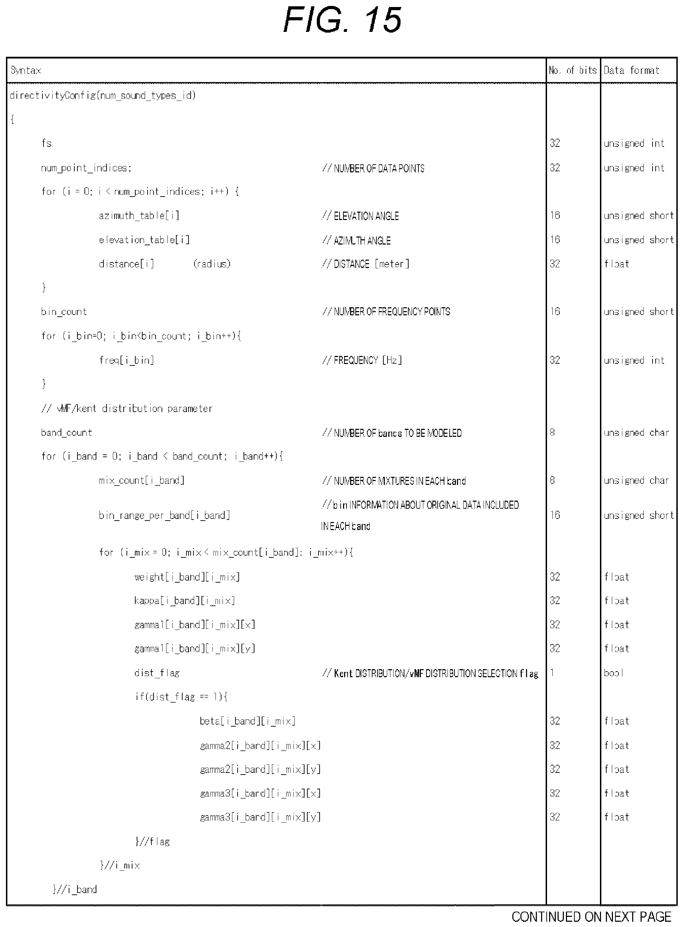

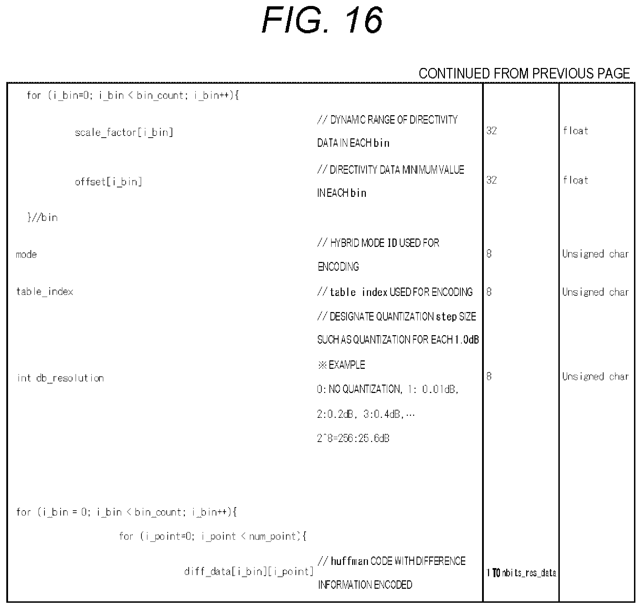

In a case where the directivity data is modeled as described above, the model data has a configuration illustrated in Figs. 15 and 16, for example. Note that Fig. 16 illustrates a portion following the portion illustrated in Fig. 15. Furthermore, in Figs. 15 and 16, description of portions corresponding to those in the case illustrated in Fig. 5 will be appropriately omitted.

The example illustrated in Figs. 15 and 16 is an example in which the directivity information (directivity data) of one type of sound source designated by num_sound_types_id is described as directivityConfig. Specifically, here, the vMF distribution, the Kent distribution, and Syntax in a case where difference data (difference information) exists are illustrated as examples of implementing the hybrid method, and the bit depth of each piece of information is merely an example.

The model data illustrated in Figs. 15 and 16 basically includes the same data as the model data illustrated in Fig. 5, but the examples of Figs. 15 and 16 are different from the example of Fig. 5 in the bit depth and the data configuration of some pieces of data.

Specifically, in the examples illustrated in Figs. 15 and 16, the azimuth angle "azimuth_table[i]" and the elevation angle "elevation_table[i]" are 16-bit unsigned shorts.

In addition, the number of bands "band_count" and the number of mixtures "mix_count[i_band]" are 8-bit unsigned char, and the selection flag "dist_flag" is set as 1-bit bool.

Further, in this example, the model data includes the ID of the hybrid mode (difference encoding mode (difference encoding method)) used for encoding the difference information, that is, "mode" indicating the difference encoding mode information. The model data also includes an index "table_index" indicating a Huffman encoding table used for encoding the difference information.

The model data further includes "int db_resolution" indicating a quantization step size such as quantization every 1.0 dB. For example, for "int db_resolution", the value "0" indicates no quantization, the value "1" indicates 0.01 dB, the value "2" indicates 0.2 dB, the value "3" indicates 0.4 dB, and the value "256" indicates 25.6 dB.

In addition, the model data also stores a Huffman encode (Huffman encode) obtained by Huffman encoding the difference information for each data point for each bin, that is, "diff_data[i_bin][i_point]" which is difference code data.

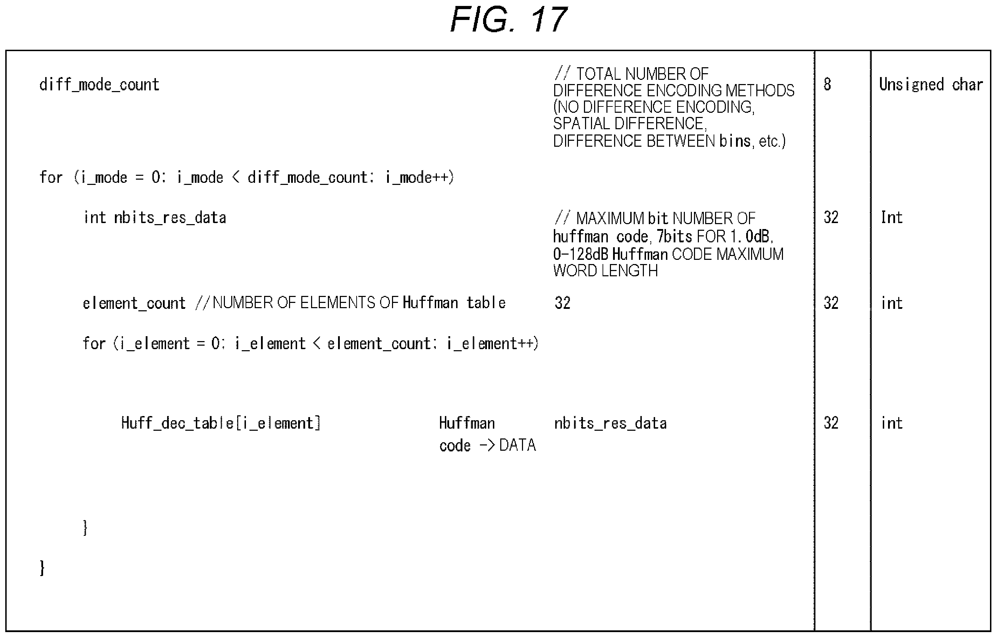

Furthermore, the information stored in the model data or about the configuration illustrated in Fig. 17 separately from the model data is transmitted from the server 11 to the information processing device 51. The information illustrated in Fig. 17 includes a Huffman encoding table or a reverse table.

In the example illustrated in Fig. 17, "diff_mode_count" is information indicating the total number of difference encoding methods, and "int_nbits_res_data" is stored by the total number "diff_mode_count".

This "int_nbits_res_data" is information indicating the maximum bit depth of the Huffman code, that is, the maximum word length of the Huffman code, and is, for example, 7 bits in the case of 1.0 dB increments, and can express a range from 0 dB to 128 dB.

"element_count" is information indicating the number of elements of the Huffman encoding table or the reverse table, and "Huff_dec_table[i_element]", which is an element corresponding to the number of elements, is stored. Specifically, in this example, "Huff_dec_table[i_element]" is an element of the reverse table.

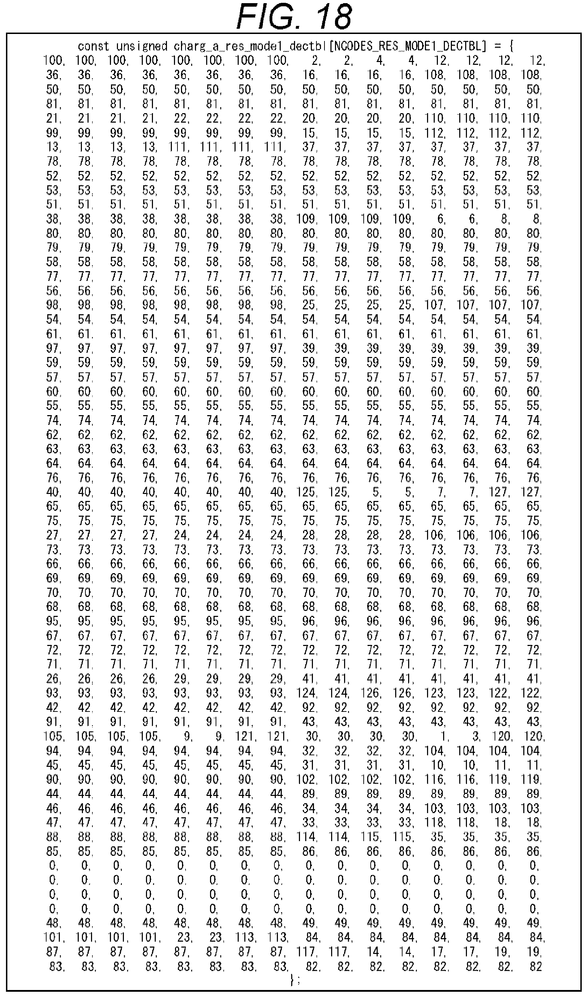

Furthermore, the Huffman encoding table is as illustrated in Fig. 18, for example. That is, Fig. 18 illustrates a specific example of the Huffman encoding table.

For example, as a specific example, in a case where int db_resolution = 1 dB is set in Fig. 16, encoding is performed as follows.

```
0:0dB
10:+1dB
11:+2dB
```

element_count=4;
int_nbits_res_data=2;// Maximum word length of the huffman decode table (reverse table for obtaining data from index)

```
Huff_dec_table[4]={0,0,1,2};
```

Huff_dec_table is a reverse table in a case where the maximum word length is 2 bits.

```
0:0dB
1:0dB
2:1dB
3:2dB
```

Furthermore, at the time of decoding, the process is performed in the following procedure.

(1) Acquire bit string from bitstream with maximum word length
(2) Refer to huff_dec_table by setting the bit string to i_element (equivalent to recording the huffman code with the maximum word length)
(3) Obtain data in which element of i_element is restored
(4) Restore the above data based on db_resolution to obtain dB value

Note that an offset value is required for restoration.

In addition, the sound pressure (dB value) of the original data can be obtained by Db = Huff_dec_table[code] * db_resolution.

<Configuration example of server>

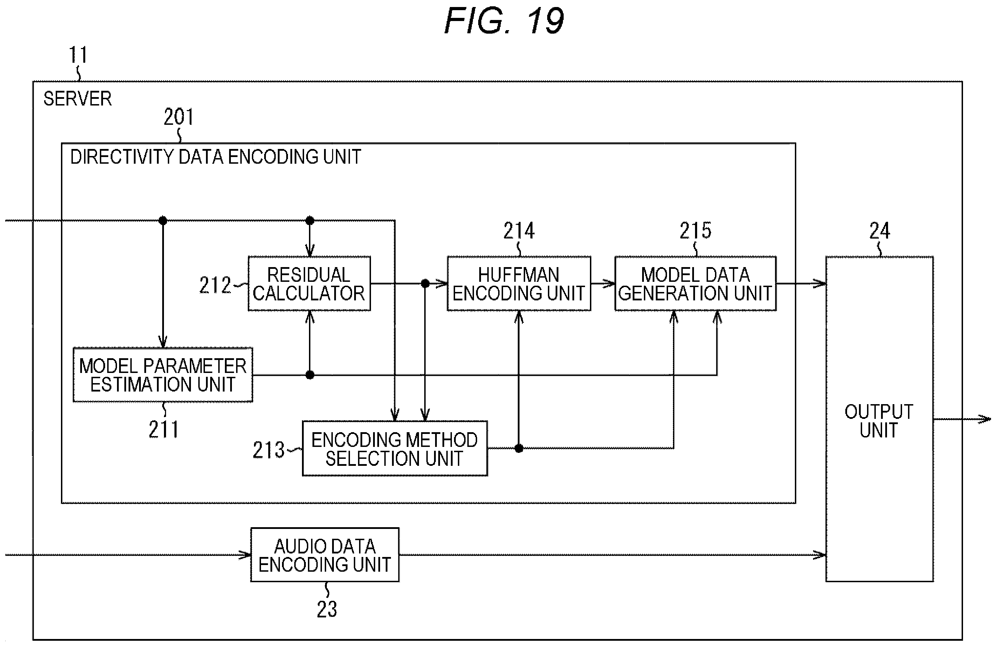

In a case where the server 11 generates model data by combining one or more methods or encodes difference information in the difference encoding mode, for example, the server 11 is configured as illustrated in Fig. 19.

Note that, in Fig. 19, portions corresponding to those in the case of Fig. 9 are denoted by the same reference numerals, and the description thereof will be omitted as appropriate.

A server 11 illustrated in Fig. 19 is an information processing device including a computer and the like, and functions as an encoding device as in the case in Fig. 9.

The server 11 includes a directivity data encoding unit 201, the audio data encoding unit 23, and the output unit 24.

The directivity data encoding unit 201 generates model data on the basis of the supplied directivity data. The directivity data encoding unit 201 includes a model parameter estimation unit 211, a residual calculator 212, an encoding method selection unit 213, a Huffman encoding unit 214, and a model data generation unit 215.

Specifically, in this example, the model parameter estimation unit 211 and the residual calculator 212 correspond to the modeling unit 21 in Fig. 9, and the encoding method selection unit 213 to the model data generation unit 215 correspond to the model data generation unit 22 in Fig. 9.

The model parameter estimation unit 211 models the supplied directivity data to be processed by at least one or more methods such as the HOA method or the mixing method, and supplies the model parameter for each method obtained as a result to the residual calculator 212 and the model data generation unit 215.

The residual calculator 212 calculates difference information on the basis of the supplied directivity data to be processed and the model parameter supplied from the model parameter estimation unit 211, and supplies the difference information to the encoding method selection unit 213 and the Huffman encoding unit 214.

On the basis of the supplied directivity data to be processed and the difference information supplied from the residual calculator 212, the encoding method selection unit 213 selects a difference encoding mode and a Huffman encoding table when Huffman encoding the difference information, and supplies encoding mode information indicating the selection result to the Huffman encoding unit 214 and the model data generation unit 215.

The encoding mode information includes difference encoding mode information indicating the selected difference encoding mode (difference encoding method) and table index information indicating the selected Huffman encoding table. Note that only the difference information may be used in generating the encoding mode information in the encoding method selection unit 213.

The Huffman encoding unit 214 Huffman encodes the difference information supplied from the residual calculator 212 on the basis of the encoding mode information supplied from the encoding method selection unit 213, and supplies difference code data obtained as a result to the model data generation unit 215.

The model data generation unit 215 generates model data including the model parameter for each method supplied from the model parameter estimation unit 211, the difference code data supplied from the Huffman encoding unit 214, and the encoding mode information supplied from the encoding method selection unit 213, and supplies the model data to the output unit 24. Note that, in the case where the difference information is not decoded, the difference code data is not included in the model data. In addition, more specifically, the model data also stores information regarding the above-described directivity data. In addition, information indicating a method used for modeling the directivity data may be stored in the model data.

Even in a case where the server 11 has the configuration illustrated in Fig. 19, the server 11 performs the encoding process described with reference to Fig. 10. However, in steps S11 and S12, more specifically, processing described below is performed.

That is, in step S11, the model parameter estimation unit 211 models the supplied directivity data to be processed by at least one or more methods, and the residual calculator 212 calculates difference information as necessary.

In other words, for example, the HOA method, the mixing method, the complex mixing method, the difference method, and the like are combined as necessary, whereby the model parameter and the difference information are calculated by the band hybrid method, the addition hybrid method, the multiplication hybrid method, the spherical harmonic coefficient modeling method, the combination hybrid method, and the like described above.

In step S12, the difference encoding mode and the Huffman encoding table are selected by the encoding method selection unit 213, and the Huffman encoding is performed by the Huffman encoding unit 214 as necessary, and the model data is generated by the model data generation unit 215.

Specifically, for example, in a case where the model parameter is calculated by the method of the addition hybrid method (AH4), the model parameter estimation unit 211 first models the directivity data by the HOA method, and as a result, obtains the spherical harmonic coefficient as the model parameter.

In addition, the model parameter estimation unit 211 obtains a difference between the directivity data after modeling by the HOA method and the directivity data before modeling as intermediate difference information, and models the intermediate difference information by the mixing method. By modeling the intermediate difference information by the mixing method, the degree of parameter concentration $\kappa$, the ellipticity $\beta$, the weight $\varphi_i$, the vector $\gamma_1$, the major axis vector $\gamma_2$, the minor axis vector $\gamma_3$ the scale factor, and the minimum value are obtained as model parameters.

The model parameter estimation unit 211 supplies the model parameter obtained by modeling the directivity data by the HOA method and the model parameter obtained by modeling the intermediate difference information by the mixing method to the residual calculator 212 and the model data generation unit 215.

Then, the residual calculator 212 generates difference information on the basis of the model parameter supplied from the model parameter estimation unit 211 and the supplied directivity data. This difference information is a residual between the directivity data after modeling modeled by the combination of the HOA method and the mixing method and the directivity data before modeling.

Further, the Huffman encoding unit 214 Huffman encodes the difference information supplied from the residual calculator 212 according to the encoding mode information supplied from the encoding method selection unit 213.

At this point, the process is performed by the method indicated by the difference encoding mode information. That is, the difference information is Huffman encoded by one or more methods of the spatial adjacency difference method, the inter-frequency difference method, and the complex difference method, or the difference information is not Huffman encoded.

For example, in a case of performing Huffman encoding by the spatial adjacency difference method, the Huffman encoding unit 214 obtains a difference in difference information between data points adjacent to each other as spatial difference information, and generates difference code data by Huffman encoding the spatial difference information.

The model data generation unit 215 generates model data including the HOA method model parameter and the mixing method model parameter supplied from the model parameter estimation unit 211, and the encoding mode information supplied from the encoding method selection unit 213. Specifically, in a case where the Huffman encoding of the difference information is performed, the model data generation unit 215 also stores the difference code data supplied from the Huffman encoding unit 214 in the model data.

Note that, in a case where the model data is generated by the difference method alone, the model parameter estimation unit 211 obtains the difference (hereinafter, also referred to as difference directivity data) of the directivity data by at least one or more methods of the spatial adjacency difference method or the inter-frequency difference method on the basis of the supplied directivity data. The difference directivity data is directivity data between data points and bins, that is, a difference in directivity gain.

In this case, the encoding method selection unit 213 generates the encoding mode information on the basis of the difference directivity data supplied from the model parameter estimation unit 211 via the residual calculator 212. In addition, on the basis of the encoding mode information supplied from the encoding method selection unit 213, the Huffman encoding unit 214 Huffman encodes the difference directivity data supplied from the model parameter estimation unit 211 via the residual calculator 212 by a designated difference encoding method to generate encoded directivity data.

Then, the model data generation unit 215 generates model data including the encoded directivity data supplied from the Huffman encoding unit 214 and the encoding mode information supplied from the encoding method selection unit 213, and supplies the model data to the output unit 24.

<Description of directivity data generation process>

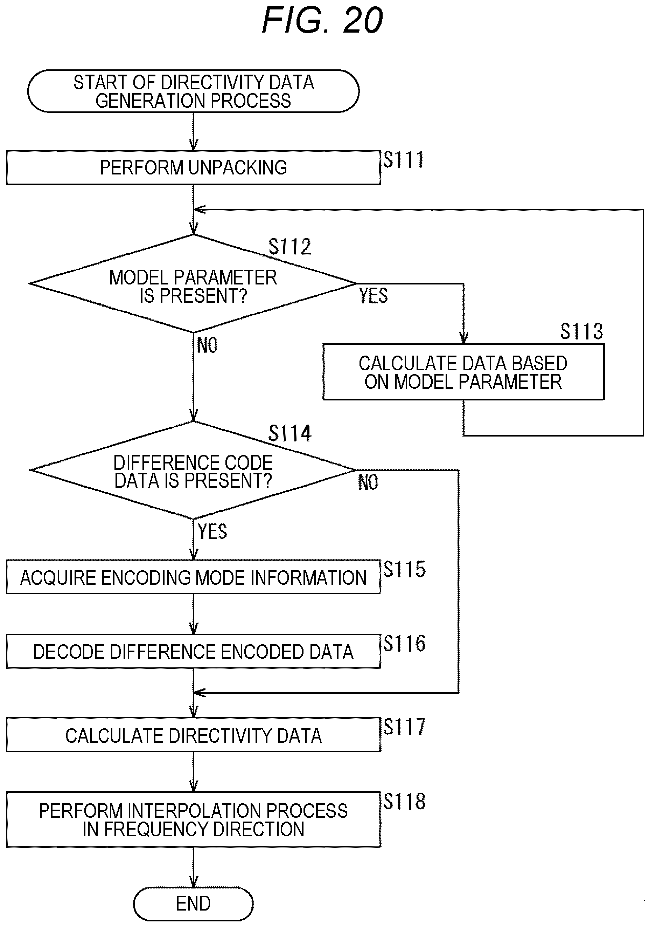

The information processing device 51 that has received the supply of the encoded bit stream from the server 11 having the configuration illustrated in Fig. 19 performs, for example, the directivity data generation process illustrated in Fig. 20, and then performs the output audio data generation process described with reference to Fig. 13 at any timing.

The directivity data generation process performed by the information processing device 51 functioning as the decoding device will be described below with reference to the flowchart of Fig. 20.

Note that, in step S111, the process similar to the process in step S51 in Fig. 12 is performed. That is, in step S111, the unpacking unit 81 unpacks the model data, and extracts the model parameter, the information regarding the original directivity data before modeling, the difference code data, and the like from the model data.

In step S112, the unpacking unit 81 determines whether or not there is a model parameter that has not yet been supplied to the directivity data calculator 82 among the model parameters for each method extracted by the unpacking.

In a case where it is determined in step S112 that there is a model parameter, the unpacking unit 81 supplies a model parameter that has not yet been supplied to the directivity data calculator 82, that is, has not yet been processed, to the directivity data calculator 82, and the process proceeds to step S113.

In step S113, the directivity data calculator 82 calculates data on the basis of the model parameter on the basis of the model parameter of one method supplied from the unpacking unit 81.

For example, in step S113, on the basis of the model parameter for each manner, such as the HOA method, the mixing method, or the like, a directivity gain, intermediate difference information, amplitude modulation information, amplitude phase modulation information, and the like constituting the modeled directivity data are calculated as data based on the model parameter for each method such as the HOA method, the mixing method, and the like.

When the process in step S113 is executed, thereafter, the process returns to step S112, and the above process is repeated.

In addition, in a case where it is determined in step S112 that there is no model parameter that is not supplied to the directivity data calculator 82, thereafter, the process proceeds to step S114.

In step S114, the unpacking unit 81 determines whether or not the difference code data is included in the model data supplied from the acquisition unit 61, that is, whether or not the difference code data is present.

In a case where it is determined in step S114 that the difference code data is included, the unpacking unit 81 supplies the encoding mode information and the difference code data extracted from the model data to the difference information decoding unit 83, and thereafter, the process proceeds to step S115.

In step S115, the difference information decoding unit 83 acquires the encoding mode information and the difference code data output from the unpacking unit 81.

In step S116, the difference information decoding unit 83 decodes the difference code data on the basis of the acquired encoding mode information, and supplies difference information (directivity data residual) obtained as a result to the addition unit 84.

For example, it is assumed that it is identified by the difference encoding mode information included in the encoding mode information that the encoding by the spatial adjacency difference method is performed.

In such a case, the difference information decoding unit 83 decodes the difference code data supplied from the unpacking unit 81 using the reverse table identified by the table index information included in the encoding mode information to obtain the spatial difference information at each data point.

Then, the difference information decoding unit 83 adds difference information at another decoded data point near the data point to the spatial difference information at the data point to be processed to obtain difference information about the data point to be processed.

In a case where it is determined that the process in step S116 is performed or that there is no difference code data in step S114, the process in step S117 is then performed.

In step S117, the directivity data calculator 82 and the addition unit 84 calculate the directivity data.

That is, the directivity data calculator 82 calculates rough directivity data on the basis of the data obtained by the process in step S113 performed one or more times, and supplies the rough directivity data to the addition unit 84.

As a specific example, for example, it is assumed that the model parameter is calculated by the addition hybrid method (AH4) on the server 11 side.

In such a case, in the first process of step S113, the modeled directivity data (rough directivity data) is calculated on the basis of the model parameter of the HOA method. In addition, in the second process in step S113, the intermediate difference information after modeling is calculated on the basis of the model parameter of the mixing method.

Therefore, the directivity data calculator 82 obtains the final rough directivity data by adding the intermediate difference information to the rough directivity data, that is, by adding the intermediate difference information for each bin at each data point to the directivity gain for each bin at each data point.

The addition unit 84 calculates the directivity data by adding the difference information (directivity data residual) supplied from the difference information decoding unit 83 to the final rough directivity data obtained by the directivity data calculator 82 in this manner, and supplies the directivity data to the frequency interpolation processing unit 85. Note that, in a case where there is no difference information, the final rough directivity data is directly used as the directivity data.

In addition, for example, it is assumed that the model parameter is calculated by the multiplication hybrid method (MH1) on the server 11 side.

In such a case, in the first process of step S113, the modeled directivity data (rough directivity data) is calculated on the basis of the model parameter of the HOA method. In addition, in the second process in step S113, the amplitude modulation information after modeling is calculated on the basis of the model parameter of the mixing method.

Therefore, the directivity data calculator 82 obtains the final directivity data by multiplying the rough directivity data by the amplitude modulation information, that is, by multiplying the directivity gain for each bin at each data point by the amplitude modulation information for each bin at each data point. In this case, since the process of steps S115 and S116 is not performed and there is no difference information, the directivity data obtained by the directivity data calculator 82 is directly supplied to the frequency interpolation processing unit 85 via the addition unit 84.

Note that, for example, the model data may be generated by the difference method alone on the server 11 side. In such a case, the process in step S113 is not performed, and the difference information decoding unit 83 decodes the encoded directivity data in steps S115 and S116.

That is, the difference information decoding unit 83 decodes the encoded directivity data supplied from the unpacking unit 81 using the reverse table identified by the table index information included in the encoding mode information to obtain the difference directivity data.

Then, in step S117, the difference information decoding unit 83 calculates the directivity data on the basis of the value (difference) for each bin at each data point constituting the difference directivity data.

Specifically, for example, in a case where the difference directivity data is calculated by the spatial adjacency difference method on the server 11 side, the difference information decoding unit 83 adds a directivity gain of the same bin at another restored data point in the vicinity of the data point to a value (difference) for each bin at the data point to be processed, thereby obtaining the directivity gain for each bin at the data point to be processed.

Furthermore, for example, in a case where the difference directivity data is calculated by the inter-frequency difference method on the server 11 side, the difference information decoding unit 83 adds a directivity gain of another restored bin in the vicinity of the bin to be processed at the same data point to a value (difference) of the bin to be processed of the data point, thereby obtaining a directivity gain of the bin to be processed.

As described above, even in a case where the encoded directivity data is stored in the model data, the amount of transmission of the directivity data can be reduced.

When the process of step S117 is performed and the directivity data is calculated, then the process of step S118 is performed and the directivity data generation process is ended. Since the process of step S118 is similar to the process of step S56 of Fig. 12, the description thereof is omitted.

As described above, the information processing device 51 calculates the directivity data on the basis of the model data. In this way, the amount of transmission of directivity data can be reduced. As a result, occurrence of a transmission delay and an increase in the transmission rate can be suppressed.

<Specific example of addition hybrid method>

<Configuration example of directivity data encoding unit>

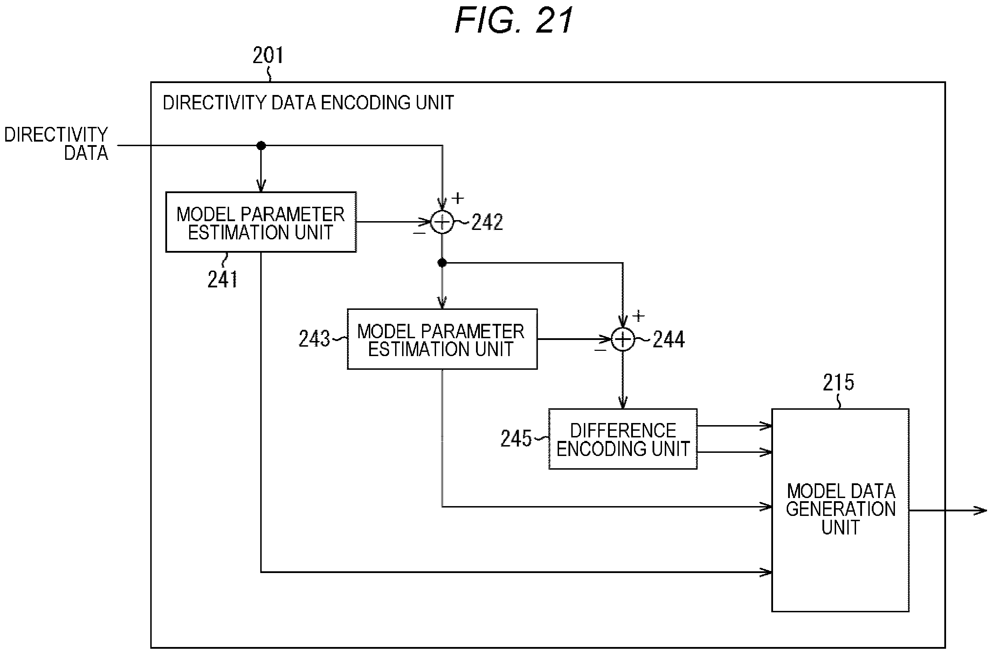

In a case where the model data is fixedly generated by the addition hybrid method in the server 11, the configuration of the directivity data encoding unit 201 in the server 11 illustrated in Fig. 19 can be, for example, the configuration illustrated in Fig. 21. Note that, in Fig. 21, portions corresponding to those in a case of Fig. 19 are denoted by the same reference numerals, and description thereof will be omitted as appropriate.

In the example of Fig. 21, the directivity data encoding unit 201 includes a model parameter estimation unit 241, an arithmetic unit 242, a model parameter estimation unit 243, an arithmetic unit 244, a difference encoding unit 245, and a model data generation unit 215.

The model parameter estimation unit 241 to the arithmetic unit 244 correspond to the model parameter estimation unit 211 in Fig. 19.

The model parameter estimation unit 241 models the supplied directivity data to be processed by the mixing method, supplies the model parameter obtained as a result to the model data generation unit 215, and supplies the directivity data after modeling by the mixing method to the arithmetic unit 242.

The arithmetic unit 242 calculates the intermediate difference information by subtracting (obtaining a difference) the modeled directivity data supplied from the model parameter estimation unit 241 from the supplied directivity data to be processed, and supplies the intermediate difference information to the model parameter estimation unit 243 and the arithmetic unit 244.

The model parameter estimation unit 243 models the intermediate difference information supplied from the arithmetic unit 242 by the HOA method, supplies the model parameter obtained as a result to the model data generation unit 215, and supplies the intermediate difference information after modeling by the HOA method to the arithmetic unit 244.

The arithmetic unit 244 calculates difference information by subtracting (obtaining a difference) the intermediate difference information after modeling supplied from the model parameter estimation unit 243 from the intermediate difference information supplied from the arithmetic unit 242, and supplies the difference information to the difference encoding unit 245.

The difference encoding unit 245 generates encoding mode information and difference code data on the basis of the difference information supplied from the arithmetic unit 244 and the supplied directivity data to be processed as appropriate, and supplies the encoding mode information and the difference code data to the model data generation unit 215.

Note that, here, an example is described in which the model parameter estimation unit 241 performs modeling by the mixing method, and the model parameter estimation unit 243 performs modeling by the HOA method.

However, the present invention is not limited thereto, and modeling may be performed by any method in the model parameter estimation unit 241 and the model parameter estimation unit 243. For example, the model parameter estimation unit 241 may perform modeling by the HOA method, and the model parameter estimation unit 243 may perform modeling by the mixing method.

<Configuration example of difference encoding unit>

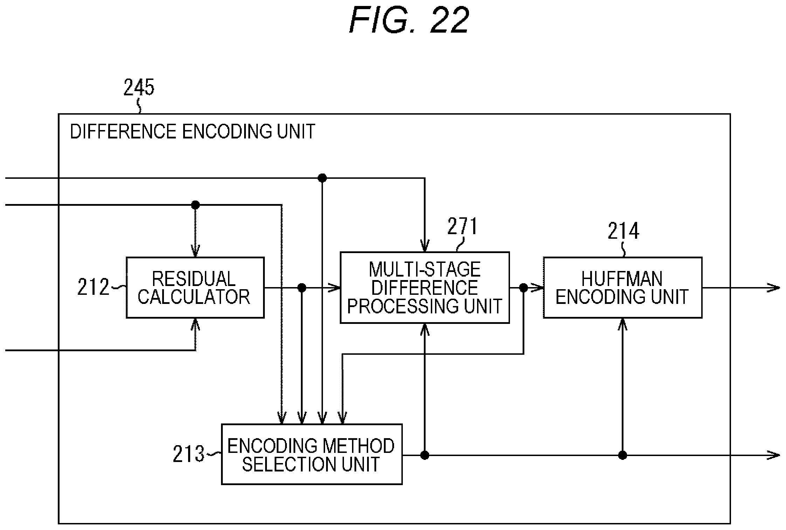

Furthermore, the difference encoding unit 245 can have a configuration illustrated in Fig. 22, for example. Note that, in Fig. 22, portions corresponding to those in a case of Fig. 19 are denoted by the same reference numerals, and description thereof will be omitted as appropriate.

In the example of Fig. 22, difference encoding unit 245 includes a residual calculator 212, an encoding method selection unit 213, a multi-stage difference processing unit 271, and a Huffman encoding unit 214.

The residual calculator 212 calculates difference information on the basis of the supplied directivity data to be processed and the modeled directivity data and intermediate difference information supplied from the model parameter estimation unit 241 and the model parameter estimation unit 243, and supplies the difference information to the encoding method selection unit 213 and the multi-stage difference processing unit 271.

The multi-stage difference processing unit 271 generates the multi-stage difference information in the difference encoding mode indicated by the encoding mode information supplied from the encoding method selection unit 213 on the basis of either the difference information from the residual calculator 212 or the difference information from the arithmetic unit 244.

For example, the spatial difference information is obtained as the multi-stage difference information in a case where the Huffman encoding is performed by the spatial adjacency difference method as the difference encoding mode, and the inter-frequency difference information is obtained as the multi-stage difference information in a case where the Huffman encoding is performed by the inter-frequency difference method as the difference encoding mode. Similarly, in a case where the Huffman encoding is performed by the spatial adjacency difference method and the inter-frequency difference method as the difference encoding mode, information to be Huffman encoded obtained by obtaining the spatial difference information and the inter-frequency difference information is the multi-stage difference information.

The multi-stage difference processing unit 271 supplies the obtained multi-stage difference information to the encoding method selection unit 213 and the Huffman encoding unit 214.

The encoding method selection unit 213 generates the encoding mode information on the basis of the supplied directivity data to be processed, the difference information supplied from the residual calculator 212 or the arithmetic unit 244, and the multi-stage difference information supplied from the multi-stage difference processing unit 271, and supplies the encoding mode information to the multi-stage difference processing unit 271, the Huffman encoding unit 214, and the model data generation unit 215.

The Huffman encoding unit 214 Huffman encodes the multi-stage difference information supplied from the multi-stage difference processing unit 271 on the basis of the encoding mode information supplied from the encoding method selection unit 213, and supplies difference code data obtained as a result to the model data generation unit 215.

<Description of model data generation process>

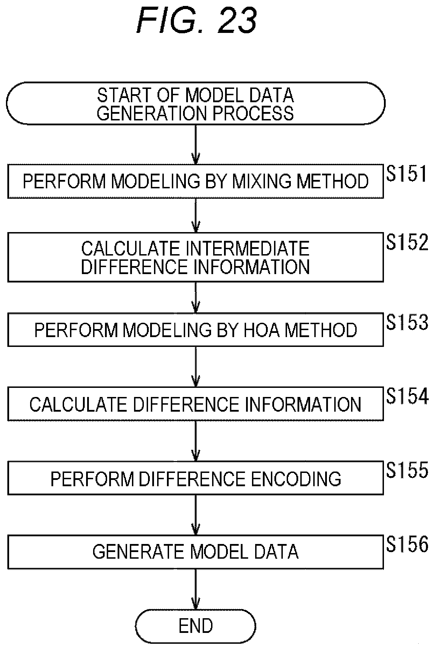

In a case where the directivity data encoding unit 201 has the configuration illustrated in Fig. 21, the directivity data encoding unit 201 performs the model data generation process illustrated in Fig. 23 as processing corresponding to steps S11 and S12 in Fig. 10.

That is, in step S151, the model parameter estimation unit 241 performs modeling by the mixing method on the supplied directivity data to be processed.

The model parameter estimation unit 241 supplies model parameter obtained by modeling to the model data generation unit 215, and supplies directivity data after modeling by the mixing method to the arithmetic unit 242.

In step S152, the arithmetic unit 242 calculates intermediate difference information on the basis of the supplied directivity data to be processed and the modeled directivity data supplied from the model parameter estimation unit 241, and supplies the intermediate difference information to the model parameter estimation unit 243 and the arithmetic unit 244.

In step S153, the model parameter estimation unit 243 performs modeling by the HOA method on the intermediate difference information supplied from the arithmetic unit 242.

The model parameter estimation unit 243 supplies model parameter obtained by modeling to the model data generation unit 215, and supplies intermediate difference information after modeling by the HOA method to the arithmetic unit 244.

In step S154, the arithmetic unit 244 calculates difference information on the basis of the intermediate difference information supplied from the arithmetic unit 242 and the intermediate difference information after modeling supplied from the model parameter estimation unit 243, and supplies the difference information to the difference encoding unit 245.

In step S155, the difference encoding unit 245 performs difference encoding on the basis of the difference information supplied from the arithmetic unit 244.

That is, for example, the encoding method selection unit 213 of the difference encoding unit 245 generates encoding mode information on the basis of the supplied directivity data to be processed, the difference information supplied from the arithmetic unit 244, and the multi-stage difference information supplied from the multi-stage difference processing unit 271 in the previous processing such as the previous frame, and supplies the encoding mode information to the multi-stage difference processing unit 271, the Huffman encoding unit 214, and the model data generation unit 215. Note that the encoding method selection unit 213 may generate the encoding mode information using the difference information supplied from the residual calculator 212.

Furthermore, the multi-stage difference processing unit 271 generates multi-stage difference information on the basis of, for example, the difference information supplied from the arithmetic unit 244 and the encoding mode information supplied from the encoding method selection unit 213, and supplies the multi-stage difference information to the encoding method selection unit 213 and the Huffman encoding unit 214.

The Huffman encoding unit 214 Huffman encodes the multi-stage difference information supplied from the multi-stage difference processing unit 271 on the basis of the encoding mode information supplied from the encoding method selection unit 213, and supplies difference code data obtained as a result to the model data generation unit 215.

In step S156, the model data generation unit 215 performs packing to generate model data, and supplies the model data to the output unit 24.

Specifically, the model data generation unit 215 generates model data including the model parameter of the mixing method from the model parameter estimation unit 241, the model parameter of the HOA method from the model parameter estimation unit 243, the encoding mode information from the encoding method selection unit 213, and the difference code data from the Huffman encoding unit 214. When the model data is generated in this manner, the model data generation process ends.

As described above, the directivity data encoding unit 201 generates the model data by the addition hybrid method. By doing so, the amount of transmission of directivity data can be reduced, and occurrence of a transmission delay and an increase in a transmission rate can be suppressed.

<Configuration example of distribution model decoding unit>

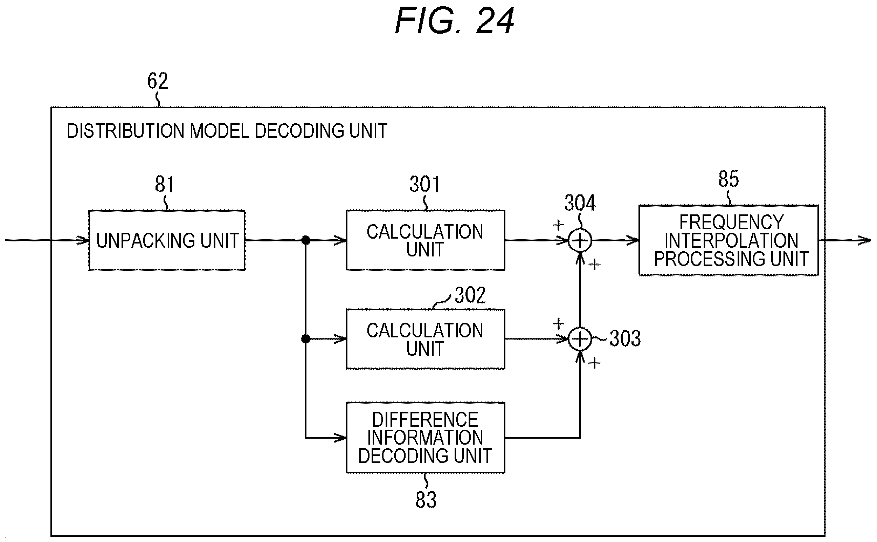

Furthermore, in a case where the directivity data encoding unit 201 has the configuration illustrated in Fig. 21, the distribution model decoding unit 62 of the information processing device 51 has the configuration illustrated in Fig. 24, for example. Note that, in Fig. 24, portions corresponding to those in a case of Fig. 11 are denoted by the same reference numerals, and description thereof will be omitted as appropriate.

The distribution model decoding unit 62 illustrated in Fig. 24 includes an unpacking unit 81, a calculation unit 301, a calculation unit 302, a difference information decoding unit 83, an arithmetic unit 303, an arithmetic unit 304, and a frequency interpolation processing unit 85. In this example, the calculation unit 301 and the calculation unit 302 correspond to the directivity data calculator 82 illustrated in Fig. 11.

The calculation unit 301 calculates directivity data (rough directivity data) after modeling by the mixing method on the basis of the model parameter of the mixing method supplied from the unpacking unit 81, and supplies the directivity data to the arithmetic unit 304. The calculation unit 302 calculates intermediate difference information after modeling by the HOA method on the basis of the model parameter of the HOA method supplied from the unpacking unit 81, and supplies the intermediate difference information to the arithmetic unit 303.

The difference information decoding unit 83 calculates difference information (directivity data residual) on the basis of the encoding mode information and the difference code data supplied from the unpacking unit 81, and supplies the difference information to the arithmetic unit 303. The arithmetic unit 303 adds (combines) the difference information supplied from the difference information decoding unit 83 and the intermediate difference information supplied from the calculation unit 302, and supplies the addition result (difference information) to the arithmetic unit 304.

The arithmetic unit 304 adds the directivity data (rough directivity data) supplied from the calculation unit 301 and the addition result (difference information) supplied from the arithmetic unit 303, and supplies directivity data obtained as a result to the frequency interpolation processing unit 85.

In a case where the distribution model decoding unit 62 has the configuration illustrated in Fig. 24, the calculation unit 301 calculates the directivity data (rough directivity data) in the first step S113 in the directivity data generation process of Fig. 20 described above. In addition, in the second step S113, the calculation unit 302 calculates the intermediate difference information.

Then, the difference information decoding unit 83 performs the process of steps S115 and S116 to generate the difference information, and the arithmetic unit 303 and the arithmetic unit 304 perform the addition process in step S117 to generate the directivity data.

<Arrangement of data points>

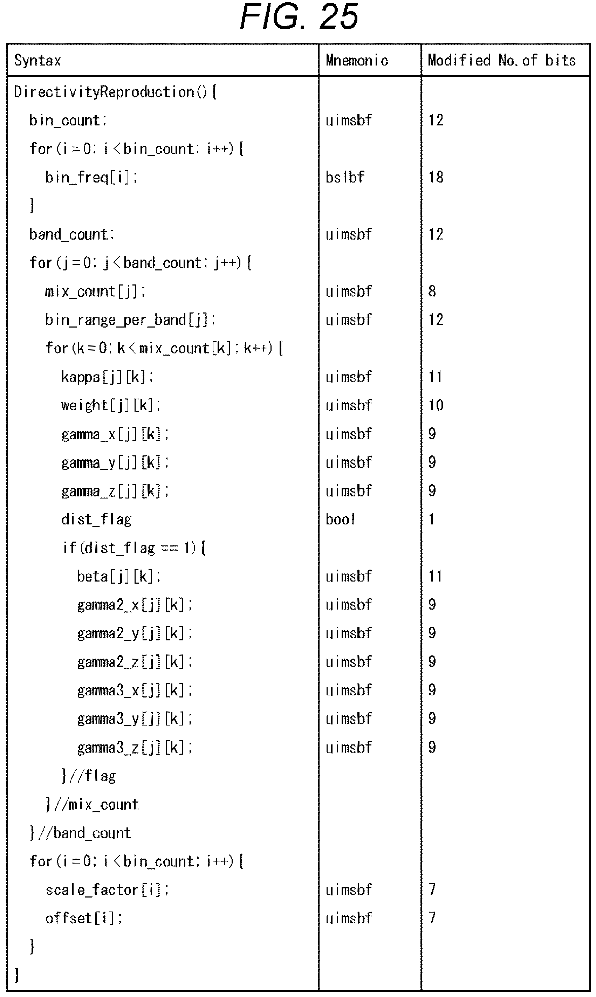

Incidentally, the configuration of the model data described above is not limited to the configuration illustrated in Fig. 5 and the configurations illustrated in Figs. 15 and 16, and may be the configuration illustrated in Fig. 25.

Note that, in Fig. 25, description of portions corresponding to those in the case illustrated in Fig. 5 will be appropriately omitted. In Fig. 25, bslbf indicates a bit string, left bit first, that is, the left bit is the head. Furthermore, uimsbf indicates unsigned integer most significant bit first, that is, an unsigned integer in which the most significant bit is the head.

The model data illustrated in Fig. 25 includes the number of frequency points "bin_count" indicating the number of frequency bins, and the frequency "bin_freq[i]" at the center of the frequency bins is stored by the number of frequency points "bin_count".

In addition, the number of mixtures "mix_count[j]" indicating the number of distributions constituting the mixture model in each band and the bin information "bin_range_per_band[j]" indicating the bin included in the band are stored by the number of bands "band_count".

Furthermore, for each band, a degree of parameter concentration $\kappa$, a weight $\varphi_i$, and a vector $\gamma_1$ as model parameters, and a selection flag "dist_flag" are stored by the number of mixtures "mix_count[k]".

In this example, "kappa[j][k]" indicates the degree of parameter concentration $\kappa$, and "weight[j][k]" indicates the weight $\varphi_i$. Furthermore, "gamma_x[j][k]", "gamma_x[j][k]", and "gamma_z[j][k]" indicate an X component (X coordinate), a Y component (Y coordinate), and a Z component (Z coordinate) constituting the vector $\gamma_1$.

In a case where the selection flag "dist_flag" is "1", that is, in a case where the distribution is the Kent distribution, the ellipticity β, the major axis vector $\gamma_2$, and the minor axis vector $\gamma_3$ are further stored.

Here, "beta[j][k]" indicates the ellipticity β, and "gamma2_x[j][k]", "gamma2_y[j][k]", and "gamma2_z[j][k]" indicate the X component, the Y component, and the Z component constituting the major axis vector $\gamma_2$. "gamma3_x[j][k]", "gamma3_y[j][k]", and "gamma3_z[j][k]" indicate the X component, the Y component, and the Z component constituting minor axis vector $\gamma_3$.

The model data also includes a scale factor "scale_factor[i]" indicating the dynamic range of the directivity gain and an offset value of the directivity data in each bin, that is, a minimum value "offset[i]" by the number of frequency points "bin _count".

In addition, the model data also includes information for identifying the position of each data point.

In the directivity recording method described above, it is assumed that the value of the directivity data at the data point defined by the original data (original directivity data), that is, the directivity gain is restored as accurately as possible.

In the information processing device 51, the decoded directivity data is used when the rendering process is performed. However, what is required in this case is not limited to the value (directivity gain) at the data point described in the original directivity data, but is the directivity gain at the position (orientation) used at the time of the rendering process.

Therefore, for example, it is necessary to record the directivity data not only in the data arrangement (hereinafter, referred to as grid pattern data arrangement) in which the data (directivity gain), that is, the data points are disposed at grid points obtained by dividing the latitude and longitude at equal intervals on the spherical surface, but also in various data arrangements. In other words, Syntax for recording coordinate information about data points as efficiently as possible is necessary.

As a method of disposing the data points in the directivity data, for example, the following method (arrangement) can be considered.

· Grid pattern data arrangement
· Uniform data arrangement
· Non-uniform data arrangement

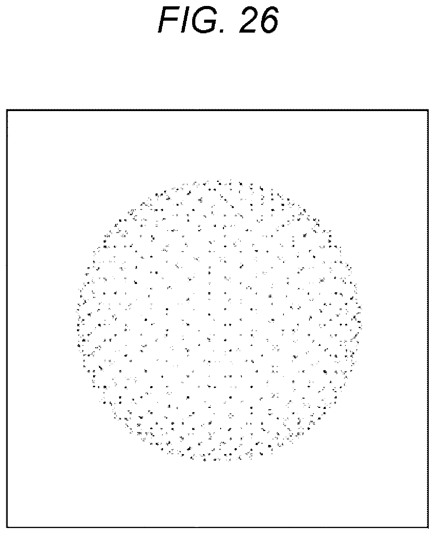

Here, the uniform data arrangement is, for example, a data arrangement in which a plurality of data points is uniformly disposed on a spherical surface centered on a sound source position as illustrated in Fig. 26. In other words, in a uniform data arrangement, the data points are disposed at a constant density in any region on the spherical surface.

In the example of Fig. 26, it can be seen that each point on the spherical surface represents a data point, and the data points are disposed at a constant density in any azimuth viewed from the sound source position, that is, a directivity gain (directivity data) is recorded at a constant density.

The recording of the directivity data by such uniform data arrangement is particularly effective in a case where the direction of the listener (user) viewed from the sound source changes evenly with time.

In addition, the non-uniform data arrangement is a data arrangement in which a plurality of data points is non-uniformly disposed on the spherical surface centered on the sound source position. In other words, in the non-uniform data arrangement, the data points are disposed at different densities for each region on the spherical surface. Therefore, it can be said that the grid pattern data arrangement is one arrangement example of the non-uniform data arrangement, but in the following description, the non-uniform data arrangement does not include the grid pattern data arrangement.

As a specific example of the non-uniform data arrangement, for example, it is conceivable to arrange the data points with high density in a region corresponding to the front direction of the sound source which is important for audibility on the spherical surface centered on the sound source position, and in a region corresponding to the direction in which the user's viewpoint and the sound source are likely to approach as a positional relationship. In the non-uniform data arrangement, it is also conceivable to arrange the data points with high density in a region where the directivity gain is large.

As another example of the non-uniform data arrangement, it is conceivable to densely arrange the data points, that is, the directivity gains in a site (region) where the amount of change in the directivity gain is large as a whole or an important region on the spherical surface centered on the sound source position, and coarsely arrange the data points in a region where the degree of importance is low.

In any of the grid pattern data arrangement, the uniform data arrangement, and the non-uniform data arrangement described above, it is conceivable to cooperate with the priority of the object in determining the priority or the like of the directivity data. For example, the priority of the directivity data may be determined on the basis of the priority of the sound source type of the object in the content in which the directivity data is utilized.

As an example of cooperation with the priority of an object, for example, in a case where there is a plurality of objects in content, in the case of content of music, it is conceivable to set the priority of an object corresponding to a vocal to be high.

Furthermore, for example, in a case where there is a sound source type with high priority, that is, an object sound source with high priority, such as a vocal in music content or a voice in movie content, it is conceivable to allocate more bits to the description of the directivity data of the sound source type. That is, in the directivity data of the sound source type with higher priority, it is conceivable to provide more data points and record the directivity data with high definition.

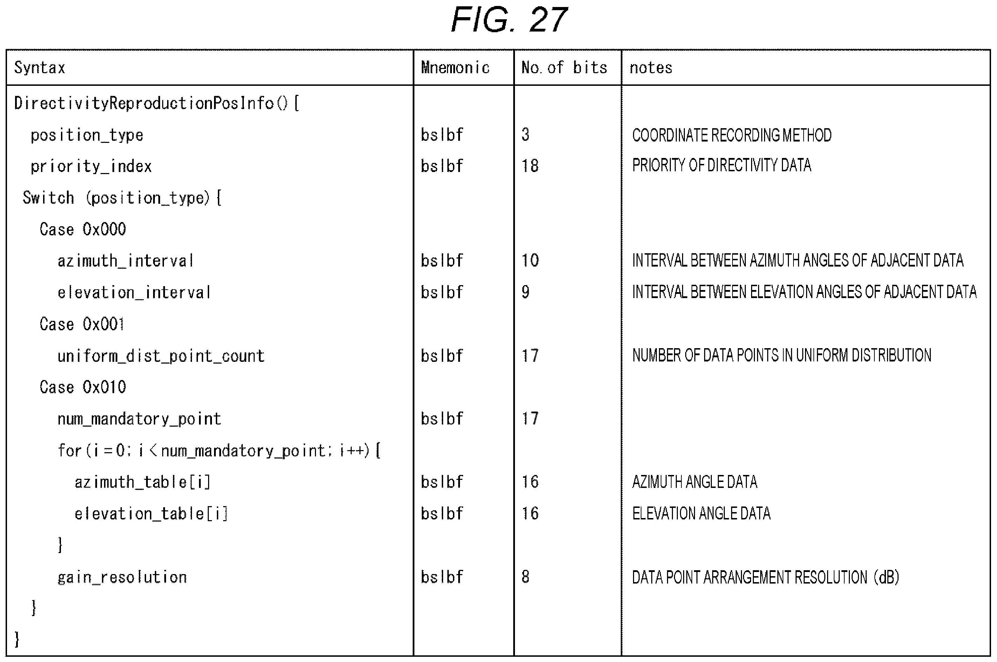

In a case where the arrangement positions and the like of the data points are recorded in the data arrangement as described above, for example, the information illustrated in Fig. 27 may be further described in the model data including the information illustrated in Fig. 25. That is, Fig. 27 illustrates an example of a description format (Syntax) of information or the like for identifying the position of each data point.

Note that, here, it is assumed that the distance from the sound source position (sound source center) to each data point is constant. That is, an example in which each data point is disposed on the surface of the sphere centered on the sound source position will be described. However, the present invention is not limited thereto, and the distance from the sound source position to the data point may be different for each data point.

In the example of Fig. 27, "position_type" is information indicating the arrangement format (arrangement method) of the data points, that is, the coordinate recording method.

For example, in a case where the arrangement of the data points is the grid pattern data arrangement, the value of the coordinate recording method "position_type" is "0x000".

Further, for example, in a case where the arrangement of the data points is uniform data arrangement, the value of the coordinate recording method "position_type" is "0x001", and in a case where the arrangement of the data points is non-uniform data arrangement, the value of the coordinate recording method "position_type" is "0x010".

"priority_index" is priority information indicating the priority of the directivity data, more specifically, the priority of the directivity data. For example, since the directivity data is prepared for each type of object, that is, for each sound source type, it can be said that the priority information indicates the priority of the directivity data for each type of sound source (object). This priority may change over time.

Specifically, for example, in a case where the value of the priority "priority_index" is "0x000", that is, in a case where the value indicating the priority is the minimum, it is indicated that the priority of the directivity data is the maximum. Here, the higher the priority of the directivity data, the smaller the value indicating the priority.

Furthermore, in a case where the priority of the directivity data is the maximum, for example, regarding the directivity data, all the data points before modeling (before encoding) may be restored (decoded) without reducing the spatial resolution in the information processing device 51 on the decoding side.

That is, the information processing device 51, more specifically, the distribution model decoding unit 62 may calculate the directivity data having the same position and the same number of data points as those before modeling on the basis of the model data. In addition, for example, the density (number) of data points constituting the directivity data may be determined according to the priority of the directivity data.

Furthermore, in this example, information for identifying the arrangement position (coordinates) of the data point is described according to the value of the coordinate recording method "position_type".

Specifically, in a case where the value of the coordinate recording method "position_type" is "0x000", that is, in the case of the grid pattern data arrangement, the azimuth angle direction interval "azimuth_interval" and the elevation angle direction interval "elevation_interval" are described (stored).

The azimuth angle direction interval "azimuth_interval" indicates an angle (difference in azimuth angle) indicating an interval in the azimuth angle direction between data points adjacent to each other in the azimuth angle direction on the spherical surface.

The elevation angle direction interval "elevation_interval" indicates an angle (difference in elevation angle) indicating the elevation angle direction interval between the data points adjacent to each other in the elevation angle direction on the spherical surface.

Furthermore, in the grid pattern data arrangement, at least one position as a reference such as a position in the front direction viewed from the sound source position is known as the arrangement position of the data points on the information processing device 51 side. Therefore, the positions of all the data points can be identified from the azimuth angle direction interval and the elevation angle direction interval, and the predetermined reference position.

In a case where the value of the coordinate recording method "position_type" is "0x001", that is, in a case of uniform data arrangement, the number of data points "uniform_dist_point_count" indicating the number of data points uniformly distributed (disposed) on the spherical surface is described (stored).

In the uniform data arrangement, for example, on the information processing device 51 side, the arrangement position of each data point is known for each number of data points, and the positions of all the data points can be identified from the number of data points.

In a case where the value of the coordinate recording method "position_type" is "0x010", that is, in the case of non-uniform data arrangement, together with the number of the mandatory data points "num_mandatory_point", the azimuth angle data "azimuth_table[i]" and the elevation angle data "elevation_table[i]" indicating the position of the mandatory data point are described (stored) by the number of the mandatory data points.

Further, in a case where the value of the coordinate recording method "position_type" is "0x010", the data point arrangement resolution, in other words, the data point arrangement resolution indicating the arrangement density of the data points "gain_resolution", is also described (stored). For example, the data point arrangement resolution "gain_resolution" is a decibel value indicating an amount of fluctuation of data (directivity gain).

In the non-uniform arrangement, the data point is set for each amount of fluctuation of the directivity gain indicated by the data point arrangement resolution "gain_resolution". That is, the number of data points in the directivity data obtained by decoding changes according to the data point arrangement resolution.

Specifically, in the non-uniform arrangement, data points that always exist (are disposed), that is, data points that are always restored at the time of decoding, regardless of the data point arrangement resolution are set as the mandatory data points. The number of mandatory data points "num_mandatory_point" indicating the number of mandatory data points is described.

Furthermore, the azimuth angle data "azimuth_table[i]" and the elevation angle data "elevation_table[i]" are an azimuth angle and an elevation angle indicating the positions (coordinates) in the azimuth angle direction and the elevation angle direction of the mandatory data points, respectively.

Therefore, on the decoding side, the arrangement position of each mandatory data point can be identified by the azimuth angle data "azimuth_table[i]" and the elevation angle data "elevation_table[i]". Note that the azimuth angle data and the elevation angle data are not limited to coordinates, that is, the azimuth angle and the elevation angle as long as it is the information for identifying the arrangement position of the mandatory data point, and may be any other information such as an index that can obtain the azimuth angle and the elevation angle.

In the non-uniform arrangement, when the arrangement position of the mandatory data point is identified, the arrangement positions of the data points other than the mandatory data point in the directivity data are identified on the basis of the arrangement position of the mandatory data point and the data point arrangement resolution "gain_resolution".

Specifically, first, on the basis of the model data, more specifically, the model parameter, a mixture model $F(x; \Theta)$ is obtained. This mixture model $F(x; \Theta)$ gives the value of the directivity gain at any position on the spherical surface surrounding the sound source position.

Next, data points (hereinafter, also referred to as non-mandatory data points) that are not a mandatory data point are disposed on the spherical surface on the basis of the mixture model $F(x; \Theta)$, the position of the mandatory data point, and the data point arrangement resolution.

The position of the non-mandatory data point is a position in which the value of the directivity gain indicated by the mixture model $F(x; \Theta)$ is changed from the value of the directivity gain at the mandatory data point on the spherical surface by the amount of fluctuation indicated by the data point arrangement resolution, for example, 3 dB.

Therefore, for example, in a case where the amount of fluctuation indicated by the data point arrangement resolution is +3 dB and the value of the directivity gain at any one mandatory data point is 48 dB, the non-mandatory data point is disposed at a position where the directivity gain is 51 dB on the spherical surface.

At this time, another non-mandatory data point may be further set at a position where the value of the directivity gain on the spherical surface is a value changed from the value of the directivity gain at the non-mandatory data point that has already been set by the amount of fluctuation indicated by the data point arrangement resolution. That is, the non-mandatory data points may be disposed at intervals corresponding to the amount of fluctuation indicated by the data point arrangement resolution with respect to the mandatory data point.

In addition, for example, the non-mandatory data points whose number corresponds to the data point arrangement resolution may be disposed at equal intervals between the mandatory data points adjacent to each other in the azimuth angle direction and the elevation angle direction.

As described above, the arrangement positions of all the data points constituting the directivity data in the non-uniform arrangement, that is, the arrangement positions of all the mandatory data points and the non-mandatory data points are identified.

As described above, in the non-uniform arrangement, the arrangement positions and the number of non-mandatory data points of the directivity data obtained on the decoding side vary depending on the data point arrangement resolution "gain_resolution".

In the above example, the spatial resolution of the directivity data, that is, the number of data points can be adjusted according to the value of the priority "priority_index" on the decoding side (the information processing device 51) even in a case where the arrangement format of the data points (coordinate recording method) is any format of the grid pattern data arrangement, the uniform data arrangement, and the non-uniform data arrangement. In this case, in each arrangement format, the number of data points changes according to the value of the priority "priority_index".

Specifically, for example, in the grid pattern data arrangement, the spatial resolution of the directivity data can be reduced by increasing the azimuth angle direction interval "azimuth_interval" and the elevation angle direction interval "elevation_interval".

In addition, in the uniform data arrangement, the spatial resolution of the directivity data can be reduced by reducing the number of data points "uniform_dist_point_count".

Similarly, in the non-uniform data arrangement, the spatial resolution of the directivity data can be reduced by increasing the data point arrangement resolution "gain_resolution".

As a method of adjusting the spatial resolution of the directivity data, that is, the data amount of the directivity data obtained by decoding, for example, a method of multiplying the value of the priority "priority_index" by the azimuth angle direction interval "azimuth_interval" or the elevation angle direction interval "elevation_interval" is considered.

Furthermore, as a method of adjusting the spatial resolution of the directivity data, for example, a method of multiplying the number of data points "uniform_dist_point_count" by the reciprocal of the value of the priority "priority_index", a method of multiplying the data point arrangement resolution "gain_resolution" by the value of the priority "priority_index", or the like can be considered.

In this way, the information processing device 51 can obtain directivity data of an appropriate spatial resolution. That is, the spatial resolution (the number of data points) of the directivity data can be appropriately adjusted.

Note that, also in the model data illustrated in Figs. 5, 15, and 16, as information for identifying the position of each data point, information (hereinafter, also referred to as data point position information) of the configuration illustrated in Fig. 27 may be stored instead of the azimuth angle, the elevation angle, and the like for each data point.

In a case where the model data includes the data point position information having the configuration illustrated in Fig. 27, the model data generation unit 22 generates the model data including information illustrated in Figs. 25 and 27 in step S12 of the encoding process described with reference to Fig. 10. That is, model data including the data point position information is generated.

Note that even in a case where the server 11 has the configuration illustrated in Fig. 19, model data including the data point position information may be generated by the model data generation unit 215.

In addition, in a case where information for each data point such as difference information is obtained at the time of generating the model data, each piece of information such as difference information is calculated for each data point of the decoded directivity data, that is, each data point identified by the data point position information.

Further, in a case where the data point position information is included in the model data, the directivity data calculator 82 generates the directivity data also using the data point position information in step S52 of the directivity data generation process described with reference to Fig. 12.

That is, on the basis of the data point position information included in the model data, the directivity data calculator 82 identifies the arrangement format (coordinate recording method) of the data points and identifies the arrangement position of each data point in the directivity data. At this time, the directivity data calculator 82 identifies the arrangement position of the data points using the priority information about the directivity data as necessary.

Further, the directivity data calculator 82 calculates the output value $F(x; \Theta)$ of the mixture model for each bin at the data point on the basis of the mixture model $F'(x; \Theta)$ of each band calculated from model parameter and the like, the result of identifying the arrangement position of each data point, the scale factor for each bin, and the minimum value for each bin. As a result, rough directivity data including a directivity gain for each bin at each data point is obtained.

Similarly, in a case where the data point position information is included in the model data, also in the directivity data generation process described with reference to Fig. 20, the result of identifying the arrangement position of the data points is appropriately used in steps S113, S116, and S117.

In the above description, the spatial adjacency difference method and the inter-frequency difference method have been described as the difference encoding method.

For example, in the inter-frequency difference method, difference information and a difference in directivity gain between adjacent bins, that is, between adjacent frequencies are obtained.

In such an inter-frequency difference method, a property that the value of the directivity gain is close between adjacent frequencies (bins), that is, the shape of the directivity data is close in the directivity data is used.

Similarly, in the spatial adjacency difference method, difference information and a difference in directivity gain between adjacent data points, that is, between adjacent positions are obtained.

In such a spatial adjacency difference method, a property that a difference in directivity gain is small between spatially close positions in the directivity data is used. That is, a property that the directivity gain on the spherical surface changes continuously in many cases in the directivity data, and the value of the directivity gain is close when the position (orientation) is close is used.

In general, in a case where directivity or a head-related transfer function (HRTF) is recorded, for example, in a file in a Spatially Oriented Format for Acoustics (SOFA), data is defined on a spherical surface, and data points are often recorded in the following manner.

```
for elev in elevation
         for azi in azimuth
          data_point(azi, elev)
         end
     end
```

Specifically, for example, on the same latitude on the spherical surface, that is, on the circumference corresponding to the latitude, the data points are disposed at longitude positions adjacent to each other along the circumference. At this time, the data points are disposed at equal intervals, for example, so as to go around the circumference.

Then, when the data point is provided for the latitude to be processed, then, the data point is provided on the spherical surface by disposing the data point at each longitude position on the circumference corresponding to the latitude while sequentially changing the value of the latitude.

In this way, directivity data of a method such as the grid pattern data arrangement can be obtained. In such a grid pattern data arrangement, the data density around the poles such as the south pole and the north pole, that is, the density of data points increases.

However, when actually recording the directivity data (directivity gain) as described above, it is desirable to record the directivity data in a data distribution in which the data (data points) is dense in an important azimuth in which it is necessary to record a change in the directivity gain with high definition or is uniform (uniform distribution) as a whole. The important azimuth mentioned here is, for example, a front direction or the like, a direction often used at the time of rendering, a direction of a position where the value of the directivity gain is large, or the like.

Furthermore, in a case where recording of the directivity data is actually considered, it is conceivable that the data on the horizontal plane is recorded densely and is recorded sparsely around the pole due to the convenience of recording.

Therefore, difference encoding may be performed by performing sorting (rearrangement) as follows.

(Method DE1): Difference encoding in order of sorting data points on the basis of a predetermined criterion
(Method DE2): Difference encoding by sorting the decibel values of the directivity gains in ascending or descending order
(Method DE3): Difference encoding by sorting in descending order of priority

In the method DE1, the data points, that is, the difference information and the directivity gain at the data points are sorted (redisposed) in a predetermined order with respect to the data arrangement such as the grid pattern data arrangement, the uniform data arrangement, and the non-uniform data arrangement. Then, the difference information and the difference in directivity gain are obtained between the data points adjacent to each other after the sorting. In this case, the order of sorting is known on the decoding side, that is, on the information processing device 51 side.

In the method DE2, the data points are sorted in ascending or descending order of values (decibel values (dB values)) to be calculated of differences such as difference information and directivity gains at the data points. At this time, whether sorting is performed in ascending order or descending order is only required to be determined in advance.

In addition, when sorting is performed in ascending order or descending order, difference information and a difference in directivity gain are obtained between data points adjacent to each other after sorting. In this way, the difference information and the difference in directivity gain between the data points can be further reduced.

Note that, in the method DE2, information indicating the arrangement order of the sorted data points is stored in the model data so that the order of sorting can be identified on the decoding side (information processing device 51 side). For example, information indicating the arrangement order of the sorted data points may be stored in the data point position information illustrated in Fig. 27.

Furthermore, the information indicating the arrangement order of the sorted data points may be any information such as, for example, information obtained by disposing indexes indicating the data points in the sorting order.

In the method DE3, among the respective azimuths (directions) viewed from the sound source position, the data points are sorted in order from the data point in the azimuth with high priority such as the front azimuth and the azimuth with a large directivity gain, and the difference information and the difference in directivity gain are obtained between the data points adjacent to each other after the sorting. As a result, the data amount of the difference information or the like difference encoded can be kept within the predetermined bit depth.

Also in the method DE3, as in the case of the method DE2, information indicating the arrangement order of the sorted data points is stored in the model data.

In the methods DE1 to DE3, the example of obtaining the difference between the data points is described, but the difference is only required to be calculated for at least any one of between the data points or between the bins.

Therefore, for example, in each of the methods DE1 to DE3, the rearrangement may be performed in consideration of not only the position of the data point but also the frequency, that is, the bin.

In such a case, for example, in the method DE1, the difference information and the directivity gains are sorted in order of predetermined data points and frequencies (bins), and the difference information and the difference in directivity gain adjacent to each other after sorting, that is, the difference between the data points and the bins are obtained. Note that, after sorting is performed in a predetermined order, a difference may be obtained between both data points and bins, or a difference may be obtained only between bins.

In addition, for example, in the method DE2, regarding the difference information and the directivity gains sorted in ascending or descending order for the same bin, the same data point, and the like, the difference information and the difference in directivity gain adjacent to each other, that is, the difference between the data points and the bins can be obtained.

Similarly, in the method DE3, the difference information and the directivity data in the bins of the data points are sorted according to the priority of the data points and the frequencies (bins), and the difference information and the difference in directivity gain adjacent to each other after sorting, that is, the difference between the data points and the bins can be obtained. In other words, in this example, the data points and bins are sorted in order of priority.

Note that, in a case where sorting is performed by any of the above methods, sorting may be performed for each group including one or more bins or data points, for example, only bins of the same frequency, only a plurality of bins belonging to a predetermined frequency band, or only bins in the same data point or a plurality of data points adjacent to each other are to be sorted.

In addition, each variable (information) in the encoded bit stream such as in the model data may be tabulated, and only an index indicating a value of the tabulated variable may be transmitted.

That is, in the example described above, for various variable values such as model parameter in the model data and the like, Syntax is described in the following manner.

· Record variable value in Syntax in floating point format

· Assign value according to dynamic range and necessary resolution in integer format such as 9 bits (value between 0 to 1 is expressed in 512 stages) and 11 bits

Here, in the floating-point format in which the variable value is recorded, any value can be taken as the variable value in the format of float (32 bits).

On the other hand, in order to actually further reduce the bit depth, Syntax may be described in the following manner.

That is, in a case where the variable value (parameter) to be described often takes a specific value or can be represented by a specific value, a value to be actually used, that is, a variable value to be described is tabulated. Then, only the index obtained by the tabulation is described in the encoded bit stream such as the model data, that is, in Syntax.

In this case, the table itself is transmitted to the decoding side separately from the encoded bit stream. In this way, the variable value can be described with a small bit depth, and the data amount (amount of transmission) of the encoded bit stream can be reduced.

As a specific example, for example, it is conceivable to table only a partial range of possible values of the variable value, such as only the range of 0.0 to 0.1 or only the range of 0.9 to 1.0 of the variable values.

In such a case, for example, for each discrete value (variable value) within a range to be tabulated, such as a range of 0.0 to 0.1, an index indicating the value is determined. Then, in a case where the actual variable value is a value within a range to be tabulated, an index corresponding to the actual variable value is stored in the model data or the like and transmitted.

On the other hand, in a case where the actual variable value is out of the range to be tabulated, the actual variable value is stored in the model data and transmitted.

Furthermore, it is also conceivable to perform parametric expression (compressed expression) on the scale factor "scale_factor[i]" and the offset value, that is, the minimum value "offset[i]" described above.

In the above description, using the scale factor "scale_factor[i]" and the minimum value "offset[i]" of each bin, the mixture model $F(x; \Theta)$ is determined in the following manner.

For i_bin in bin

$$F(x; \Theta) = F'(x; \Theta) \times \text{scale\_factor[i]} + \text{offset[i]}$$

End

where $F'(x; \Theta)$ is an output value of the mixture model for each band.

In addition, the scale factor "scale_factor[i]" is a ratio between a sum of the vMF distribution and the Kent distribution (model data sum), that is, a sum of the values (directivity gain) at each data point of the mixture model $F'(x; \Theta)$, and a sum of values at the data points of the original (original) directivity data before modeling in the bin indicated by the index i, that is, the i-th bin. This scale factor is a float value representing a dynamic range.

Note that the model data sum is a sum of values (directivity gains) defined on the spherical surface, and ideally is 1, but it does not become 1 because it is actually discretized. In addition, the original directivity data before modeling is dB-scale data, and is offset in the positive direction when the scale factor is calculated.

The minimum value "offset[i]" is the original (original) directivity data before modeling in the i-th bin, that is, the minimum value (dB value) of the directivity gain, and is expressed by a float value.

By the calculation using such a scale factor and a minimum value, the output value of the mixture model can be corrected and restored according to the dynamic range of each bin.

In this case, a scale factor and a minimum value corresponding to the number of bins are required, and when the frequency resolution of the directivity data is made high definition, the amount of information required to record the scale factor and the minimum value, that is, the bit depth, increases in proportion to the number of bins.

Therefore, the amount of information (bit depth) necessary for recording the scale factor and the minimum value may be reduced by parametrically expressing the scale factor and the minimum value.

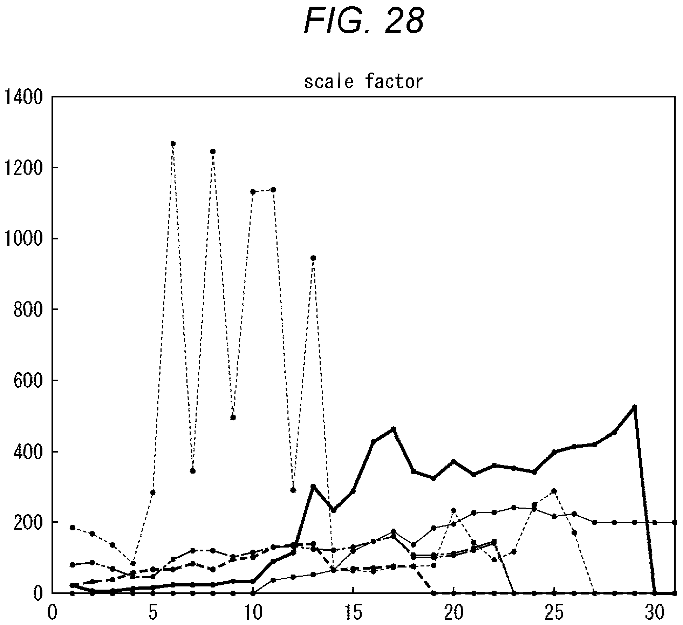

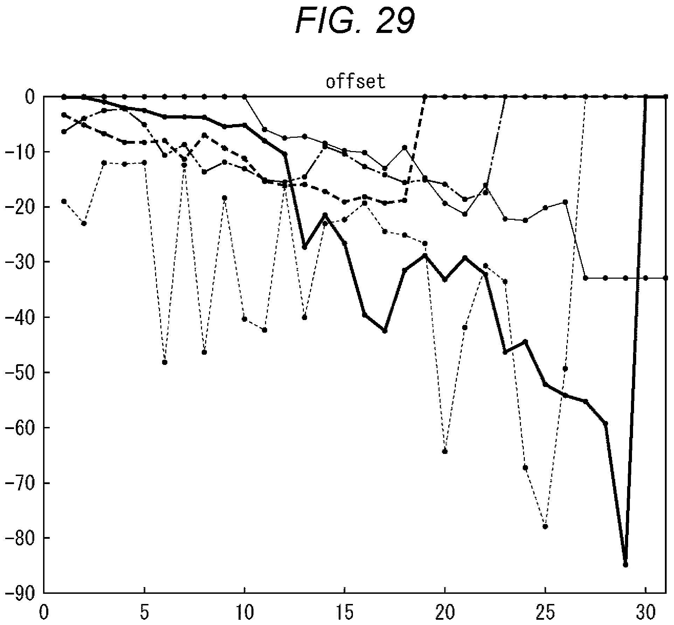

For example, as an example, the values illustrated in Figs. 28 and 29 are obtained as the scale factor and the minimum value (offset value) for the directivity data of each of the six sound source types.

Fig. 28 illustrates scale factors of the six sound source types. Note that, in Fig. 28, the vertical axis represents the value of the scale factor which is a dimensionless ratio, and the horizontal axis represents the index i of the bin.

In this example, depending on the sound source type, the scale factor varies greatly between adjacent bins, or the scale factor varies less between adjacent bins.

Fig. 29 illustrates the minimum value (offset value) of each of the six sound source types. Note that, in Fig. 29, the vertical axis represents the minimum value (offset value) that is the dB value, and the horizontal axis represents the index i of the bin.

Even in the minimum value, as in the case of the scale factor, it can be seen that the minimum value greatly fluctuates or the fluctuation is small between adjacent bins depending on the sound source type.

As described above, the magnitude of the variation of the scale factor or the minimum value greatly differs between adjacent frequencies (between adjacent bins) depending on the sound source type.

Therefore, when the scale factor and the minimum value are modeled, that is, parametrically expressed, there may be a case where modeling can be performed with a small number of parameters and a case where the number of parameters increases.

Therefore, for example, in a case where the variation between the bins is large and the coding efficiency cannot be improved by the parametric expression of the scale factor or the minimum value, the model data generation unit 22 and the model data generation unit 215 stores (describes) the scale factor or the minimum value of each bin as it is in the model data.

On the other hand, in a case where the variation between the bins is small and the coding efficiency can be improved, the model data generation unit 22 and the model data generation unit 215 parameterize the scale factor or the minimum value and store (describe) the scale factor or the minimum value in the model data.

As an example of the parameterization (parametric representation), for example, curve fitting by function approximation or the like is exemplified.

In such a case, the model data generation unit 22 and the model data generation unit 215 generate a function approximation parameter for obtaining an approximation function corresponding to a graph representing a scale factor or a minimum value of each bin by curve fitting or the like. Then, the model data generation unit 22 and the model data generation unit 215 store the function approximation parameter in the model data instead of the scale factor or the minimum value of each bin.

On the decoding side, the directivity data calculator 82 and the calculation unit 301 obtain the scale factor or the minimum value in each bin from the approximation function on the basis of the function approximation parameter and the index i of the bin, and use the scale factor or the minimum value as the model parameter.

In this way, the scale factors and the minimum values of all the bins were required to be stored in the model data, but only the function approximation parameters need to be described, and the data amount can be compressed. Note that, as the function approximation, any approximation such as approximation by a linear function, an n-th order function ($n \geq 2$), or polynomial approximation can be performed.

Furthermore, in a case where the dynamic range of the scale factor or the minimum value is large, the dynamic range may be compressed by performing, as preprocessing of function approximation, processing of taking the logarithm of the scale factor or the minimum value, processing of converting the scale factor or the minimum value by a nonlinear function, or the like.

In addition, the band hybrid method, the addition hybrid method, the multiplication hybrid method, the spherical harmonic coefficient modeling method, and the combination hybrid method have been described above as examples of the method in the case of generating the model data by combining the HOA method, the mixing method, the complex mixing method, and the difference method.

However, the present invention is not limited thereto, and it is of course possible to generate model data by other combinations.

For example, the model data may be generated by switching any method such as the HOA method, the mixing method, the complex mixing method, the difference method, the band hybrid method, or the addition hybrid method described above for each azimuth viewed from the sound source position, that is, for each data point or for each region including a plurality of data points.

In the directivity data, there is a high possibility that the frequency of use of the data of the horizontal plane, that is, the data on the equator (directivity gain) is high, and conversely, the frequency of use of the data near the pole is low. Therefore, the bit depth of the model data can be appropriately reduced by switching the method for each region. Note that the horizontal plane here is a plane including a plurality of positions at which the latitude viewed from the sound source position, that is, the elevation angle (elevation), is 0 degrees.

As a specific example, for example, it is conceivable to combine the HOA method with the mixing method, more specifically, the method of modeling by the vMF distribution. At this time, for example, the order of the spherical harmonic function expansion in the HOA method may be set to the first order, and whether the HOA method and the mixing method are used in combination or only the mixing method is used may be switched for each region (orientation).

In addition, it is also conceivable to generate model data by changing the order of spherical harmonic function expansion in the HOA method for each region. Furthermore, it is also conceivable to switch between the HOA method and a combination of the mixing method and the HOA method for each region, and to change the order of the spherical harmonic function expansion in the HOA method for each region.

In addition, it is also conceivable that data points in the vicinity of the horizontal plane are recorded with high definition by using a method of modeling directivity data by circular harmonic function expansion instead of spherical harmonic function expansion, and for data points other than those in the vicinity of the horizontal plane, the directivity gain is recorded sparsely by another method.

<Third embodiment>

<Utilization of symmetry of data>

Meanwhile, the directivity data may have symmetry depending on the shape of the original sound source.

For example, a shape of a speaker as a sound source is bilaterally symmetric, and directivity data of the speaker is also symmetric. However, in a case where a tweeter and a woofer are present in the speaker, reproduction bands of the tweeter and the woofer are different, and thus, the directivity data is not symmetric in the up-and-down direction.

In addition, a regular dodecahedron speaker and the like are also commercialized, and symmetry is established in 12 directions in the regular dodecahedron speaker. Further, in the case of a full range speaker having a cubic shape, not only the left-and-right symmetry but also the up-and-down symmetry may be established. On the other hand, a human also has an outer shape that is bilaterally symmetrical, and bilateral symmetry is established to some extent, but has a shape that is not symmetrical in the up-and-down direction with the head, the torso, and the legs, and directivity is not symmetrical in the up-and-down direction.

From these, in a case where there is symmetry in the directivity data, it is possible to reduce the amount of transmission data by utilizing the symmetry.

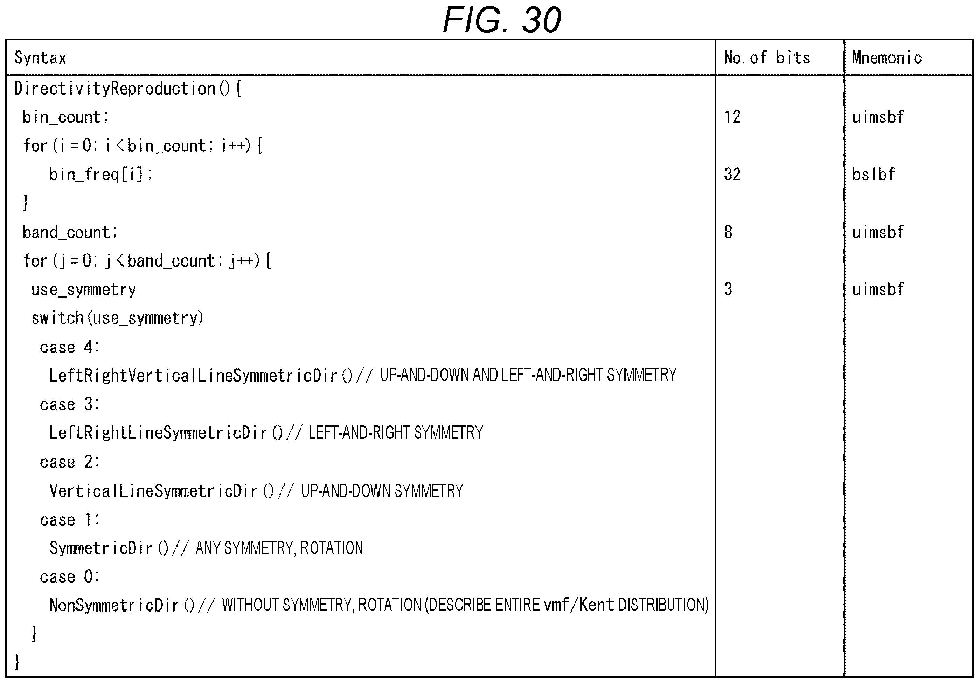

In such a case, Syntax of the model data is, for example, as illustrated in Fig. 30.

The model data illustrated in Fig. 30 includes the number of frequency points "bin_count" indicating the number of bins, and the frequency "bin_freq[i]" at the center of the bin is stored by the number of frequency points "bin_count".

In addition, the number of bands "band_count" is also stored, and the symmetry information "use_symmetry" related to the use of the symmetry of the directivity data is stored for the number of bands "band_count", that is, for each band.

For example, the values "4", "3", "2", "1", and "0" of the symmetry information "use_symmetry" indicate that an up-and-down and left-and-right symmetry operation is performed, a left-and-right symmetry operation is performed, an up-and-down symmetry operation is performed, any symmetry and rotation are utilized, and any symmetry and rotation operation is not performed, respectively.

Specifically, in a case where the value of the symmetry information "use_symmetry" is "0", the directivity data is described by a model in which directivity gains in all directions are composed of the above-described vMF distribution, Kent distribution, or the like, that is, by a mixture model or the like. Furthermore, values "5" to "7" of the symmetry information "use_symmetry" are reserved.

In the model data, operation-related information for a rotation operation or a symmetry operation is stored according to a value of the symmetry information "use_symmetry".

In a case where the value of the symmetry information "use_symmetry" is "4", the operation-related information "LeftRightVerticallineSymmetricDir()" for the up-and-down and left-and-right symmetry operation is described in the model data. In a case where the value of the symmetry information "use_symmetry" is "3", the operation-related information "LeftRightLineSymmetricDir()" for the left-and-right symmetry operation is described in the model data.

Furthermore, in a case where the value of the symmetry information "use_symmetry" is "2", the operation-related information "VerticalLineSymmetricDir()" for the up-and-down symmetry operation is described in the model data.

In a case where the value of the symmetry information "use_symmetry" is "1", the operation-related information "SymmetricDir()" for any symmetry or rotation operation is described in the model data.

In a case where the value of the symmetry information "use_symmetry" is "0", no operation is performed on the model data, and the information "NonSymmetricDir()" for obtaining the directivity data is described.

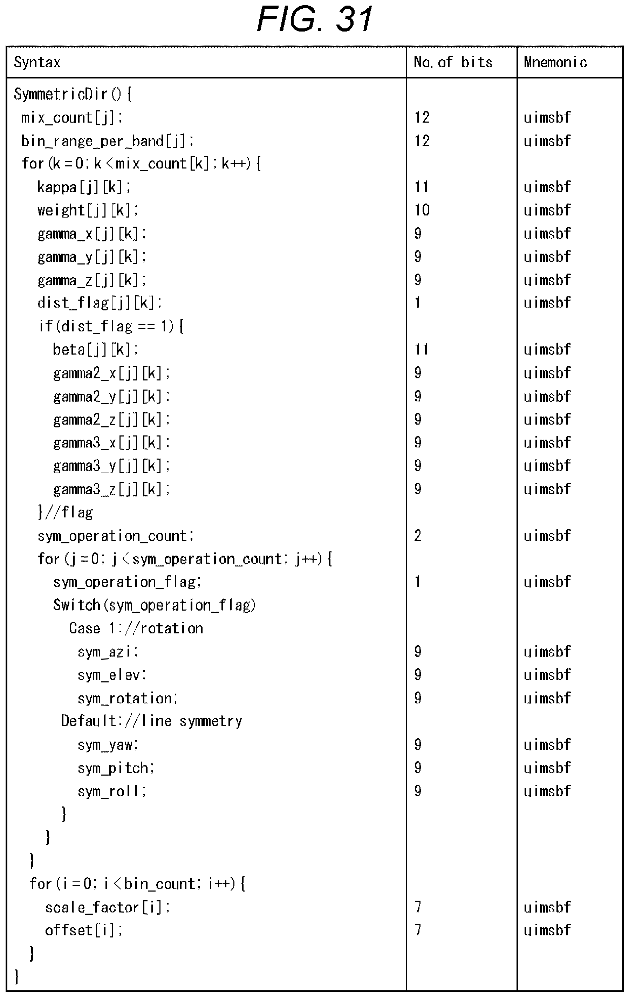

Fig. 31 illustrates Syntax of "SymmetricDir()".

In this example, as in the case in Fig. 25, "SymmetricDir()" of the model data stores the number of mixtures "mix_count[j]" and bin information "bin_range_per_band[j]", "kappa[j][k]", "weight[j][k]", "gamma_x[j][k]", "gamma_y[j][k]", and "gamma_z[j][k]" as model parameters, and a selection flag "dist_flag[j][k]".

In addition, "beta[j][k]", "gamma2_x[j][k]", "gamma2_y[j][k]", "gamma2_z[j][k]", "gamma3_x[j][k]", "gamma3_y[j] [k]", and "gamma3_z[j][k]" as model parameters are also stored according to the value of the selection flag "dist_flag[j][k]".

Further, "SymmetricDir()" stores operation count information "sym_operation_count" and an operation flag "sym_operation_flag".

The operation count information "sym_operation_count" is information indicating the number of times of performing a rotation operation, which is an operation of rotating and copying, or a symmetry operation, which is an operation of copying to a symmetric position, on one distribution (distribution model) such as the vMF distribution or the Kent distribution.

The operation flag "sym_operation_flag" is flag information indicating which of the rotation operation and the symmetry operation is performed. For example, in a case where the value of the operation flag "sym_operation_flag" is "1", it indicates that the rotation operation is performed, and in a case where the value is "0", it indicates that the symmetry operation is performed.

Specifically, here, the operation flag "sym_operation_flag" is included by the number of times indicated by the operation count information "sym_operation_count", and information necessary for the operation is stored according to the value of the operation flag.

That is, in a case where the value of the operation flag "sym_operation_flag" is "1", the rotation axis azimuth angle "sym_azi", the rotation axis elevation angle "sym_elev", and the rotation angle "sym_rotation" required for the rotation operation are stored.

Here, the rotation axis azimuth angle "sym_azi" and the rotation axis elevation angle "sym_elev" are an azimuth angle and an elevation angle indicating the direction of the rotation axis viewed from the sound source position when the rotation operation is performed. That is, the rotation axis is determined by the rotation axis azimuth angle and the rotation axis elevation angle. Furthermore, the rotation angle "sym_rotation" is an angle at the time of rotation with the rotation axis as the center (axis) in the rotation operation.

In addition, in a case where the value of the operation flag "sym_operation_flag" is not "1", that is, in a case where the value of the operation flag is "0", a yaw angle "sym_yaw", a pitch angle "sym_pitch", and a roll angle "sym_roll" indicating a direction of a spherical cross section, that is, a symmetry plane, necessary for the symmetry operation viewed from the sound source position are stored. That is, the symmetry plane is determined by the yaw angle, the pitch angle, and the roll angle.

Therefore, for example, in a case where the value of the operation count information "sym_operation_count" is "2", the operation indicated by each of the two operation flags "sym_operation_flag" is performed. That is, the rotation operation and the symmetry operation are performed twice.

Further, as in the case in Fig. 25, the scale factor "scale_factor[i]" and the minimum value "offset[i]" are also stored in "SymmetricDir()" by the number of frequency points "bin_count".

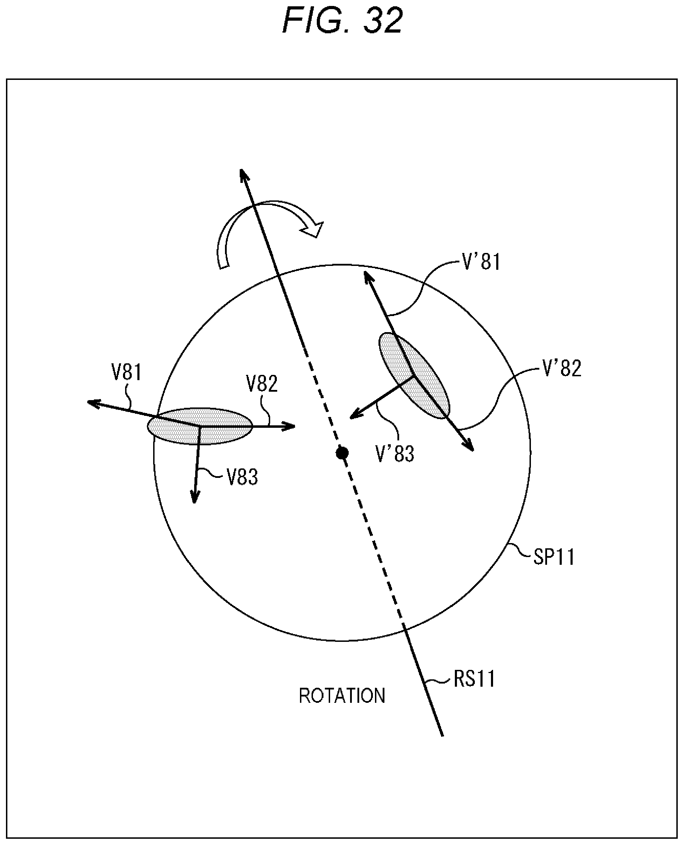

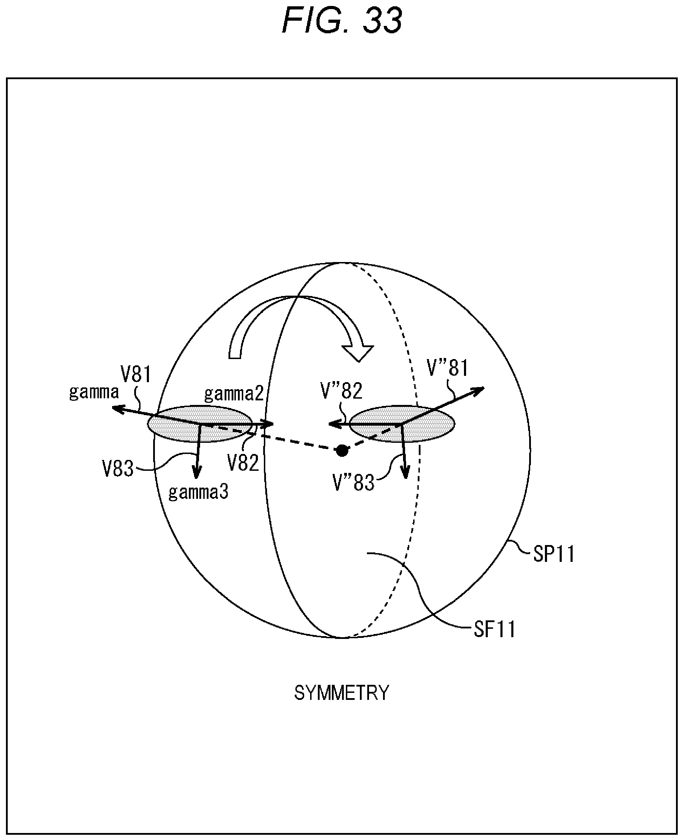

Here, the rotation operation and the symmetry operation will be described with reference to Figs. 32 and 33. Note that the examples illustrated in Figs. 32 and 33 are examples in which a rotation operation or a symmetry operation is performed on the Kent distribution.

Fig. 32 illustrates an example in which a rotation operation is performed on the Kent distribution.

In this example, the directivity gain on the sphere SP11 is represented by a Kent distribution, and vectors V81 to V83 represent a vector $\gamma_1$, a major axis vector $\gamma_2$, and a minor axis vector $\gamma_3$ of the Kent distribution.

These vectors V81 to V83 are obtained by model parameter stored in the model data, that is, "gamma_x[j][k]" to "gamma_z[j][k]" and "gamma2_x[j][k]" to "gamma2_z[j][k]".

In a case where the rotation operation is performed, the directivity data calculator 82 of the information processing device 51 obtains the rotation axis RS11 on the basis of the rotation axis azimuth angle "sym_azi" and the rotation axis elevation angle "sym_elev" read from the model data.

The directivity data calculator 82 obtains the Kent distribution $f(x; \theta_i)$ using the vector V81 to the vector V83.

Further the directivity data calculator 82 obtains the Kent distribution $f(x; \theta_i)$ using the vector V'81 to the vector V'83.

Here, the vector V'81 to the vector V'83 are vectors after rotation obtained by rotating the vectors V81 to V83 by the rotation angle "sym_rotation" stored in the model data around the rotation axis RS11.

In this case, the vector V'81 to the vector V'83 are used as the vector $\gamma_1$, the major axis vector $\gamma_2$, and the minor axis

vector $\gamma_3$ of the Kent distribution.

Therefore, in this example, the directivity data calculator 82 calculates the rotated model parameter by performing a rotation operation on the model parameter such as the vector $\gamma_1$ of the Kent distribution on the basis of the rotation axis azimuth angle and the like. Then, the directivity data calculator 82 obtains the Kent distribution on the basis of each of the model parameter before rotation and the rotated (post-rotation) model parameter, and calculates the mixture model, that is, the directivity data (directivity gain) using the obtained Kent distribution. In other words, one distribution is obtained by synthesis from the Kent distribution obtained from the model parameter before the rotation operation and the Kent distribution obtained from the model parameter after the rotation operation, and the mixture model is obtained using the distribution. Note that the two Kent distributions may be directly used for calculation of the mixture model, or only a partial region of each of the two Kent distributions, such as the right half and the left half, may be used for calculation of the mixture model. This applies not only to the case of the rotation operation but also to the case of the symmetry operation.

Fig. 33 illustrates an example in which a symmetry operation is performed on the Kent distribution. Note that, in Fig. 33, portions corresponding to those in a case of Fig. 32 are denoted by the same reference numerals, and description thereof will be omitted as appropriate.

In this example, the directivity data calculator 82 obtains the cross section SF11 of the sphere SP11 to be the symmetric plane on the basis of the yaw angle "sym_yaw", the pitch angle "sym_pitch", and the roll angle "sym_roll" read from the model data. The cross section SF11 is a plane including the center (sound source position) of the sphere SP11.

The directivity data calculator 82 obtains the Kent distribution $f(x; \theta_i)$ using the vector V81 to the vector V83.

Further, the directivity data calculator 82 obtains the Kent distribution $f(x; \theta_i)$ using the vector V''81 to the vector V''83.

Here, the vector V''81 to the vector V''83 are vectors obtained by folding (symmetrically moving) the vectors V81 to V83 with the cross-section SF11 as a symmetry plane. That is, the vectors V''81 tor V''83 and the vectors V81 to V83 are symmetric (plane-symmetric) with respect to the cross-section SF11.

In the directivity data calculator 82, the vector V''81 to the vector V''83 are used as the vector $\gamma_1$, the major axis vector $\gamma_2$, and the minor axis vector $\gamma_3$ of the Kent distribution.

Therefore, in this example, the directivity data calculator 82 performs a symmetry operation on the model parameter such as the vector $\gamma_1$ of the Kent distribution on the basis of the yaw angle and the like, thereby calculating the model parameter symmetrically moved (symmetry operation). Then, the directivity data calculator 82 obtains the Kent distribution on the basis of each of the model parameter before the symmetrical movement and the symmetrically moved (symmetrically moved) model parameter, and calculates the directivity data (directivity gain) from the obtained Kent distribution and the like.

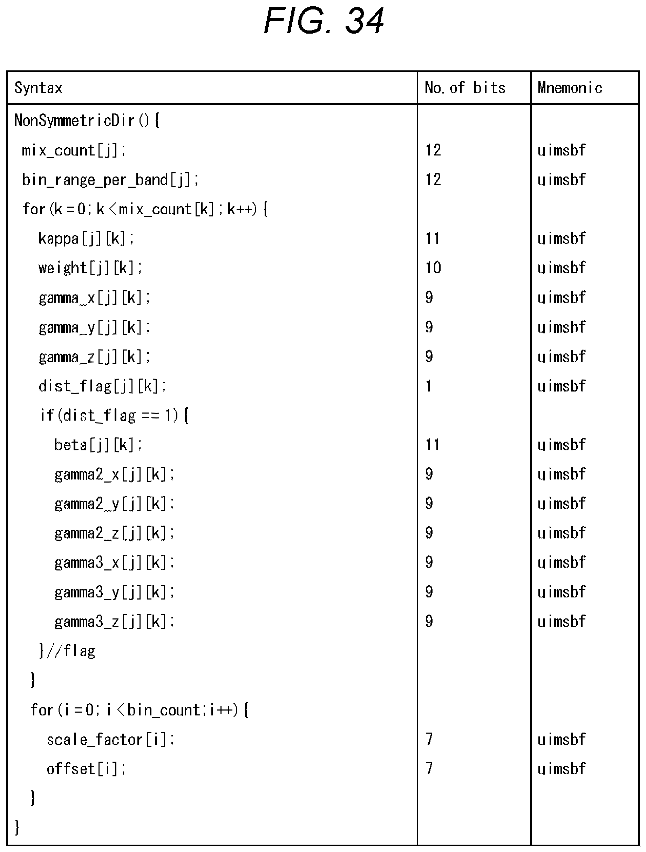

Fig. 34 illustrates an example of Syntax of the information "NonSymmetricDir()" for obtaining the directivity data in the model data illustrated in Fig. 30.

In the example illustrated in Fig. 34, as in the case in Fig. 25, the number of mixtures "mix_count[j]" and bin information "bin_range_per_band[j]", "kappa[j][k]", "weight[j][k]", "gamma_x[j][k]", "gamma_y[j][k]", and "gamma_z[j][k]" as model parameters, and a selection flag "dist_flag[j][k]" are stored.

In addition, "beta[j][k]", "gamma2_x[j][k]", "gamma2_y[j][k]", "gamma2_z[j][k]", "gamma3_x[j][k]", "gamma3_y[j][k]", and "gamma3_z[j][k]" as model parameters are also stored according to the value of the selection flag "dist_flag[j][k]".

Further, a scale factor "scale_factor[i]" and a minimum value "offset[i]" are also stored by the number of frequency points "bin_count".

In this example, since the rotation operation and the symmetry operation are not performed, the model parameter constituting all the distributions are described in the model data.

In addition, the data format (Syntax) of the operation-related information "LeftRightVerticalLineSymmetricDir()", "LeftRightLineSymmetricDir()", and "VerticalLineSymmetricDir()" is the same as "NonSymmetricDir()" illustrated in Fig. 34.

However, in a case where these "LeftRightVerticalLineSymmetricDir()", "LeftRightLineSymmetricDir()", or "VerticalLineSymmetricDir()" are stored, that is, in a case where the value of the symmetry information "use_symmetry" is "4", "3", or "2", the directivity data calculator 82 performs the symmetry operation at the time of decoding the directivity data.

Specifically, in a case where the value of the symmetry information "use_symmetry" is "3", the directivity data calculator 82 performs a left-and-right symmetry operation for the front median plane on the distribution corresponding to the model parameter described in the model data, and obtains a new vMF distribution or Kent distribution.

The left-and-right symmetry operation performed in this case is a symmetry operation in which the front median plane (median plane) viewed from the sound source is a cross section SF11 illustrated in Fig. 33. In other words, the left-and-right symmetry operation is realized by performing the symmetry operation described with reference to Fig. 33 with the median plane as the cross section SF11. In this case, when the distribution obtained from the model parameter before the left-and-right symmetry operation and the distribution obtained from the model parameter after the left-and-right symmetry operation are combined, one distribution that is left-and-right symmetric when viewed from the sound source is obtained.

Furthermore, in a case where the value of the symmetry information "use_symmetry" is "2", the directivity data calculator 82 performs an up-and-down symmetry operation for the front horizontal plane on the distribution corresponding to the model parameter described in the model data with respect to the front horizontal plane, and obtains a new vMF distribution or Kent distribution.

The up-and-down symmetry operation performed in this case is a symmetry operation in which the front horizontal plane (horizontal plane) viewed from the sound source is the cross-section SF11 illustrated in Fig. 33. In other words, the up-and-down symmetry operation is realized by performing the symmetry operation described with reference to Fig. 33 with the horizontal plane as the cross section SF11. In this case, when the distribution obtained from the model parameter before the up-and-down symmetry operation and the distribution obtained from the model parameter after the up-and-down symmetry operation are combined, one distribution that is symmetric in the up-and-down direction when viewed from the sound source is obtained.

Furthermore, in a case where the value of the symmetry information "use_symmetry" is "4", the directivity data calculator 82 performs an up-and-down and left-and-right symmetry operation for the front face on the distribution corresponding to the model parameter described in the model data, and obtains a new distribution. Here, the up-and-down and left-and-right symmetry operation is an operation of obtaining a symmetrical distribution in the up-and-down and left-and-right directions by performing an up-and-down symmetry operation and a left-and-right symmetry operation on the distribution to be operated. Note that the vMF distribution and the Kent distribution on which the symmetry operations including the left-and-right symmetry operation and the up-and-down symmetry operation are performed are effective over the entire spherical surface where the directivity data is defined at the time of decoding (at the time of restoration). In addition, a boundary may be defined in the distribution to be operated or the distribution obtained by the operation, and the directivity gain may be discontinuous at the boundary.

<Fourth embodiment>

<Crossfade between bands>

In the above, the method of reducing the data amount by modeling the directivity data for each frequency band, that is, for each band is described.

However, there is a case where the directivity data, that is, the directivity gain gradually fluctuates according to the frequency, and in such a case, the crossfade of the modeled data is considered to be effective.

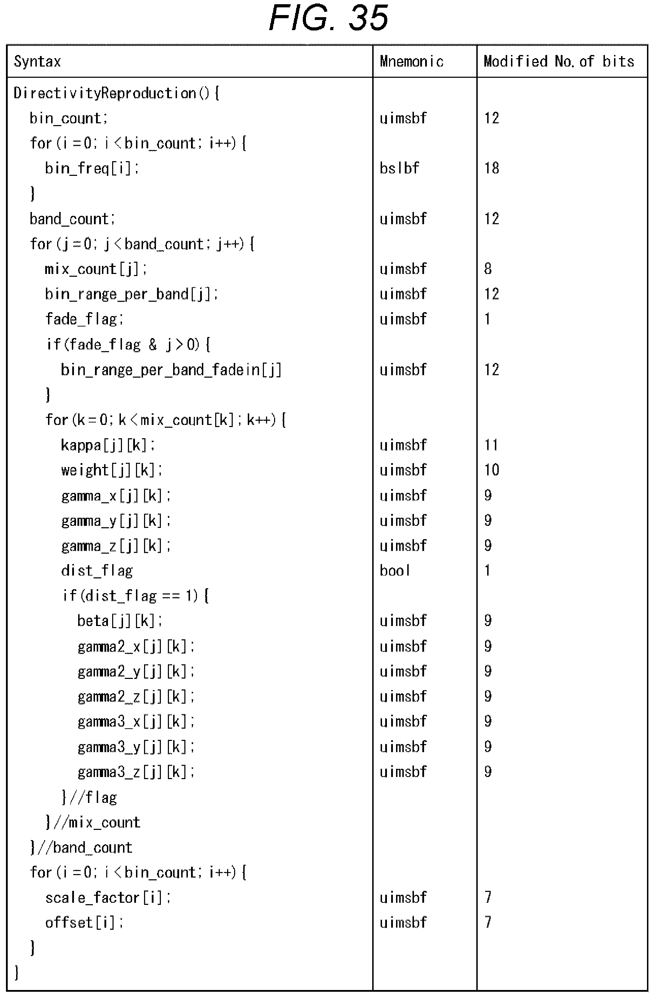

Fig. 35 illustrates an example of Syntax of the model data in a case where the crossfade is performed.

In the example illustrated in Fig. 35, in addition to the information illustrated in Fig. 25, a crossfade flag "fade_flag" and an upper limit bin index "bin_range_per_band_fadein[j]" are further stored (included).

Specifically, in this example, the crossfade flag "fade_flag" in each band is stored by the number of bands "band_count".

The crossfade flag "fade_flag" is flag information indicating whether or not perform a crossfade between bands adjacent to each other, that is, perform weighted addition of the mixture model F' $(x; \Theta)$ for each band, in calculating the mixture model F$(x; \Theta)$ foe each bin.

For example, in a case where the value of the crossfade flag "fade_flag" is "1", the crossfade between the bands is performed, and in a case where the value is "0", the crossfade between the bands is not performed. Note that the crossfade between the bands is used in the second or subsequent bands.

In addition, in a case where the value of the crossfade flag "fade_flag" is "1", the upper limit bin index "bin_range_per_band_fadein[j]" is stored.

The upper limit bin index "bin_range_per_band_fadein[j]" is an index indicating the upper limit bin in which the inter-band crossfade is performed, that is, the bin having the highest frequency among the bins in the band in which the inter-band crossfade is performed.

In the crossfade between bands, the directivity data calculator 82 performs weighted addition on the output value F' $(x; \Theta)$ of the mixture model obtained for the predetermined band and the output value F' $(x; \Theta)$ of the mixture model obtaining for another band adjacent to the predetermined band.

Then, the directivity data calculator 82 multiplies the output value obtained by the weighted addition by the scale factor, and sets a value obtained by adding the minimum value (offset value) to the multiplication result to the output value F$(x; \Theta)$ of the mixture model in the target bin in another band.

In this case, the target of the crossfade is each bin from the bin with the lowest frequency in the another band to the upper limit bin indicated by the upper limit bin index "bin_range_per_band_fadein[j]" in the another band, and the crossfade is not performed in the another bin. For a bin in which no crossfade is performed, the output value F$(x; \Theta)$ of the mixture model is obtained from the output value F' $(x; \Theta)$ of the mixture model in the band to which the bin belongs, the scale factor, and the minimum value.

Therefore, in a case where the crossfade between the bands is performed, in the calculation of the directivity data (directivity gain), a procedure of setting the weighted sum (weighted addition value) of the output values of the restored mixture models between the adjacent bands for the output value of the mixture model of the final band is added before the scale factor and the minimum value are applied.

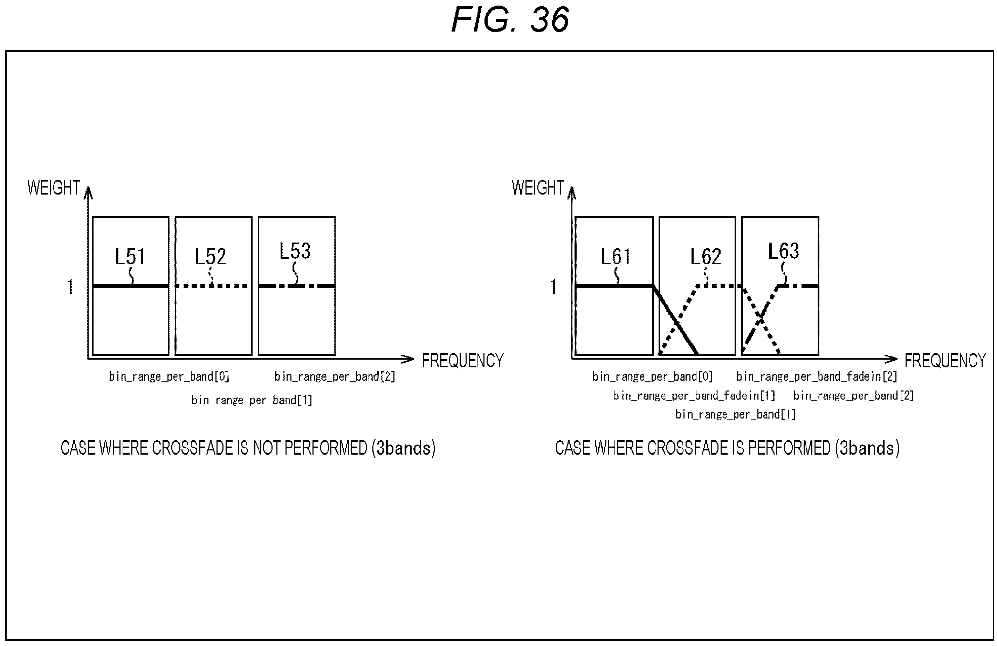

Fig. 36 illustrates a conceptual diagram of the crossfade between bands.

In Fig. 36, the vertical axis represents the weight used at the time of crossfading, and the horizontal axis represents the frequency. In addition, here, a case where the number of bands is three is illustrated as an example.

In the drawing, the weight at the time of the weighted addition in a case where the crossfade between the bands is not performed is illustrated on the left side.

Straight lines L51 to L53 shows a weight of the output value F' (x; Θ) of the mixture model for each band from band "bin_range_per_band[0]" to band "bin_range_per_band[2]", the weight being used to calculate the output value F(x; Θ) of the mixture model for each bin.

In particular, in this example: the ranges in the frequency direction of straight lines L51 to L53 do not overlap with each other, and the weight of the output value F' (x; Θ) of the mixture model for each band for each bin (frequency) is 1. Therefore, it can be seen that crossfade between bands is not substantially performed.

On the other hand, the weight at the time of the weighted addition in a case where the crossfade between the bands is performed is illustrated on the right side in the figure.

Broken lines L61 to L63 shows the weight of the output value F' (x; Θ) of the mixture model for each band from band "bin_range_per_band[0]" to band "bin_range_per_band[2]", which are used to calculate the output value F(x; Θ) of the mixture model for each bin.

In this example, the right end of the broken line L61 indicating the weight of the output value F' (x; Θ) of for example, a mixture model of the band "bin_range_per_band[0]" is located at a frequency position outside the range of the band "bin_range_per_band[0]".

Specifically, the frequency (bin) of the end portion on the right side of the broken line L61 is a bin in the band "bin_range_per_band[1]" adjacent to the band "bin_range_per_band[0]", and this bin is the upper limit bin "bin_range_per_band_fadein[1]".

Therefore, for example, for each bin between the lowest frequency bin and the upper limit bin "bin_range_per_band_fadein[1]" among the bins in the band "bin_range_per_band[1]", it can be seen that the output value F(x; Θ) of the mixture model for each bin is obtained by performing the crossfading between bands. In this case, in each bin, the weights are calculated so that the sum of the weights used to calculate the output value F(x; Θ) of the mixture model is 1.

On the other hand, for each bin having a frequency higher than the upper limit bin among the bins in the band "bin_range_per_band[1]", the value of the weight indicated by the broken line L62 is 1, and it can be seen that the crossfade between the bands is not performed in the bin.

In a case where the crossfade between the bands is performed, the weight $\text{model\_weight}_{i\_band-1}[i\_bin]$ of the output value of the mixture model of the lower frequency band "i_band-1" for a predetermined bin "i_bin" can be obtained by the following Expression (10).

[Math. 10]

$$\text{model\_weight}_{i\_band-1}[i\_bin] = \begin{cases} (i\_bin - bin\_range\_per\_band[i\_band-1])/(bin\_range\_per\_band\_fadein[i\_band] - bin\_range\_per\_band[i\_band-1]) \\ \qquad\qquad (i\_bin < bin\_range\_per\_band\_fadein[i\_band]) \\ 1.0 \\ \qquad\qquad (i\_bin >= bin\_range\_per\_band\_fadein[i\_band]) \end{cases}$$

$$\cdots (10)$$

Furthermore, the weight $\text{model\_weight}_{i\_band}[i\_bin]$ of the output value of the mixture model of the higher frequency band "i_band" for the predetermined bin "i_bin" can be obtained by the following Expression (11).

[Math. 11]

$$\text{model\_weight}_{i\_band}[i\_bin] = 1 - \text{model\_weight}_{i\_band-1}[i\_bin]$$

$$\cdots (11)$$

Furthermore, the output value $F_{i\_bin}(x)$ of the mixture model for the bin "i_bin" can be obtained by calculating the following Expression (12) on the basis of the weight and the output value $F_{i\_band+j-1}(x)$ of the mixture model for the band "i_band + j-1" for the bin "i_bin".
[Math. 12]

$$F_{i\_bin}(x) = \left( \sum_{j=0}^{1} model\_weight_{i\_band+j-1}[i\_bin] * F_{i\_band+j-1}(x) \right)$$
$$* scale\_factor[i\_bin] + offset[i\_bin] \qquad \cdots (12)$$

Note that scal _factor[i_bin] and offset[i_bin] in Expression (12) indicate the scale factor and the minimum value (offset value) of the bin "i_bin".

The directivity data calculator 82 calculates Expression (12) to calculate the output value of the mixture model of each bin, that is, the directivity gain of each bin of each data point. In this way, the data amount of the model data can be reduced.

<Fifth embodiment>

<Utilization of symmetry of data>

In the third embodiment, utilization of data symmetry is described.

In a case where the amount of transmission data is reduced by utilizing such symmetry, it is also possible to utilize the symmetry in the front-rear direction in addition to the up-and-down symmetry and the left-and-right symmetry of the directivity data described above, and to utilize a combination of symmetries in the front-rear direction, the up-and-down direction, and the left-and-right direction.

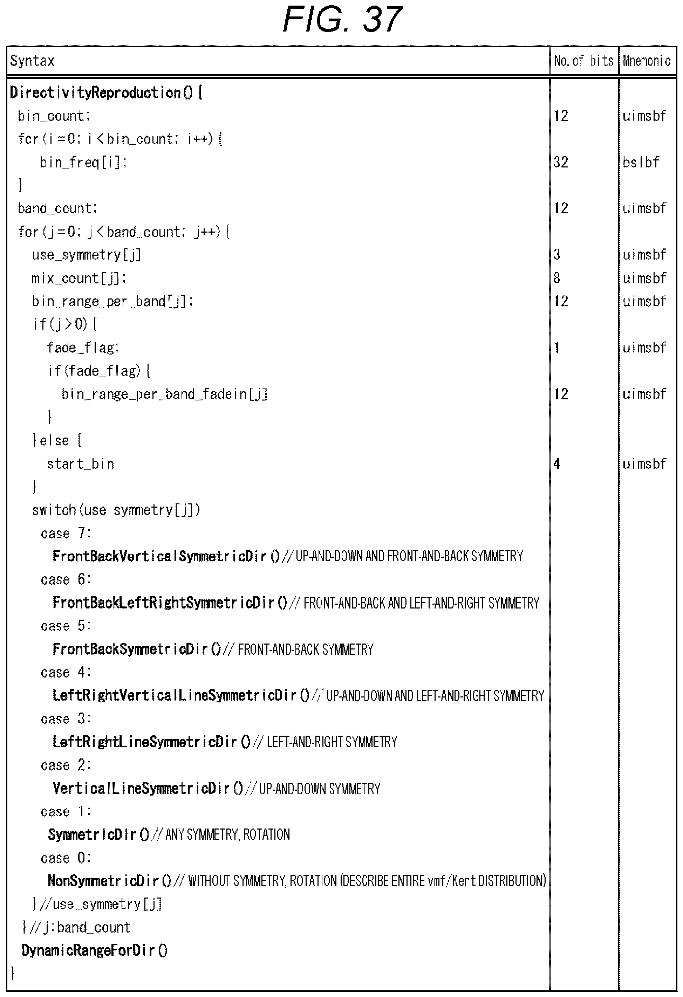

In such a case, Syntax of the model data is, for example, as illustrated in Fig. 37.

The model data illustrated in Fig. 37 includes the number of frequency points "bin_count" indicating the number of bins, and the frequency "bin_freq[i]" at the center of the bin is stored by the number of frequency points "bin_count".

In addition, the model data also stores the number of bands "band_count", and symmetry information "use_symmetry[j]", the number of mixtures "mix_count[j]", and bin information "bin_range_per_band[j]" related to the use of the symmetry of the directivity data are stored by the number of bands "band_count", that is, for each band.

The symmetry information "use_symmetry[j]" is similar to the symmetry information "use_symmetry" illustrated in Fig. 30, but in this example, the values "5" to "7" of the symmetry information "use_symmetry[j]" are used without being reserved as described later.

Furthermore, the number of mixtures "mix_count[j]" and the bin information "bin_range_per_band[j]" are similar to those illustrated in Fig. 31, and are information indicating the number of distributions constituting the mixture model of bands and a bin (bin) for the original directivity data before modeling.

In the example illustrated in Fig. 30, the number of mixtures "mix_count[j]" and the bin information "bin_range_per_band[j]" are stored for each piece of operation-related information and the like. However, since the number of mixtures and the bin information are the same, the number of mixtures and the bin information are stored in a portion other than the operation-related information in the model data in the example of Fig. 37.

In the example of Fig. 37, the value of the symmetry information "use_symmetry[j]" for each band is any value of "0" to "7".

The values "4", "3", "2", "1", and "0" of the symmetry information "use_symmetry[j]" indicate that the up-and-down and left-and-right symmetry operation is performed, the left-and-right symmetry operation is performed, the up-and-down symmetry operation is performed, any symmetry and rotation are utilized, and any symmetry and rotation operation is not performed, as in the example of Fig. 30.

Values "7", "6", and "5" of the symmetry information "use_symmetry[j]" indicate that an up-and-down and front-and-back symmetry operation is performed, a front-and-back and left-and-right symmetry operation is performed, and a front-and-back symmetry operation is performed.

In a case where the number of bands "band_count" is larger than 0 (j > 0), the crossfade flag "fade_flag" in each band is stored in the model data.

The crossfade flag "fade_flag" is the same as that described with reference to Fig. 35. That is, in a case where the value of the crossfade flag "fade_flag" is "1", the crossfade between the bands is performed, and in a case where the value is "0", the crossfade between the bands is not performed.

In addition, in a case where the value of the crossfade flag "fade_flag" is "1", an upper limit bin index "bin_range_per_band_fadein[j]" for the band is stored in the model data.

In addition, a start bin "start_bin" is stored in the model data.

The original directivity data before modeling may not substantially include data for a bin having a lower frequency among the bins indicated by the frequency "bin_freq[i]". That is, the directivity gain of a bin with a low frequency may be 0.

The start bin "start_bin" is information indicating the bin having the lowest frequency in which the directivity gain that is not 0 is included as data among the bins indicated by the frequency "bin_freq[i]".

Furthermore, operation-related information for a rotation operation or a symmetry operation is stored in the model data according to the value of the symmetry information "use_symmetry[j]".

In a case where the value of the symmetry information "use_symmetry[j]" is "7", the operation-related information "FrontBackVerticalSymmetricDir()" for the up-and-down and front-and-back symmetry operation is described in the model data. In a case where the value of the symmetry information "use_symmetry[j]" is "6", the operation-related information "FrontBackLeftRightSymmetricDir()" for the front-and-back and left-and-right symmetry operation is described in the model data.

Furthermore, in a case where the value of the symmetry information "use_symmetry[j]" is "5", the operation-related information "FrontBackSymmetricDir()" for the front-and-back symmetry operation is described in the model data.

In a case where the value of the symmetry information "use_symmetry[j]" is "4", the operation-related information "LeftRightVerticalLineSymmetricDir()" is described in the model data. In a case where the value of the symmetry information "use_symmetry[j]" is "3", the operation-related information "LeftRightLineSymmetricDir()" is described in the model data.

Further, in a case where the value of the symmetry information "use_symmetry[j]" is "2", the operation-related information "VerticalLineSymmetricDir()" is described in the model data.

In a case where the value of the symmetry information "use_symmetry[j]" is "1", the operation-related information "SymmetricDir()" is described in the model data. In a case where the value of the symmetry information "use_symmetry[j]" is "0", the information "NonSymmetricDir()" is described in the model data.

Furthermore, information regarding the dynamic range "DynamicRangeForDir()" is described in the model data.

The information "DynamicRangeForDir()" stores a scale factor "scale_factor[i]" and a minimum value "offset[i]" for each bin in which the center frequency is equal to or higher than the center frequency of the bin indicated by the start bin "start_bin".

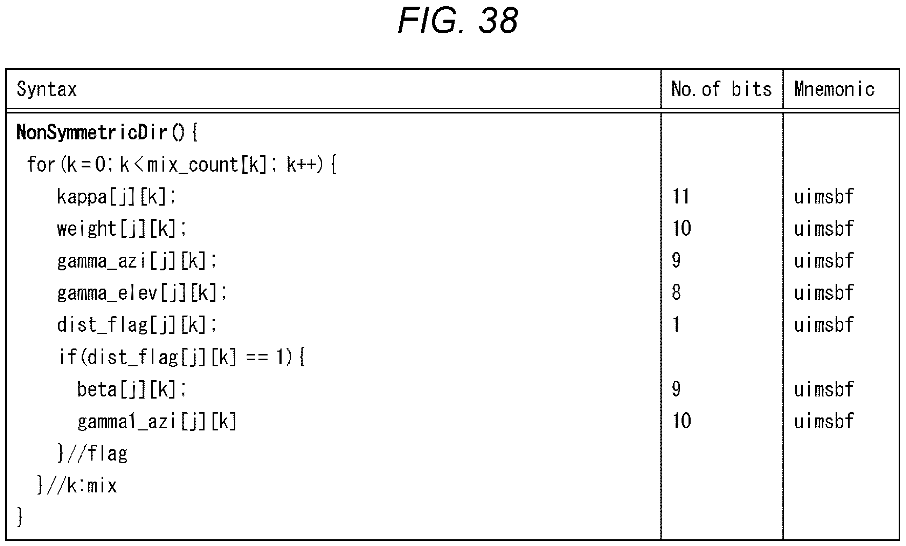

Fig. 38 illustrates an example of Syntax of the information "NonSymmetricDir()" for obtaining the directivity data in the model data illustrated in Fig. 37.

In the example illustrated in Fig. 38, "kappa[j][k]", "weight[j][k]", "gamma_azi[j][k]", and "gamma_elev[j] [k]" as model parameters and a selection flag "dist_flag[j][k]" are stored by the number of mixtures "mix_count[k]".

Here, "gamma_azi[j][k]" and "gamma_elev[j][k]" indicate a horizontal direction angle (azimuth angle) and a vertical direction angle (elevation angle) indicating the direction of the vector $\gamma_1$.

In the example of Fig. 34, the vector $\gamma_1$ is expressed by "gamma_x[j][k]", "gamma_y[j][k]", and "gamma_z[j][k]", but in Fig. 38, the vector $\gamma_1$ is expressed by an azimuth angle and an elevation angle.

In addition, "beta[j][k]" and "gammal_azi[j][k]" as model parameters are also stored according to the value of the selection flag "dist_flag[j][k]".

"gammal_azi[j][k]" is an angle (rotation angle) in the horizontal direction indicating the relative direction of the major axis vector $\gamma_2$ and the minor axis vector $\gamma_3$ when viewed from the vector $\gamma_1$.

That is, in this example, the major axis vector $\gamma_2$ and the minor axis vector $\gamma_3$ can be obtained from the vector $\gamma_1$ and the angle "gamma1_azi[j][k]".

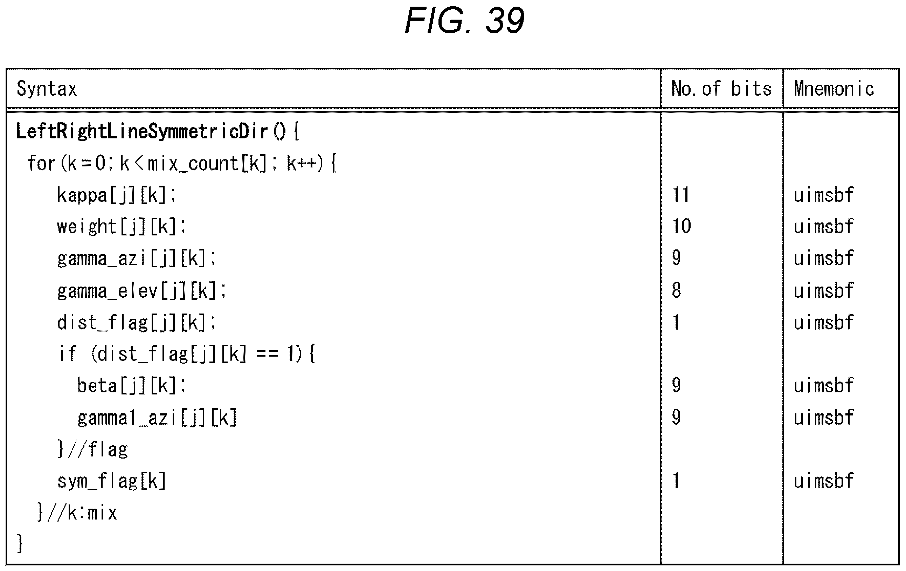

Fig. 39 illustrates an example of Syntax of the operation-related information "LeftRightLineSymmetricDir()".

In this example, as in the case of "NonSymmetricDir()" in Fig. 38, "kappa[j] [k]", "weight[j] [k]", "gamma_azi[j][k]", and "gamma _elev[j][k]" as model parameters, and a selection flag "dist_flag[j][k]" are stored by the number of mixtures "mix_count[k]".

In addition, "beta[j][k]" and "gammal_azi[j][k]" as model parameters are also stored according to the value of the selection flag "dist_flag[j][k]".

Further, the operation-related information "LeftRightLineSymmetricDir()" stores "sym_flag[k]" for each distribution (mixture) such as Kent distribution or vMF distribution constituting a mixture model representing the distribution of the directivity gain in the band by the number of mixtures "mix_count[k]".

"sym_flag[k]" is flag information indicating whether or not to perform an operation such as symmetry or rotation on a target distribution. For example, a value "00" of the flag information "sym_flag[k]" indicates that an operation such as symmetry or rotation is not performed, and the value "01" of the flag information "sym_flag[k]" indicates that a symmetry operation is performed.

Therefore, for example, in a case where the value of the flag information "sym_flag[k]" of the predetermined distribution stored in the operation-related information "LeftRightLineSymmetricDir()" is "01", a left-and-right symmetry operation is performed on the distribution.

The data format (Syntax) of the operation-related information "FrontBackVerticalSymmetricDir()", "FrontBackLeftRightSymmetricDir()", "FrontBackSymmetricDir()", "LeftRightVerticalLineSymmetricDir()", "VerticalLineSymmetric-

Dir()", and "SymmetricDir()" in the model data is similar to "LeftRightLineSymmetricDir()" in Fig. 39.

In this case, the flag information "sym_flag[k]" in each piece of operation-related information is flag information indicating whether or not to perform an operation corresponding to the operation-related information.

Specifically, for example, in a case where the value of the flag information "sym_flag[k]" of the predetermined distribution (mixture) stored in the operation-related information "VerticalLineSymmetricDir()" is "01", the up-and-down symmetry operation is performed on the distribution.

Furthermore, for example, in addition to the information stored in the operation-related information "LeftRightLineSymmetricDir()" illustrated in Fig. 39, information necessary for the rotation operation and the symmetry operation is also stored in the operation-related information "SymmetricDir()" according to the value of the flag information "sym_flag [k]".

Specifically, for example, the rotation axis azimuth angle "sym_azi", the rotation axis elevation angle "sym_elev", the rotation angle "sym_rotation", the yaw angle "sym_yaw", the pitch angle "sym_pitch", and the roll angle "sym_roll" described with reference to Fig. 31 are appropriately stored in the operation-related information. Then, a rotation operation or a symmetry operation is performed for each distribution constituting the mixture model according to the value of the flag information "sym_flag[k]". In this case, a combination of operations to be executed, such as only a rotation operation, only a symmetry operation, and both the rotation operation and the symmetry operation, can be designated by a value of the flag information "sym_flag[k]".

Note that the configuration of the operation-related information "SymmetricDir()" may be similar to the configuration of the example illustrated in Fig. 31, and the presence or absence of execution of the rotation operation and the symmetry operation may be defined by the operation count information "sym_operation_count" and the operation flag "sym_operation_flag".

Further, in a case where the operation-related information "FrontBackVerticalSymmetricDir()", "FrontBackLeftRightSymmetricDir()", or "FrontBackSymmetricDir()" is stored in the model data, that is, in a case where the value of the symmetry information "use_symmetry[j]" is "7", "6", or "5", the directivity data calculator 82 performs a symmetry operation at the time of decoding the directivity data.

Specifically, in a case where the value of the symmetry information "use_symmetry[j]" is "7", the directivity data calculator 82 performs an up-and-down and front-and-back symmetry operation on the distribution in which the value of the flag information "sym_flag[k]" is "01", and obtains a new distribution.

Then, the directivity data calculator 82 calculates the directivity data (directivity gain) from the new distribution and the like. In addition, thereafter, the crossfade between bands is also appropriately performed according to the value of the crossfade flag "fade_flag" for each band.

Here, the up-and-down and front-and-back symmetry operation is an operation of obtaining an up-and-down and front-and-back symmetric distribution by performing an up-and-down symmetry operation and a front-and-back symmetry operation on a distribution to be operated.

The up-and-down symmetry operation performed in this case is a symmetry operation in which the front horizontal plane (horizontal plane) viewed from the sound source is the cross-section SF11 illustrated in Fig. 33. In other words, the up-and-down symmetry operation is realized by performing the symmetry operation described with reference to Fig. 33 with the horizontal plane as the cross section SF11.

In addition, the front-and-back symmetry operation is a symmetry operation in which a plane obtained by rotating the front median plane (median plane) viewed from the sound source by 90 degrees in the horizontal direction is a cross section SF11 illustrated in Fig. 33. In other words, the front-and-back symmetry operation is realized by performing the symmetry operation described with reference to Fig. 33 with a plane obtained by rotating the front median plane by 90 degrees in the horizontal direction as the cross-section SF11.

In a case where the value of the symmetry information "use_symmetry[j]" is "6", the directivity data calculator 82 performs a front-and-back and left-and-right symmetry operation on the distribution in which the value of the flag information "sym_flag[k]" is "01" to obtain a new distribution, and calculates the directivity data using the obtained distribution.

The front-and-back and left-and-right symmetry operation is an operation of obtaining a symmetrical distribution in the front-back and left-and-right directions by performing the front-and-back symmetry operation and the left-and-right symmetry operation on the distribution to be operated. The left-and-right symmetry operation performed in this case is a symmetry operation in which the front median plane (median plane) viewed from the sound source is a cross section SF11 illustrated in Fig. 33.

Further, for example, in a case where the value of the symmetry information "use_symmetry[j]" is "5", the directivity data calculator 82 performs a front-and-back symmetry operation on the distribution in which the value of the flag information "sym_flag[k]" is "01" to obtain a new distribution, and calculates the directivity data using the obtained distribution.

Note that the distribution such as the vMF distribution and the Kent distribution on which the symmetry operations including the left-and-right symmetry operation, the up-and-down symmetry operation, and the front-and-back symmetry operation are performed is effective over the entire spherical surface where the directivity data is defined at the time of decoding (at the time of restoration). In addition, a boundary may be defined in the distribution to be operated or the distribution obtained by the operation, and the directivity gain may be discontinuous at the boundary.

In addition, in the fifth embodiment, regarding the operation of symmetry or rotation defined by the symmetry information "use_symmetry[j]" for each band, whether or not the operation of symmetry or rotation is actually performed for each distribution (mixture) such as the Kent distribution constituting the mixture model of the bands is defined by the flag information "sym_flag[k]".

However, the invention is not limited thereto, and an operation of symmetry or rotation to be executed for each distribution (mixture) such as Kent distribution constituting the band mixture model may be defined.

In such a case, for example, for each distribution, it is conceivable to appropriately store 1-bit symmetry information "use_symmetry" and 3-bit flag information "sym_flag[k]" in operation-related information or the like of model data, and define an operation to be performed for each distribution.

In this example, for example, 1-bit symmetry information "use_symmetry" is flag information indicating whether or not to perform an operation such as symmetry or rotation.

Specifically, for example, in a case where the value of the symmetry information "use_symmetry" is "1", an operation such as symmetry or rotation is performed, and in a case where the value of the symmetry information "use_symmetry" is "0", an operation such as symmetry or rotation is not performed.

Furthermore, in a case where the value of the symmetry information "use_symmetry" is "0", since the operation of symmetry or rotation is not performed on the target distribution, the flag information "sym_flag[k]" for the distribution is not stored in the operation-related information or the like.

On the other hand, in a case where the value of the symmetry information "use_symmetry" is "1", since the operation of symmetry or rotation is performed on the target distribution, the flag information "sym_flag[k]" for the distribution is stored in the operation-related information and the like.

Then, the directivity data calculator 82 performs an operation according to the value of the flag information "sym_flag[k]", and a new distribution is obtained.

At this time, for the values "0", "1", "2", "3", "4", "5", "6", and "7" of the flag information "sym_flag[k]", for example, no operation, any symmetry, rotation operation, an up-and-down symmetry operation, a left-and-right symmetry operation, an up-and-down and left-and-right symmetry operation, a front-and-back symmetry operation, a front-and-back and left-and-right symmetry operation, and an up-and-down and front-and-back symmetry operation may be assigned.

<Others>

When calculating the rough directivity data (directivity data) such as step S52 in Fig. 12 and step S117 in Fig. 20, the directivity data calculator 82 calculates a mixture model $F'(x; \Theta)$ for each band on the basis of the model parameter.

At this time, the directivity data calculator 82 performs weighted addition on a plurality of distributions constituting the mixture model, such as the Kent distribution, the vMF distribution, and the complex Bingham distribution obtained from the model parameter, by using the weight $\varphi_i$ of the distributions, that is, the weight[j][k] and the weight[i_band][i_mix] described above, to obtain the mixture model $F'(x; \Theta)$ (directivity data).

The value of the weight $\varphi_i$ of each distribution is determined such that the sum of the weights $\varphi_i$ of the plurality of distributions constituting the mixture model is 1, but the value of each weight $\varphi_i$ may be a positive value or a negative value.

For example, by setting the weight $\varphi_i$ of some distributions to a negative value, it is possible to provide not only a steep peak but also a dip in the mixture model, as in the relationship between the bandpass and the band eject filter in the filter.

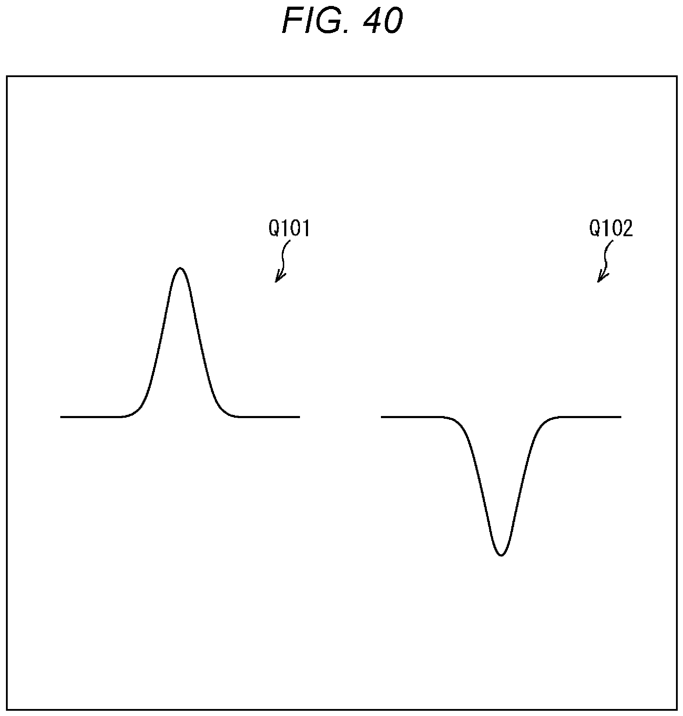

For example, in a case where the weight $\varphi_i$ of one distribution such as the Kent distribution or the vMF distribution constituting the mixture model is a positive value, when the distribution is multiplied by the weight $\varphi_i$, the distribution after the multiplication of the weight $\varphi_i$ is as indicated by the arrow Q101 in Fig. 40, for example.

Note that, in Fig. 40, the lateral direction indicates a predetermined direction on the spherical surface in the distribution such as the Kent distribution defined on the spherical surface, and the vertical direction indicates a value at each position of the distribution, that is, the directivity gain.

In the example indicated by the arrow Q101, it can be seen that there is an upward convex peak in the figure in the distribution after multiplication by the weight $\varphi_i$.

On the other hand, in a case where the weight $\varphi_i$ of one distribution such as the Kent distribution or the vMF distribution constituting the mixture model is a negative value, when the distribution is multiplied by the weight $\varphi_i$, the distribution after the multiplication by the weight $\varphi_i$ is as indicated by the arrow Q102, for example. In this example, it can be seen that there is a downward convex dip in the distribution after multiplication by the weight $\varphi_i$ in the drawing.

Therefore, when the weight $\varphi_i$ of each distribution including a negative value is appropriately determined on the condition that the sum of the weights $\varphi_i$ of all the distributions constituting the mixture model for the band is 1, the degree of freedom is further increased, and the mixture models having more various shapes can be expressed.

**EP 4 425 960 B1**

As described above, even in a case where the weight $\varphi_i$ of any distribution is set to a negative value, when the sum of the weights $\varphi_i$ of all the distributions is set to 1 (1.0), the generality is not lost.

Furthermore, in a case where a negative value can also be taken as the value of the weight $\varphi_i$, for example, high-order 1 bit of a weight of 10 bits, weight[j][k], as the weight $\varphi_i$ in Fig. 25, Fig. 31, Fig. 34, or the like is used as the sign bit. The same applies to, for example, the weight weight[i_band][i_mix] in Fig. 5.

<Configuration example of computer>

Note that, the above-described series of processes may be executed by hardware or software. In a case where the series of processes are executed by the software, a program constituting the software is installed on a computer. Here, examples of the computer include a computer incorporated in dedicated hardware, and for example, a general-purpose personal computer capable of executing various functions by installing various programs.

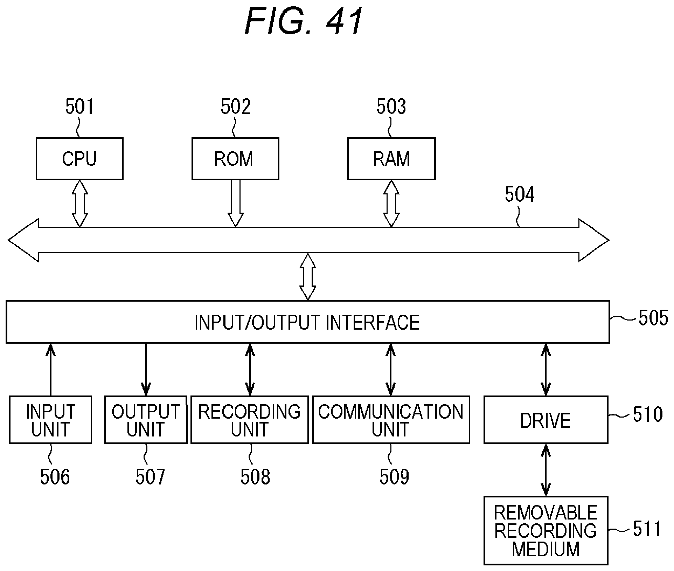

Fig. 41 is a block diagram illustrating a configuration example of hardware of a computer that executes the above-described series of processes by a program.

In the computer, a central processing unit (CPU) 501, a read only memory (ROM) 502, and a random access memory (RAM) 503 are mutually connected by a bus 504.

Moreover, an input/output interface 505 is connected to the bus 504. An input unit 506, an output unit 507, a recording unit 508, a communication unit 509, and a drive 510 are connected to the input/output interface 505.

The input unit 506 includes a keyboard, a mouse, a microphone, an imaging element, and the like. The output unit 507 includes a display, a speaker and the like. The recording unit 508 includes a hard disk, a nonvolatile memory, and the like. The communication unit 509 includes a network interface and the like. The drive 510 drives a removable recording medium 511 such as a magnetic disk, an optical disc, a magneto-optical disk, or a semiconductor memory.

In the computer configured as described above, the CPU 501 loads, for example, a program recorded in the recording unit 508 into the RAM 503 via the input/output interface 505 and the bus 504, and executes the program, so as to execute the above-described series of processes.

The program executed by the computer (CPU 501) can be provided by being recorded on the removable recording medium 511 as a package medium, or the like, for example. Furthermore, the program may be provided via a wired or wireless transmission medium, such as a local area network, the Internet, or digital satellite broadcasting.

In the computer, the program can be installed in the recording unit 508 via the input/output interface 505 by mounting the removable recording medium 511 to the drive 510. Furthermore, the program can be received by the communication unit 509 via the wired or wireless transmission medium to be installed on the recording unit 508. In addition, the program can be installed in the ROM 502 or the recording unit 508 in advance.

Note that, the program executed by the computer may be a program that is processed in time series in the order described in the present specification, or a program that is processed in parallel or at a necessary timing such as when a call is made.

Furthermore, the embodiments of the present technology are not limited to the above-described embodiments, and various modifications are possible without departing from the scope of the present technology.

For example, the present technology may be configured as cloud computing in which one function is shared by a plurality of devices via a network to process together.

In addition, each step described in the above flowcharts can be executed by one device or shared and performed by a plurality of devices.

Moreover, in a case where a plurality of processing steps is included in one step, the plurality of processing included in the one step can be performed by one device or shared and performed by a plurality of devices.

REFERENCE SIGNS LIST

| | |
|---|---|
| 11 | Server |
| 21 | Modeling unit |
| 22 | Model data generation unit |
| 23 | Audio data encoding unit |
| 51 | Information processing device |
| 61 | Acquisition unit |
| 62 | Distribution model decoding unit |
| 63 | Audio data decoding unit |
| 64 | Rendering processing unit |
| 82 | Directivity data calculator |

83 Difference information decoding unit
84 Addition unit
85 Frequency interpolation processing unit
88 Temporal interpolation processing unit
89 Directivity convolution unit
90 HRTF convolution unit

**Claims**

1. An information processing device (51) comprising:

   an acquisition unit (61) configured to acquire model data obtained by modeling directivity data representing directivity of a sound source; and
   a calculator (82) configured to calculate the directivity data on a basis of the model data,
   wherein the model data includes a model parameter constituting a mixture model, the model parameter being obtained by modeling the directivity data with the mixture model including one or more distributions **characterized in that** the one or more distributions include at least any one of a von Mises Fisher, VMF, distribution or a Kent distribution.

2. The information processing device (51) according to claim 1, wherein

   the directivity data includes a directivity gain for each of a plurality of frequency bins, and
   the model data includes the model parameter constituting the mixture model representing a distribution of the directivity gain for each band that is a frequency band including one or more of the frequency bins.

3. The information processing device (51) according to claim 2, wherein
   the model data includes a scale factor indicating a dynamic range of the directivity gain in the frequency bin and a minimum value of the directivity gain in the frequency bin.

4. The information processing device (51) according to any one of the previous claims, wherein

   the model data includes difference information indicating a difference between the directivity data before modeling and the directivity data after modeling, and
   the information processing device further comprises an addition unit (84) configured to add the difference information to the directivity data calculated by the calculator.

5. The information processing device (51) according to claim 4, wherein
   the difference information is Huffman encoded.

6. The information processing device (51) according to any one of the previous claims, wherein

   the directivity data includes a directivity gain for each of a plurality of frequency bins, and
   the information processing device further comprises an interpolation processing unit (85) configured to calculate the directivity gain of the new frequency bin by performing an interpolation process on a basis of the directivity data calculated by the calculator.

7. The information processing device (51) according to any one of the previous claims, wherein

   the directivity data includes a directivity gain at each of a plurality of data points, and
   the information processing device further comprises an interpolation processing unit (85) configured to calculate the directivity gain at the new data point by performing an interpolation process on a basis of the directivity data calculated by the calculator.

8. The information processing device (51) according to any one of the previous claims,, further comprising:
   a directivity convolution unit (89) configured to convolve the directivity data and audio data.

9. The information processing device (51) according to claim 8, further comprising:
   an HRTF convolution unit (90) configured to convolve the audio data in which the directivity data is convolved and an HRTF.

10. The information processing device (51) according to claim 1, wherein
the one or more distributions include a complex Bingham distribution or a complex watson distribution.

11. The information processing device (51) according to any one of the previous claims, wherein
the model data includes a spherical harmonic coefficient obtained by modeling the directivity data by spherical harmonic function expansion as a model parameter.

12. The information processing device (51) according to any one of the previous claims, wherein
the model data includes a model parameter obtained by modeling the directivity data by one or more methods different from each other.

13. The information processing device (51) according to claim 12, wherein
the methods include at least any one of a method of modeling with a mixture model including one or more distributions or a method of modeling by spherical harmonic function expansion.


**Patentansprüche**

1. Informationsverarbeitungsvorrichtung (51), umfassend:

   eine Erfassungseinheit (61), die konfiguriert ist, um Modelldaten zu erfassen, die durch Modellierung von Richtwirkungsdaten erhalten werden, welche die Richtwirkung einer Schallquelle darstellen; und
   einen Rechner (82), der konfiguriert ist, um die Richtwirkungsdaten auf Basis der Modelldaten zu berechnen, wobei die Modelldaten einen Modellparameter einschließen, der ein Mischungsmodell bildet, wobei der Modellparameter durch Modellierung der Richtwirkungsdaten mit dem Mischungsmodell erhalten wird, das eine oder mehrere Verteilungen einschließt,
   **dadurch gekennzeichnet, dass** die eine oder mehreren Verteilungen mindestens eines von einer von-Mises-Fisher-Verteilung (VMF-Verteilung) oder einer Kent-Verteilung einschließen.

2. Informationsverarbeitungsvorrichtung (51) nach Anspruch 1, wobei

   die Richtwirkungsdaten eine Richtwirkungsverstärkung für jeden einer Vielzahl von Frequenzbereichen einschließen, und
   die Modelldaten den Modellparameter einschließen, der das Mischmodell bildet, das eine Verteilung der Richtwirkungsverstärkung für jedes Band darstellt, das ein Frequenzband ist, das einen oder mehrere der Frequenzbereiche einschließt.

3. Informationsverarbeitungsvorrichtung (51) nach Anspruch 2, wobei
die Modelldaten einen Skalierungsfaktor einschließen, der einen Dynamikbereich der Richtwirkungsverstärkung in dem Frequenzbereich angibt, und einen Mindestwert der Richtwirkungsverstärkung in dem Frequenzbereich.

4. Informationsverarbeitungsvorrichtung (51) nach einem der vorstehenden Ansprüche, wobei

   die Modelldaten Differenzinformationen einschließen, die eine Differenz zwischen den Richtwirkungsdaten vor der Modellierung und den Richtwirkungsdaten nach der Modellierung anzeigen, und
   die Informationsverarbeitungsvorrichtung ferner eine Additionseinheit (84) umfasst, die konfiguriert ist, um die Differenzinformation zu den von dem Rechner berechneten Richtwirkungsdaten zu addieren.

5. Informationsverarbeitungsvorrichtung (51) nach Anspruch 4, wobei
die Differenzinformationen Huffman-codiert sind.

6. Informationsverarbeitungsvorrichtung (51) nach einem der vorstehenden Ansprüche, wobei

   die Richtwirkungsdaten eine Richtwirkungsverstärkung für jeden einer Vielzahl von Frequenzbereichen einschließen, und
   die Informationsverarbeitungsvorrichtung ferner eine Interpolationsverarbeitungseinheit (85) umfasst, die konfiguriert ist, um die Richtwirkungsverstärkung des neuen Frequenzbereichs durch Durchführung eines Interpolationsprozesses auf Basis der durch den Rechner berechneten Richtwirkungsdaten zu berechnen.

7. Informationsverarbeitungsvorrichtung (51) nach einem der vorstehenden Ansprüche, wobei

   die Richtwirkungsdaten eine Richtwirkungsverstärkung an jedem einer Vielzahl von Datenpunkten einschließen, und
   die Informationsverarbeitungsvorrichtung ferner eine Interpolationsverarbeitungseinheit (85) umfasst, die konfiguriert ist, um die Richtwirkungsverstärkung an dem neuen Datenpunkt durch Durchführung eines Interpolationsprozesses auf Basis der durch den Rechner berechneten Richtwirkungsdaten zu berechnen.

8. Informationsverarbeitungsvorrichtung (51) nach einem der vorstehenden Ansprüche, ferner umfassend:
   eine Richtwirkungs-Faltungseinheit (89), die konfiguriert ist, um die Richtwirkungsdaten und Audiodaten zu falten.

9. Informationsverarbeitungsvorrichtung (51) nach Anspruch 8, ferner umfassend:
   eine HRTF-Faltungseinheit (90), die konfiguriert ist, um die Audiodaten, in welche die Richtwirkungsdaten gefaltet sind, und eine **HRTF** zu falten.

10. Informationsverarbeitungsvorrichtung (51) nach Anspruch 1, wobei
    die eine oder die mehreren Verteilungen eine komplexe Bingham-Verteilung oder eine komplexe Watson-Verteilung einschließen.

11. Informationsverarbeitungsvorrichtung (51) nach einem der vorstehenden Ansprüche, wobei
    die Modelldaten einen sphärischen harmonischen Koeffizienten einschließen, der durch Modellierung der Richtwirkungsdaten mittels sphärischer harmonischer Funktionserweiterung als Modellparameter erhalten wird.

12. Informationsverarbeitungsvorrichtung (51) nach einem der vorstehenden Ansprüche, wobei
    die Modelldaten einen Modellparameter einschließen, der durch Modellierung der Richtwirkungsdaten mittels eines oder mehrerer voneinander verschiedener Verfahren erhalten wird.

13. Informationsverarbeitungsvorrichtung (51) nach Anspruch 12, wobei
    die Verfahren mindestens eines von einem Verfahren der Modellierung mit einem Mischungsmodell, das eine oder mehrere Verteilungen einschließt, oder einem Verfahren der Modellierung durch sphärische harmonische Funktionserweiterung einschließen.

**Revendications**

1. Dispositif de traitement d'informations (51) comprenant :

   une unité d'acquisition (61) configurée pour acquérir des données de modèle obtenues en modélisant des données de directivité représentant la directivité d'une source sonore ; et
   un calculateur (82) configuré pour calculer les données de directivité sur une base des données de modèle, dans lequel les données de modèle comportent un paramètre de modèle constituant un modèle de mélange, le paramètre de modèle étant obtenu en modélisant les données de directivité avec le modèle de mélange comportant une ou plusieurs distributions
   **caractérisé en ce que** la ou les distributions comportent au moins l'une quelconque parmi une distribution de von Mises Fisher, VMF, ou une distribution de Kent.

2. Dispositif de traitement d'informations (51) selon la revendication 1, dans lequel

   les données de directivité comportent un gain de directivité pour chacune d'une pluralité de compartiments de fréquence, et
   les données de modèle comportent le paramètre de modèle constituant le modèle de mélange représentant une distribution du gain de directivité pour chaque bande qui est une bande de fréquence comportant un ou plusieurs des compartiments de fréquence.

3. Dispositif de traitement d'informations (51) selon la revendication 2, dans lequel

les données de modèle comportent un facteur d'échelle indiquant une plage dynamique du gain de directivité dans le compartiment de fréquence et une valeur minimale du gain de directivité dans le compartiment de fréquence.

4. Dispositif de traitement d'informations (51) selon l'une quelconque des revendications précédentes, dans lequel

les données de modèle comportent des informations de différence indiquant une différence entre les données de directivité avant modélisation et les données de directivité après modélisation, et
le dispositif de traitement d'informations comprend en outre une unité d'addition (84) configurée pour ajouter les informations de différence aux données de directivité calculées par le calculateur.

5. Dispositif de traitement d'informations (51) selon la revendication 4, dans lequel
les informations de différence sont codées par Huffman.

6. Dispositif de traitement d'informations (51) selon l'une quelconque des revendications précédentes, dans lequel

les données de directivité comportent un gain de directivité pour chacune d'une pluralité de compartiments de fréquence, et
le dispositif de traitement d'informations comprend en outre une unité de traitement d'interpolation (85) configurée pour calculer le gain de directivité du nouveau compartiment de fréquence en effectuant un processus d'interpolation sur une base des données de directivité calculées par le calculateur.

7. Dispositif de traitement d'informations (51) selon l'une quelconque des revendications précédentes, dans lequel

les données de directivité comportent un gain de directivité à chacun parmi une pluralité de points de données, et
le dispositif de traitement d'informations comprend en outre une unité de traitement d'interpolation (85) configurée pour calculer le gain de directivité au nouveau point de données en effectuant un processus d'interpolation sur la base des données de directivité calculées par le calculateur.

8. Dispositif de traitement d'informations (51) selon l'une quelconque des revendications précédentes, comprenant en outre :
une unité de convolution de directivité (89) configurée pour convoluer les données de directivité et les données audio.

9. Dispositif de traitement d'informations (51) selon la revendication 8, comprenant en outre :
une unité de convolution HRTF (90) configurée pour convoluer les données audio dans lesquelles les données de directivité sont convoluées et une HRTF.

10. Dispositif de traitement d'informations (51) selon la revendication 1, dans lequel
la ou les distributions comportent une distribution de Bingham complexe ou une distribution de Watson complexe.

11. Dispositif de traitement d'informations (51) selon l'une quelconque des revendications précédentes, dans lequel
les données de modèle comportent un coefficient harmonique sphérique obtenu en modélisant les données de directivité par expansion de fonction harmonique sphérique en tant que paramètre de modèle.

12. Dispositif de traitement d'informations (51) selon l'une quelconque des revendications précédentes, dans lequel
les données de modèle comportent un paramètre de modèle obtenu en modélisant les données de directivité par un ou plusieurs procédés différents les uns des autres.

13. Dispositif de traitement d'informations (51) selon la revendication 12, dans lequel
les procédés comportent au moins l'un quelconque parmi un procédé de modélisation avec un modèle de mélange comportant une ou plusieurs distributions ou un procédé de modélisation par expansion de fonction harmonique sphérique.

FIG. 1

FIG. 2

EP 4 425 960 B1

## FIG. 3

90° (RIGHT)

Relative Level [dB]

135°          45°

(BACK) 180°          0° (FRONT)

25dB

225°          315°

270° (LEFT)
Microphone Number [ch]

125 [Hz]
250 [Hz]
500 [Hz]
1000 [Hz]
2000 [Hz]
4000 [Hz]
8000 [Hz]

90° (UPPER)

Relative Level [dB]

135°          45°

(BACK) 180°          0° (FRONT)

−135°          −45°

−90° (LOWER)
Microphone Number [ch]

125 [Hz]
250 [Hz]
500 [Hz]
1000 [Hz]
2000 [Hz]
4000 [Hz]
8000 [Hz]

EP 4 425 960 B1

# FIG. 4

# FIG. 5

| Syntax | No. of bits | Data format |
|---|---|---|
| directivityConfig(num_sound_types_id) | | |
| { | | |
|   fs | 32 | unsigned int |
|   num_point_indices;     // NUMBER OF DATA POINTS | 32 | unsigned int |
|   for (i = 0; i < num_point_indices; i++) { | | |
|     azimuth_table[i]   // AZIMUTH ANGLE | 32 | float |
|     elevation_table[i]   // ELEVATION ANGLE | 32 | float |
|     distance[i] (radius)   // DISTANCE [meter] | 32 | float |
|   } | | |
|   bin_count   // NUMBER OF FREQUENCY POINTS | 16 | unsigned short |
|   for (i_bin=0; i_bin<bin_count; i_bin++) { | | |
|     freq[i_bin]   // FREQUENCY [Hz] | 32 | unsigned int |
|   } | | |
|   // vMF/kent distribution parameter | | |
|   band_count   // NUMBER OF bands TO BE MODELED | 16 | unsigned short |
|   for (i_band = 0; i_band<band_count; i_band++) { | | |
|     mix_count[i_band]   // NUMBER OF MIXTURES IN EACH band | 16 | unsigned short |
|     bin_range_per_band[i_band]   // bin INFORMATION ABOUT ORIGINAL DATA INCLUDED IN EACH band | 16 | unsigned short |
|     for (i_mix=0; i_mix<mix_count[i_band]; i_mix++) { | | |
|       weight[i_band][i_mix] | 32 | float |
|       kappa[i_band][i_mix] | 32 | float |
|       gamma1[i_band][i_mix][x] | 32 | float |
|       gamma1[i_band][i_mix][y] | 32 | float |
|       dist_flag   // Kent DISTRIBUTION/vMF DISTRIBUTION SELECTION flag | 8 | unsigned char |
|       if (dist_flag == 1) { | | |
|         beta[i_band][i_mix] | 32 | float |
|         gamma2[i_band][i_mix][x] | 32 | float |
|         gamma2[i_band][i_mix][y] | 32 | float |
|         gamma3[i_band][i_mix][x] | 32 | float |
|         gamma3[i_band][i_mix][y] | 32 | float |
|       }//flag | | |
|     }//mix | | |
|   }//band | | |
|   for (i_bin=0; i_bin < bin_count; i_bin++){ | | |
|     scale_factor[i_bin]   // DYNAMIC RANGE OF DIRECTIVITY DATA IN EACH bin | 32 | float |
|     offset[i_bin]   // DIRECTIVITY DATA MINIMUM VALUE IN EACH bin | 32 | float |
|   }//bin | | |
|   for (i_point=0; i_point<num_point) { | | |
|     diff_data[i_point]   // DIFFERENCE INFORMATION | TBD | |
|   } | | |
| } | | |

*FIG. 6*

EP 4 425 960 B1

## FIG. 7

| mixture | 1 | 12 | 19 |
|---|---|---|---|
| | | | |
| | band1 | band2 | band3 |
| weight | 32 | 384 | 608 |
| kappa | 32 | 384 | 608 |
| mean | 96 | 1152 | 1824 |
| offset | 320 | 384 | 224 |
| scale factor | 320 | 384 | 224 |
| Total (KB) | 0.097656 | 0.328125 | 0.42578125 |
| | | | 0.8515625 |

| Original data | Modeled by mixture of vMFdistribution |
|---|---|
| 306KB | 0.85KB |

EP 4 425 960 B1

FIG. 8

*FIG. 9*

# FIG. 10

```
        ( START OF ENCODING PROCESS )
                      |
                      v
    +--------------------------------------+  S11
    |       MODEL DIRECTIVITY DATA         |
    +--------------------------------------+
                      |
                      v
    +--------------------------------------+  S12
    |        GENERATE MODEL DATA           |
    +--------------------------------------+
                      |
                      v
    +--------------------------------------+  S13
    |         ENCODE AUDIO DATA            |
    +--------------------------------------+
                      |
                      v
    +--------------------------------------+  S14
    |     OUTPUT ENCODED BIT STREAM        |
    +--------------------------------------+
                      |
                      v
               (    END    )
```

# FIG. 11

# FIG. 12

```
┌─────────────────────────────┐
│ START OF DIRECTIVITY DATA   │
│ GENERATION PROCESS          │
└─────────────────────────────┘
              │
              ▼
┌─────────────────────────────┐ S51
│ PERFORM UNPACKING           │
└─────────────────────────────┘
              │
              ▼
┌─────────────────────────────┐ S52
│ CALCULATE DIRECTIVITY DATA  │
└─────────────────────────────┘
              │
              ▼           S53
         DIFFERENCE CODE DATA          NO
           IS PRESENT?           ─────────┐
              │                            │
             YES                           │
              ▼                            │
┌─────────────────────────────┐ S54       │
│ DECODE DIFFERENCE CODE DATA │           │
└─────────────────────────────┘           │
              │                            │
              ▼                            │
┌─────────────────────────────┐ S55       │
│ ADD DIRECTIVITY DATA RESIDUAL│          │
└─────────────────────────────┘           │
              │◄──────────────────────────┘
              ▼
┌─────────────────────────────┐ S56
│ PERFORM INTERPOLATION PROCESS│
│ IN FREQUENCY DIRECTION      │
└─────────────────────────────┘
              │
              ▼
          ┌────────┐
          │  END   │
          └────────┘
```

# FIG. 13

START OF OUTPUT AUDIO DATA
GENERATION PROCESS

DECODE ENCODED AUDIO DATA          S81

PERFORM INTERPOLATION PROCESS          S82
IN TEMPORAL DIRECTION

CONVOLVE DIRECTIVITY DATA          S83

CONVOLVE HRTF          S84

S85
END?          NO

YES

END

# FIG. 14

APPEARANCE
PROBABILITY

DIFFERENCE DATA VALUE (dB)

# FIG. 15

| Syntax | | No. of bits | Data format |
|---|---|---|---|
| directivityConfig(num_sound_types_id) | | | |
| { | | | |
|     fs | | 32 | unsigned int |
|     num_point_indices; | // NUMBER OF DATA POINTS | 32 | unsigned int |
|     for (i = 0; i < num_point_indices; i++) { | | | |
|         azimuth_table[i] | // ELEVATION ANGLE | 16 | unsigned short |
|         elevation_table[i] | // AZIMUTH ANGLE | 16 | unsigned short |
|         distance[i]     (radius) | // DISTANCE [meter] | 32 | float |
|     } | | | |
|     bin_count | // NUMBER OF FREQUENCY POINTS | 16 | unsigned short |
|     for (i_bin=0; i_bin<bin_count; i_bin++){ | | | |
|         freq[i_bin] | // FREQUENCY [Hz] | 32 | unsigned int |
|     } | | | |
|     // vMF/kent distribution parameter | | | |
|     band_count | // NUMBER OF bands TO BE MODELED | 8 | unsigned char |
|     for (i_band = 0; i_band < band_count; i_band++){ | | | |
|         mix_count[i_band] | // NUMBER OF MIXTURES IN EACH band | 8 | unsigned char |
|         bin_range_per_band[i_band] | // b in INFORMATION ABOUT ORIGINAL DATA INCLUDED IN EACH band | 16 | unsigned short |
|         for (i_mix = 0; i_mix < mix_count[i_band]; i_mix++){ | | | |
|             weight[i_band][i_mix] | | 32 | float |
|             kappa[i_band][i_mix] | | 32 | float |
|             gamma1[i_band][i_mix][x] | | 32 | float |
|             gamma1[i_band][i_mix][y] | | 32 | float |
|             dist_flag | // Kent DISTRIBUTION/vMF DISTRIBUTION SELECTION flag | 1 | bool |
|             if(dist_flag == 1){ | | | |
|                 beta[i_band][i_mix] | | 32 | float |
|                 gamma2[i_band][i_mix][x] | | 32 | float |
|                 gamma2[i_band][i_mix][y] | | 32 | float |
|                 gamma3[i_band][i_mix][x] | | 32 | float |
|                 gamma3[i_band][i_mix][y] | | 32 | float |
|             }//flag | | | |
|         }//i_mix | | | |
|     }//i_band | | | |

# FIG. 16

```
for (i_bin=0; i_bin < bin_count; i_bin++){
```

| | | | |
|---|---|---|---|
| scale_factor[i_bin] | // DYNAMIC RANGE OF DIRECTIVITY DATA IN EACH bin | 32 | float |
| offset[i_bin] | // DIRECTIVITY DATA MINIMUM VALUE IN EACH bin | 32 | float |

```
    }//bin
```

| | | | |
|---|---|---|---|
| mode | // HYBRID MODE ID USED FOR ENCODING | 8 | Unsigned char |
| table_index | // table index USED FOR ENCODING | 8 | Unsigned char |
| int db_resolution | // DESIGNATE QUANTIZATION step SIZE SUCH AS QUANTIZATION FOR EACH 1.0dB ※ EXAMPLE 0: NO QUANTIZATION, 1: 0.01dB, 2:0.2dB, 3:0.4dB,··· 2^8=256:25.6dB | 8 | Unsigned char |

```
for (i_bin = 0; i_bin < bin_count; i_bin++){
        for (i_point=0; i_point < num_point){
```

| | | | |
|---|---|---|---|
| diff_data[i_bin][i_point] | // huffman CODE WITH DIFFERENCE INFORMATION ENCODED | 1 TO nbits_res_data | |

## FIG. 17

| | | | |
|---|---|---|---|
| diff_mode_count | // TOTAL NUMBER OF DIFFERENCE ENCODING METHODS (NO DIFFERENCE ENCODING, SPATIAL DIFFERENCE, DIFFERENCE BETWEEN bins, etc.) | 8 | Unsigned char |
| for (i_mode = 0; i_mode < diff_mode_count; i_mode++) | | | |
| int nbits_res_data | // MAXIMUM bit NUMBER OF huffman code, 7bits FOR 1.0dB, 0-128dB Huffman CODE MAXIMUM WORD LENGTH | 32 | Int |
| element_count //NUMBER OF ELEMENTS OF Huffman table | 32 | 32 | int |
| for (i_element = 0; i_element < element_count; i_element++) | | | |
| Huff_dec_table[i_element] | Huffman code -> DATA | nbits_res_data | 32 | int |
| } | | | |
| } | | | |

EP 4 425 960 B1

# FIG. 18

```
const unsigned charg_a_res_model_dectbl[NCODES_RES_MODE1_DECTBL] = {
100, 100, 100, 100, 100, 100, 100, 100,   2,   2,   4,   4,  12,  12,  12,  12,
 36,  36,  36,  36,  36,  36,  36,  36,  16,  16,  16,  16, 108, 108, 108, 108,
 50,  50,  50,  50,  50,  50,  50,  50,  50,  50,  50,  50,  50,  50,  50,  50,
 81,  81,  81,  81,  81,  81,  81,  81,  81,  81,  81,  81,  81,  81,  81,  81,
 21,  21,  21,  21,  22,  22,  22,  22,  20,  20,  20,  20, 110, 110, 110, 110,
 99,  99,  99,  99,  99,  99,  99,  99,  15,  15,  15,  15, 112, 112, 112, 112,
 13,  13,  13,  13, 111, 111, 111, 111,  37,  37,  37,  37,  37,  37,  37,  37,
 78,  78,  78,  78,  78,  78,  78,  78,  78,  78,  78,  78,  78,  78,  78,  78,
 52,  52,  52,  52,  52,  52,  52,  52,  52,  52,  52,  52,  52,  52,  52,  52,
 53,  53,  53,  53,  53,  53,  53,  53,  53,  53,  53,  53,  53,  53,  53,  53,
 51,  51,  51,  51,  51,  51,  51,  51,  51,  51,  51,  51,  51,  51,  51,  51,
 38,  38,  38,  38,  38,  38,  38,  38, 109, 109, 109, 109,   6,   6,   8,   8,
 80,  80,  80,  80,  80,  80,  80,  80,  80,  80,  80,  80,  80,  80,  80,  80,
 79,  79,  79,  79,  79,  79,  79,  79,  79,  79,  79,  79,  79,  79,  79,  79,
 58,  58,  58,  58,  58,  58,  58,  58,  58,  58,  58,  58,  58,  58,  58,  58,
 77,  77,  77,  77,  77,  77,  77,  77,  77,  77,  77,  77,  77,  77,  77,  77,
 56,  56,  56,  56,  56,  56,  56,  56,  56,  56,  56,  56,  56,  56,  56,  56,
 98,  98,  98,  98,  98,  98,  98,  98,  25,  25,  25,  25, 107, 107, 107, 107,
 54,  54,  54,  54,  54,  54,  54,  54,  54,  54,  54,  54,  54,  54,  54,  54,
 61,  61,  61,  61,  61,  61,  61,  61,  61,  61,  61,  61,  61,  61,  61,  61,
 97,  97,  97,  97,  97,  97,  97,  97,  39,  39,  39,  39,  39,  39,  39,  39,
 59,  59,  59,  59,  59,  59,  59,  59,  59,  59,  59,  59,  59,  59,  59,  59,
 57,  57,  57,  57,  57,  57,  57,  57,  57,  57,  57,  57,  57,  57,  57,  57,
 60,  60,  60,  60,  60,  60,  60,  60,  60,  60,  60,  60,  60,  60,  60,  60,
 55,  55,  55,  55,  55,  55,  55,  55,  55,  55,  55,  55,  55,  55,  55,  55,
 74,  74,  74,  74,  74,  74,  74,  74,  74,  74,  74,  74,  74,  74,  74,  74,
 62,  62,  62,  62,  62,  62,  62,  62,  62,  62,  62,  62,  62,  62,  62,  62,
 63,  63,  63,  63,  63,  63,  63,  63,  63,  63,  63,  63,  63,  63,  63,  63,
 64,  64,  64,  64,  64,  64,  64,  64,  64,  64,  64,  64,  64,  64,  64,  64,
 76,  76,  76,  76,  76,  76,  76,  76,  76,  76,  76,  76,  76,  76,  76,  76,
 40,  40,  40,  40,  40,  40,  40,  40, 125, 125,   5,   5,   7,   7, 127, 127,
 65,  65,  65,  65,  65,  65,  65,  65,  65,  65,  65,  65,  65,  65,  65,  65,
 75,  75,  75,  75,  75,  75,  75,  75,  75,  75,  75,  75,  75,  75,  75,  75,
 27,  27,  27,  27,  24,  24,  24,  24,  28,  28,  28,  28, 106, 106, 106, 106,
 73,  73,  73,  73,  73,  73,  73,  73,  73,  73,  73,  73,  73,  73,  73,  73,
 66,  66,  66,  66,  66,  66,  66,  66,  66,  66,  66,  66,  66,  66,  66,  66,
 69,  69,  69,  69,  69,  69,  69,  69,  69,  69,  69,  69,  69,  69,  69,  69,
 70,  70,  70,  70,  70,  70,  70,  70,  70,  70,  70,  70,  70,  70,  70,  70,
 68,  68,  68,  68,  68,  68,  68,  68,  68,  68,  68,  68,  68,  68,  68,  68,
 95,  95,  95,  95,  95,  95,  95,  95,  96,  96,  96,  96,  96,  96,  96,  96,
 67,  67,  67,  67,  67,  67,  67,  67,  67,  67,  67,  67,  67,  67,  67,  67,
 72,  72,  72,  72,  72,  72,  72,  72,  72,  72,  72,  72,  72,  72,  72,  72,
 71,  71,  71,  71,  71,  71,  71,  71,  71,  71,  71,  71,  71,  71,  71,  71,
 26,  26,  26,  26,  29,  29,  29,  29,  41,  41,  41,  41,  41,  41,  41,  41,
 93,  93,  93,  93,  93,  93,  93,  93, 124, 124, 126, 126, 123, 123, 122, 122,
 42,  42,  42,  42,  42,  42,  42,  42,  92,  92,  92,  92,  92,  92,  92,  92,
 91,  91,  91,  91,  91,  91,  91,  91,  43,  43,  43,  43,  43,  43,  43,  43,
105, 105, 105, 105,   9,   9, 121, 121,  30,  30,  30,  30,   1,   3, 120, 120,
 94,  94,  94,  94,  94,  94,  94,  94,  32,  32,  32,  32, 104, 104, 104, 104,
 45,  45,  45,  45,  45,  45,  45,  45,  31,  31,  31,  31,  10,  10,  11,  11,
 90,  90,  90,  90,  90,  90,  90,  90, 102, 102, 102, 102, 116, 116, 119, 119,
 44,  44,  44,  44,  44,  44,  44,  44,  89,  89,  89,  89,  89,  89,  89,  89,
 46,  46,  46,  46,  46,  46,  46,  46,  34,  34,  34,  34, 103, 103, 103, 103,
 47,  47,  47,  47,  47,  47,  47,  47,  33,  33,  33,  33, 118, 118,  18,  18,
 88,  88,  88,  88,  88,  88,  88,  88, 114, 114, 115, 115,  35,  35,  35,  35,
 85,  85,  85,  85,  85,  85,  85,  85,  86,  86,  86,  86,  86,  86,  86,  86,
  0,   0,   0,   0,   0,   0,   0,   0,   0,   0,   0,   0,   0,   0,   0,   0,
  0,   0,   0,   0,   0,   0,   0,   0,   0,   0,   0,   0,   0,   0,   0,   0,
  0,   0,   0,   0,   0,   0,   0,   0,   0,   0,   0,   0,   0,   0,   0,   0,
  0,   0,   0,   0,   0,   0,   0,   0,   0,   0,   0,   0,   0,   0,   0,   0,
 48,  48,  48,  48,  48,  48,  48,  48,  49,  49,  49,  49,  49,  49,  49,  49,
101, 101, 101, 101,  23,  23, 113, 113,  84,  84,  84,  84,  84,  84,  84,  84,
 87,  87,  87,  87,  87,  87,  87,  87, 117, 117,  14,  14,  17,  17,  19,  19,
 83,  83,  83,  83,  83,  83,  83,  83,  82,  82,  82,  82,  82,  82,  82,  82
};
```

## FIG. 19

# FIG. 20

START OF DIRECTIVITY DATA
GENERATION PROCESS

PERFORM UNPACKING — S111

S112

MODEL PARAMETER
IS PRESENT? — YES

NO

S113

CALCULATE DATA BASED
ON MODEL PARAMETER

S114

DIFFERENCE CODE
DATA IS PRESENT? — NO

YES

ACQUIRE ENCODING MODE INFORMATION — S115

DECODE DIFFERENCE ENCODED DATA — S116

CALCULATE DIRECTIVITY DATA — S117

PERFORM INTERPOLATION PROCESS
IN FREQUENCY DIRECTION — S118

END

# FIG. 21

**201**

DIRECTIVITY DATA ENCODING UNIT

DIRECTIVITY DATA →

MODEL PARAMETER ESTIMATION UNIT — **241**

⊕ ~242  (+ / −)

MODEL PARAMETER ESTIMATION UNIT — **243**

⊕ ~244  (+ / −)

DIFFERENCE ENCODING UNIT — **245**

MODEL DATA GENERATION UNIT — **215**

EP 4 425 960 B1

## FIG. 22

245

DIFFERENCE ENCODING UNIT

212 — RESIDUAL CALCULATOR

271 — MULTI-STAGE DIFFERENCE PROCESSING UNIT

214 — HUFFMAN ENCODING UNIT

213 — ENCODING METHOD SELECTION UNIT

# FIG. 23

```
┌─────────────────────────────┐
│  START OF MODEL DATA        │
│  GENERATION PROCESS         │
└─────────────────────────────┘
              │
              ▼
┌─────────────────────────────┐
│ PERFORM MODELING BY MIXING METHOD │ S151
└─────────────────────────────┘
              │
              ▼
┌─────────────────────────────┐
│ CALCULATE INTERMEDIATE      │ S152
│ DIFFERENCE INFORMATION      │
└─────────────────────────────┘
              │
              ▼
┌─────────────────────────────┐
│ PERFORM MODELING BY HOA METHOD │ S153
└─────────────────────────────┘
              │
              ▼
┌─────────────────────────────┐
│ CALCULATE DIFFERENCE INFORMATION │ S154
└─────────────────────────────┘
              │
              ▼
┌─────────────────────────────┐
│ PERFORM DIFFERENCE ENCODING │ S155
└─────────────────────────────┘
              │
              ▼
┌─────────────────────────────┐
│ GENERATE MODEL DATA         │ S156
└─────────────────────────────┘
              │
              ▼
           ( END )
```

## FIG. 24

DISTRIBUTION MODEL DECODING UNIT 62

81 UNPACKING UNIT

301 CALCULATION UNIT

302 CALCULATION UNIT

83 DIFFERENCE INFORMATION DECODING UNIT

303

304

85 FREQUENCY INTERPOLATION PROCESSING UNIT

EP 4 425 960 B1

# FIG. 25

| Syntax | Mnemonic | Modified No. of bits |
|---|---|---|
| DirectivityReproduction() { | | |
| bin_count; | uimsbf | 12 |
| for (i = 0; i < bin_count; i++) { | | |
| bin_freq[i]; | bslbf | 18 |
| } | | |
| band_count; | uimsbf | 12 |
| for (j = 0; j < band_count; j++) { | | |
| mix_count[j]; | uimsbf | 8 |
| bin_range_per_band[j]; | uimsbf | 12 |
| for (k = 0; k < mix_count[k]; k++) { | | |
| kappa[j][k]; | uimsbf | 11 |
| weight[j][k]; | uimsbf | 10 |
| gamma_x[j][k]; | uimsbf | 9 |
| gamma_y[j][k]; | uimsbf | 9 |
| gamma_z[j][k]; | uimsbf | 9 |
| dist_flag | bool | 1 |
| if (dist_flag == 1) { | | |
| beta[j][k]; | uimsbf | 11 |
| gamma2_x[j][k]; | uimsbf | 9 |
| gamma2_y[j][k]; | uimsbf | 9 |
| gamma2_z[j][k]; | uimsbf | 9 |
| gamma3_x[j][k]; | uimsbf | 9 |
| gamma3_y[j][k]; | uimsbf | 9 |
| gamma3_z[j][k]; | uimsbf | 9 |
| } //flag | | |
| } //mix_count | | |
| } //band_count | | |
| for (i = 0; i < bin_count; i++) { | | |
| scale_factor[i]; | uimsbf | 7 |
| offset[i]; | uimsbf | 7 |
| } | | |
| } | | |

# FIG. 26

## FIG. 27

| Syntax | Mnemonic | No. of bits | notes |
|---|---|---|---|
| DirectivityReproductionPosInfo() [ | | | |
|   position_type | bslbf | 3 | COORDINATE RECORDING METHOD |
|   priority_index | bslbf | 18 | PRIORITY OF DIRECTIVITY DATA |
|  Switch (position_type) [ | | | |
|    Case 0x000 | | | |
|     azimuth_interval | bslbf | 10 | INTERVAL BETWEEN AZIMUTH ANGLES OF ADJACENT DATA |
|     elevation_interval | bslbf | 9 | INTERVAL BETWEEN ELEVATION ANGLES OF ADJACENT DATA |
|    Case 0x001 | | | |
|     uniform_dist_point_count | bslbf | 17 | NUMBER OF DATA POINTS IN UNIFORM DISTRIBUTION |
|    Case 0x010 | | | |
|     num_mandatory_point | bslbf | 17 | |
|     for (i = 0; i < num_mandatory_point; i++) [ | | | |
|      azimuth_table[i] | bslbf | 16 | AZIMUTH ANGLE DATA |
|      elevation_table[i] | bslbf | 16 | ELEVATION ANGLE DATA |
|     } | | | |
|     gain_resolution | bslbf | 8 | DATA POINT ARRANGEMENT RESOLUTION (dB) |
|   } | | | |
| } | | | |

EP 4 425 960 B1

FIG. 28

scale factor

FIG. 29

## FIG. 30

| Syntax | No. of bits | Mnemonic |
|---|---|---|
| DirectivityReproduction() { | | |
|   bin_count; | 12 | uimsbf |
|   for (i = 0; i < bin_count; i++) { | | |
|     bin_freq[i]; | 32 | bslbf |
|   } | | |
|   band_count; | 8 | uimsbf |
|   for (j = 0; j < band_count; j++) { | | |
|    use_symmetry | 3 | uimsbf |
|    switch(use_symmetry) | | |
|     case 4: | | |
|      LeftRightVerticalLineSymmetricDir() // UP-AND-DOWN AND LEFT-AND-RIGHT SYMMETRY | | |
|     case 3: | | |
|      LeftRightLineSymmetricDir() // LEFT-AND-RIGHT SYMMETRY | | |
|     case 2: | | |
|      VerticalLineSymmetricDir() // UP-AND-DOWN SYMMETRY | | |
|     case 1: | | |
|      SymmetricDir() // ANY SYMMETRY, ROTATION | | |
|     case 0: | | |
|      NonSymmetricDir() // WITHOUT SYMMETRY, ROTATION (DESCRIBE ENTIRE vmf/Kent DISTRIBUTION) | | |
|   } | | |
| } | | |

EP 4 425 960 B1

## FIG. 31

| Syntax | No. of bits | Mnemonic |
|---|---|---|
| SymmetricDir() { | | |
| mix_count[j]; | 12 | uimsbf |
| bin_range_per_band[j]; | 12 | uimsbf |
| for(k = 0; k < mix_count[k]; k++) { | | |
| kappa[j][k]; | 11 | uimsbf |
| weight[j][k]; | 10 | uimsbf |
| gamma_x[j][k]; | 9 | uimsbf |
| gamma_y[j][k]; | 9 | uimsbf |
| gamma_z[j][k]; | 9 | uimsbf |
| dist_flag[j][k]; | 1 | uimsbf |
| if(dist_flag == 1) { | | |
| beta[j][k]; | 11 | uimsbf |
| gamma2_x[j][k]; | 9 | uimsbf |
| gamma2_y[j][k]; | 9 | uimsbf |
| gamma2_z[j][k]; | 9 | uimsbf |
| gamma3_x[j][k]; | 9 | uimsbf |
| gamma3_y[j][k]; | 9 | uimsbf |
| gamma3_z[j][k]; | 9 | uimsbf |
| }//flag | | |
| sym_operation_count; | 2 | uimsbf |
| for(j = 0; j < sym_operation_count; j++) { | | |
| sym_operation_flag; | 1 | uimsbf |
| Switch(sym_operation_flag) | | |
| Case 1://rotation | | |
| sym_azi; | 9 | uimsbf |
| sym_elev; | 9 | uimsbf |
| sym_rotation; | 9 | uimsbf |
| Default://line symmetry | | |
| sym_yaw; | 9 | uimsbf |
| sym_pitch; | 9 | uimsbf |
| sym_roll; | 9 | uimsbf |
| } | | |
| } | | |
| } | | |
| for(i = 0; i < bin_count; i++) { | | |
| scale_factor[i]; | 7 | uimsbf |
| offset[i]; | 7 | uimsbf |
| } | | |
| } | | |

# FIG. 32

# FIG. 33

SYMMETRY

# FIG. 34

| Syntax | No. of bits | Mnemonic |
|---|---|---|
| NonSymmetricDir () { | | |
| mix_count[j]; | 12 | uimsbf |
| bin_range_per_band[j]; | 12 | uimsbf |
| for (k = 0; k < mix_count[k]; k++) { | | |
| kappa[j][k]; | 11 | uimsbf |
| weight[j][k]; | 10 | uimsbf |
| gamma_x[j][k]; | 9 | uimsbf |
| gamma_y[j][k]; | 9 | uimsbf |
| gamma_z[j][k]; | 9 | uimsbf |
| dist_flag[j][k]; | 1 | uimsbf |
| if (dist_flag == 1) { | | |
| beta[j][k]; | 11 | uimsbf |
| gamma2_x[j][k]; | 9 | uimsbf |
| gamma2_y[j][k]; | 9 | uimsbf |
| gamma2_z[j][k]; | 9 | uimsbf |
| gamma3_x[j][k]; | 9 | uimsbf |
| gamma3_y[j][k]; | 9 | uimsbf |
| gamma3_z[j][k]; | 9 | uimsbf |
| }//flag | | |
| } | | |
| for (i = 0; i < bin_count; i++) { | | |
| scale_factor[i]; | 7 | uimsbf |
| offset[i]; | 7 | uimsbf |
| } | | |
| } | | |

# FIG. 35

| Syntax | Mnemonic | Modified No. of bits |
|---|---|---|
| DirectivityReproduction() { | | |
|   bin_count; | uimsbf | 12 |
|   for (i = 0; i < bin_count; i++) { | | |
|     bin_freq[i]; | bslbf | 18 |
|   } | | |
|   band_count; | uimsbf | 12 |
|   for (j = 0; j < band_count; j++) { | | |
|     mix_count[j]; | uimsbf | 8 |
|     bin_range_per_band[j]; | uimsbf | 12 |
|     fade_flag; | uimsbf | 1 |
|     if (fade_flag & j > 0) { | | |
|       bin_range_per_band_fadein[j] | uimsbf | 12 |
|     } | | |
|     for (k = 0; k < mix_count[k]; k++) { | | |
|       kappa[j][k]; | uimsbf | 11 |
|       weight[j][k]; | uimsbf | 10 |
|       gamma_x[j][k]; | uimsbf | 9 |
|       gamma_y[j][k]; | uimsbf | 9 |
|       gamma_z[j][k]; | uimsbf | 9 |
|       dist_flag | bool | 1 |
|       if (dist_flag == 1) { | | |
|         beta[j][k]; | uimsbf | 9 |
|         gamma2_x[j][k]; | uimsbf | 9 |
|         gamma2_y[j][k]; | uimsbf | 9 |
|         gamma2_z[j][k]; | uimsbf | 9 |
|         gamma3_x[j][k]; | uimsbf | 9 |
|         gamma3_y[j][k]; | uimsbf | 9 |
|         gamma3_z[j][k]; | uimsbf | 9 |
|       } // flag | | |
|     } // mix_count | | |
|   } // band_count | | |
|   for (i = 0; i < bin_count; i++) { | | |
|     scale_factor[i]; | uimsbf | 7 |
|     offset[i]; | uimsbf | 7 |
|   } | | |
| } | | |

# FIG. 36

WEIGHT

L51    L52    L53

1

FREQUENCY

bin_range_per_band[0]        bin_range_per_band[2]

bin_range_per_band[1]

CASE WHERE CROSSFADE IS NOT PERFORMED (3bands)

WEIGHT

L61    L62    L63

1

FREQUENCY

bin_range_per_band[0]        bin_range_per_band_fadein[2]

bin_range_per_band_fadein[1]    bin_range_per_band[2]

bin_range_per_band[1]

CASE WHERE CROSSFADE IS PERFORMED (3bands)

EP 4 425 960 B1

# FIG. 37

| Syntax | No. of bits | Mnemonic |
|---|---|---|
| DirectivityReproduction() { | | |
| bin_count; | 12 | uimsbf |
| for(i=0; i<bin_count; i++){ | | |
|    bin_freq[i]; | 32 | bslbf |
| } | | |
| band_count; | 12 | uimsbf |
| for(j=0; j<band_count; j++){ | | |
|   use_symmetry[j] | 3 | uimsbf |
|   mix_count[j]; | 8 | uimsbf |
|   bin_range_per_band[j]; | 12 | uimsbf |
|   if(j>0){ | | |
|     fade_flag; | 1 | uimsbf |
|     if(fade_flag){ | | |
|       bin_range_per_band_fadein[j] | 12 | uimsbf |
|     } | | |
|   }else{ | | |
|     start_bin | 4 | uimsbf |
|   } | | |
|   switch(use_symmetry[j]){ | | |
|    case 7: | | |
|     FrontBackVerticalSymmetricDir() // UP-AND-DOWN AND FRONT-AND-BACK SYMMETRY | | |
|    case 6: | | |
|     FrontBackLeftRightSymmetricDir() // FRONT-AND-BACK AND LEFT-AND-RIGHT SYMMETRY | | |
|    case 5: | | |
|     FrontBackSymmetricDir() // FRONT-AND-BACK SYMMETRY | | |
|    case 4: | | |
|     LeftRightVerticalLineSymmetricDir() // UP-AND-DOWN AND LEFT-AND-RIGHT SYMMETRY | | |
|    case 3: | | |
|     LeftRightLineSymmetricDir() // LEFT-AND-RIGHT SYMMETRY | | |
|    case 2: | | |
|     VerticalLineSymmetricDir() // UP-AND-DOWN SYMMETRY | | |
|    case 1: | | |
|     SymmetricDir() // ANY SYMMETRY, ROTATION | | |
|    case 0: | | |
|     NonSymmetricDir() // WITHOUT SYMMETRY, ROTATION (DESCRIBE ENTIRE vmf/Kent DISTRIBUTION) | | |
|   } //use_symmetry[j] | | |
| } //j:band_count | | |
| DynamicRangeForDir() | | |
| } | | |

## FIG. 38

| Syntax | No. of bits | Mnemonic |
|---|---|---|
| NonSymmetricDir () {<br>  for (k = 0; k < mix_count[k]; k++) {<br>    kappa[j][k]; | <br><br>11 | <br><br>uimsbf |
| weight[j][k]; | 10 | uimsbf |
| gamma_azi[j][k]; | 9 | uimsbf |
| gamma_elev[j][k]; | 8 | uimsbf |
| dist_flag[j][k]; | 1 | uimsbf |
| if (dist_flag[j][k] == 1) {<br>      beta[j][k]; | <br>9 | <br>uimsbf |
| gamma1_azi[j][k] | 10 | uimsbf |
| }//flag<br>  }//k:mix<br>} | | |

## FIG. 39

| Syntax | No. of bits | Mnemonic |
|---|---|---|
| LeftRightLineSymmetricDir() {<br>　for(k=0; k<mix_count[k]; k++) {<br>　　　kappa[j][k]; | 11 | uimsbf |
| 　　　weight[j][k]; | 10 | uimsbf |
| 　　　gamma_azi[j][k]; | 9 | uimsbf |
| 　　　gamma_elev[j][k]; | 8 | uimsbf |
| 　　　dist_flag[j][k]; | 1 | uimsbf |
| 　　　if (dist_flag[j][k] == 1) {<br>　　　　beta[j][k]; | 9 | uimsbf |
| 　　　　gamma1_azi[j][k] | 9 | uimsbf |
| 　　　}//flag | | |
| 　　　sym_flag[k] | 1 | uimsbf |
| 　　}//k:mix | | |
| } | | |

# FIG. 40

FIG. 41

A block diagram showing: CPU (501), ROM (502), RAM (503) connected to a bus (504); INPUT/OUTPUT INTERFACE (505) connected to INPUT UNIT (506), OUTPUT UNIT (507), RECORDING UNIT (508), COMMUNICATION UNIT (509), and DRIVE (510), with REMOVABLE RECORDING MEDIUM (511) connected to the drive.

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 2011249822 A1

- JP 2021100209 A

**Non-patent literature cited in the description**

- **JOHN T. KENT**. *The Fisher-Bingham Distribution on the Sphere*, 1982